# EUROPÄISCHE PATENTSCHRIFT

(11) **EP 2 205 615 B1**
(45) Veröffentlichungstag und Bekanntmachung des Hinweises auf die Patenterteilung: **18.04.2012**
(21) Anmeldenummer: 08840571.7
(22) Anmeldetag: 17.10.2008
(51) Int. Cl.: C07F 15/00, B01J 31/22, H01J 61/62, H05B 33/00

(54) **ÜBERGANGSMETALLKOMPLEXE MIT VERBRÜCKTEN CARBENLIGANDEN UND DEREN VERWENDUNG IN OLEDS**
TRANSITION METAL COMPLEXES WITH BRIDGED CARBENE LIGANDS AND USE THEREOF IN OLEDS
COMPLEXES DE MÉTAUX DE TRANSITION À LIGANDS CARBÉNIQUES PONTÉS ET LEUR UTILISATION DANS DES OLED

(30) Priorität: 17.10.2007 EP 07118675; 26.03.2008 EP 08153303
(43) Veröffentlichungstag der Anmeldung: 14.07.2010
(73) Patentinhaber: BASF SE, 67056 Ludwigshafen (DE)
(72) Erfinder: MOLT, Oliver, 69493 Hirschberg (DE); LENNARTZ, Christian, 67105 Schifferstadt (DE); FUCHS, Evelyn, 68199 Mannheim (DE); KAHLE, Klaus, 67069 Ludwigshafen (DE); LANGER, Nicolle, 64646 Heppenheim (DE); SCHILDKNECHT, Christian, 68305 Mannheim (DE); RUDOLPH, Jens, 67547 Worms (DE); WAGENBLAST, Gerhard, 67157 Wachenheim (DE); WATANABE, Soichi, 68161 Mannheim (DE)
(86) Internationale Anmeldenummer: PCT/EP2008/064064
(87) Internationale Veröffentlichungsnummer: WO 2009/050281

(56) Entgegenhaltungen:
- WO-A-2005/113704
- WO-A-2007/088093

## Beschreibung

Die vorliegende Erfindung betrifft verbrückte cyclometallierte Carbenkomplexe, ein Verfahren zur Herstellung der verbrückten cyclometallierten Carbenkomplexe, die Verwendung der verbrückten cyclometallierten Carbenkomplexe in organischen Leuchtdioden, organische Leuchtdioden enthaltend mindestens einen erfindungsgemäßen verbrückten cyclometallierten Carbenkomplex, eine Licht-emittierende Schicht, enthaltend mindestens einen erfindungsgemäßen verbrückten cyclometallierten Carbenkomplex, organische Leuchtdioden, enthaltend mindestens eine erfindungsgemäße Licht-emittierende Schicht sowie Vorrichtungen, die mindestens eine erfindungsgemäße organische Leuchtdiode enthalten.

In organischen Leuchtdioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigen Stromverbrauchs eignen sich die Vorrichtungen enthaltend OLEDs insbesondere für mobile Anwendungen, zum Beispiel für Anwendungen in Handys, Laptops usw.

Die Grundprinzipien der Funktionsweise von OLEDs sowie geeignete Aufbauten (Schichten) von OLEDs sind zum Beispiel in WO 2005/113704 und der darin zitierten Literatur genannt.

Im Stand der Technik wurden bereits zahlreiche Materialien vorgeschlagen, die bei der Anregung durch elektrischen Strom Licht emittieren.

In WO 2005/019373 ist erstmals die Verwendung von neutralen Übergangsmetallkomplexen, die mindestens einen Carbenliganden enthalten, in OLEDs offenbart. Diese Übergangsmetallkomplexe können gemäß WO 2005/019373 in jeder Schicht eines OLEDs eingesetzt werden, wobei das Ligandgerüst oder Zentralmetall zur Anpassung an gewünschte Eigenschaften der Übergangsmetallkomplexe variiert werden kann. Beispielsweise ist der Einsatz der Übergangsmetallkomplexe in einer Blockschicht für Elektronen, einer Blockschicht für Excitonen, einer Blockschicht für Löcher oder der Licht-emittierenden Schicht des OLEDs möglich, wobei die Übergangsmetallkomplexe bevorzugt als Emittermoleküle in OLEDs eingesetzt werden.

In WO 2006/056418 ist die Verwendung von neutralen Übergangsmetall-Carbenkomplexen offenbart, wobei der eingesetzte Carbenligand ein verbrückter Carbenligand sein kann. Geeignete verbrückte Carbenliganden weisen die folgende allgemeine Formel auf: 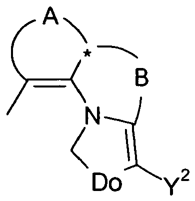 wobei der Stern das zum N-gebundenen vinylischen Kohlenstoffatom α-ständige Kohlenstoff- oder geeignete Heteroatom der Brücke A, und B die aus einem Alkyl-, Alkenyl-, Alkinyl-, Aryl- oder Heteroarylrest (Y¹) und einer chemischen Einfachbindung, C(Y⁴)₂, C(O), O, S, S(O), SO₂ oder NY⁵ zusammengesetzte Brücke bezeichnet.

WO 2005/113704 betrifft Carben-Metallkomplexe für den Einsatz in OLEDs. Unter den zahlreichen genannten geeigneten Carbenliganden sind zwei verbrückte Liganden genannt:

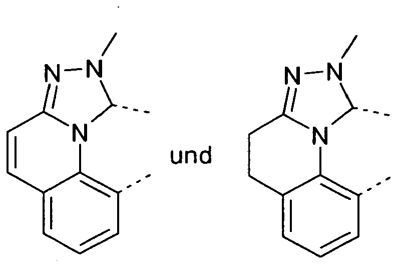

In der prioritätsälteren nicht vorveröffentlichten Anmeldung mit dem Aktenzeichen WO 2007/115981 sind heteroleptische Carbenkomplexe enthaltend sowohl Carbenliganden als auch heterocyclische Nicht-Carbenliganden offenbart. Bei den Carbenliganden kann es sich um verbrückte Carbenliganden handeln, wobei unter anderem verbrückte Carbenliganden der folgenden Formeln erwähnt sind:

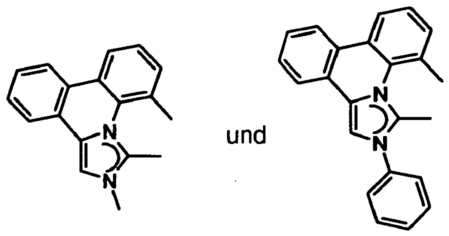

WO 2007/095118 betrifft Metallkomplexe von cyclometallierten Imidazo[1,2-f]phenanthridin- und Diimidazo[1,2-a:1',2'-c]quinazolin-Liganden sowie isoelektronischen und benzanellierten Analogen davon. Gemäß WO 2007/095118 sollen blau phosphoreszierende OLEDs mit verlängerter Lebensdauer bereits gestellt werden.

Obwohl bereits verbrückte Carbenkomplexe bekannt sind, die zum Einsatz in OLEDs, insbesondere als Licht-emittierende Substanzen, geeignet sind, ist die Bereitstellung von stabileren und/oder effizienteren Verbindungen, die technisch einsetzbar sind, wünschenswert.

Im Sinne der vorliegenden Anmeldung ist unter Elektrolumineszenz sowohl Elektrofluoreszenz als auch Elektrophosphoreszenz zu verstehen.

Aufgabe der vorliegenden Anmeldung ist daher die Bereitstellung von verbrückten Carbenkomplexen, die zum Einsatz in OLEDs geeignet sind. Insbesondere ist die Bereitstellung von Übergangsmetallkomplexen wünschenswert, die ein gegenüber bekannten Übergangsmetallkomplexen verbessertes Eigenschaftsspektrum zeigen, z.B. verbesserte Effizienzen und/oder eine verbesserte Lebensdauer/Stabilität.

Diese Aufgabe wird durch die Bereitstellung von verbrückten cyclometallierten Carbenkomplexen der allgemeinen Formel (I) gelöst 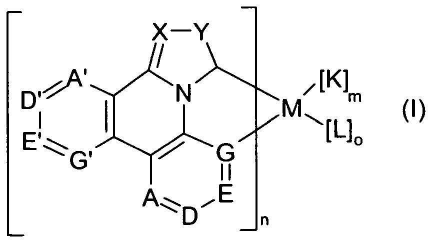 worin die Symbole die folgenden Bedeutungen aufweisen:
- M: Metallatom ausgewählt aus der Gruppe bestehend aus Metallen der Gruppe IB, IIB, IIIB, IVB, VB, VIB, VIIB, VIIIB, den Lanthaniden und IIIA des Periodensystems der Elemente (CAS-Version) in jeder für das entsprechende Metallatom möglichen Oxidationsstufe; bevorzugt Fe, Os, Co, Rh, Ir, Ni, Ru, Pd und Pt, Cu, Au, Ce, Tb, Eu, besonders bevorzugt Os, Ru, Rh, Ir und Pt und ganz besonders bevorzugt Ir, Os und Pt;
- K: neutraler mono- oder bidentater Ligand;

- L: mono- oder dianionischer Ligand, bevorzugt monoanionischer Ligand, der mono- oder didentat sein kann;
- X: CR¹ oder N, bevorzugt N;
- Y: NR² oder CR²₂;
- A, D,: G, E, A', D', G' oder E' unabhängig voneinander CH, CR³ oder N;
- R¹: F, CN, C₁-C₂₀-Alkoxy, C₆-C₃₀-Aryloxy, C₁-C₂₀-Alkylthio, C₆-C₃₀-Arylthio, substituiertes oder unsubstituiertes C₆-C₃₀-Aryl oder substituiertes oder unsubstituiertes Heteroaryl mit 5 bis 30 Ringatomen;
- R², R³: unabhängig voneinander substituiertes oder unsubstituiertes C₁-C₂₀-Alkyl, substituiertes oder unsubstituiertes C₅-C₂₀-Cycloalkyl, substituiertes oder unsubstituiertes C₅-C₂₀-Cycloalkenyl, substituiertes oder unsubstituiertes Heterocycloalkyl mit 5 bis 30 Ringatomen, substituiertes oder unsubstituiertes Heterocycloalkenyl mit 5 bis 30 Ringatomen, substituiertes oder unsubstituiertes C₂-C₂₀-Alkenyl, substituiertes oder unsubstituiertes C₂-C₂₀-Alkinyl, substituiertes oder unsubstituiertes C₆-C₃₀-Aryl, substituiertes oder unsubstituiertes Heteroaryl mit 5 bis 30 Ringatomen oder ein Substituent mit Donor- oder Akzeptorwirkung ausgewählt aus der Gruppe bestehend aus: C₁-C₂₀-Alkoxy, C₆-C₃₀-Aryloxy, C₁-C₂₀-Alkylthio, C₆-C₃₀-Arylthio, SiR⁴R⁵R⁶, Halogenresten, halogenierten C₁-C₂₀-Alkylresten, Carbonyl (-CO(R⁴)), Carbonylthio (-C=O(SR⁴)), Carbonyloxy (-C=O(OR⁴)), Oxycarbonyl (-OC=O(R⁴)), Thiocarbonyl (-SC=O(R⁴)), Amino (-NR⁴R⁵), OH, Pseudohalogenresten, Amido (-C=O(NR⁴R⁵)), -NR⁴C=O(R⁵), Phosphonat (- P(O)(OR⁴)₂, Phosphat (-OP(O)(OR⁴)₂), Phosphin (-PR⁴R⁵), Phosphinoxid (-P(O)R⁴₂), Sulfat (-OS(O)₂OR⁴), Sulfoxid (-S(O)R⁴), Sulfonat (-S(O)₂OR⁴), Sulfonyl (-S(O)₂R⁴, Sulfonamid (-S(O)₂NR⁴R⁵), NO₂, Boronsäureestern (-B(OR⁴)₂), Imino (-C=NR⁴R⁵)), Boranresten, Stannatresten, Hydrazinresten, Hydrazonresten, Oximresten, Nitroso-Gruppen, Diazo-Gruppen, Vinylgruppen, Sulfoximinen, Alanen, Germanen, Boroxinen und Borazinen;
oder
zwei benachbarte Reste R³ bilden gemeinsam eine gesättigte oder ungesättigte substituierte oder unsubstituierte Brücke aus 3 bis 6 Atomen, so dass die Reste R³ gemeinsam mit einem der Elemente A=D, D-E, A'=D', D'-E', E'=G' einen 5- bis 8-gliedrigen Ring bilden;
oder
die Reste R³ an den Positionen G' und A bilden gemeinsam eine gesättigte oder ungesättigte substituierte oder unsubstituierte Brücke aus 1 bis 4 Atomen, so dass die Reste R³ gemeinsam mit dem Element -G'-C-C-A- einen 5- bis 8-gliedrigen Ring bilden;
- R⁴, R⁵, R⁶: unabhängig voneinander H, substituiertes oder unsubstituiertes C₁-C₂₀-Alkyl oder substituiertes oder unsubstituiertes C₆-C₃₀-Aryl oder substituiertes oder unsubstituiertes Heteroaryl mit 5 bis 30 Ringatomen;
- n: Zahl der Carbenliganden, wobei n mindestens 1 ist und die Carbenliganden in dem Komplex der Formel I bei n > 1 gleich oder verschieden sein können;
- m: Zahl der Liganden K, wobei m 0 oder ≥ 1 sein kann, und die Liganden K bei m > 1 gleich oder verschieden sein können;
- o: Zahl der Liganden L, wobei o 0 oder ≥ 1 sein kann, und die Liganden L bei o > 1 gleich oder verschieden sein können;
wobei die Summe n + m + o von der Oxidationsstufe und Koordinationszahl des eingesetzten Metallatoms und von der Zähnigkeit der Liganden L und K sowie von der Ladung der Liganden L abhängig ist, mit der Bedingung, dass n mindestens 1 ist.

Die erfindungsgemäßen verbrückten cyclometallierten Carbenkomplexe der Formel I zeichnen sich dadurch aus, dass sie eine Verbrückung des/der Carbenliganden aufweisen und insbesondere an der Position X ein N-Atom oder einen Rest -C-F,-C-CN, -C-C₁-C₂₀-Alkoxy, -C-C₆-C₃₀-Aryloxy, -C-C₁-C₂₀-Alkylthio, -C-C₆-C₃₀-Arylthio, substituiertes oder unsubstituiertes -C-C₆-C₃₀-Aryl oder substituiertes oder unsubstituiertes -C-Heteroaryl mit 5 bis 30 Ringatomen aufweisen. Es wurde gefunden, dass sich die erfindungsgemäßen Carbenkomplexe durch eine gute Stabilität auszeichnen und mit Hilfe der erfindungsgemäßen Carbenkomplexe der Formel I OLEDs mit einem verbesserten Eigenschaftsspektrum, z.B. verbesserten Effizienzen und/oder einer verbesserten Lebensdauer erhältlich sind.

Unter substituiertem oder unsubstituiertem C₁-C₂₀-Alkyl sind Alkylreste mit 1 bis 20 Kohlenstoffatomen zu verstehen. Bevorzugt sind C₁- bis C₁₀-Alkylreste, besonders bevorzugt C₁- bis C₆-Alkylreste. Die Alkylreste können sowohl geradkettig als auch verzweigt sein. Des Weiteren können die Alkylreste mit einem oder mehreren Substituenten ausgewählt aus der Gruppe bestehend aus C₁-C₂₀-Alkyl, C₁-C₂₀-Alkoxy, Halogen, bevorzugt F, C₁-C₂₀-Halogenalkyl, z.B. CF₃, und C₆-C₃₀-Aryl, das wiederum substituiert oder unsubstituiert sein kann, substituiert sein. Geeignete Arylsubstituenten sowie geeignete Alkoxy- und Halogensubstituenten sind nachstehend genannt. Beispiele für geeignete Alkylgruppen sind Methyl, Ethyl, Propyl, Butyl, Pentyl, Hexyl, Heptyl und Octyl sowie mit C₁-C₂₀-Alkyl, C₁-C₂₀-Halogenalkyl, C₆-C₃₀-Aryl-, C₁-C₂₀-Alkoxy- und/oder Halogen, insbesondere F, substituierte Derivate der genannten Alkylgruppen, zum Beispiel CF₃. Dabei sind sowohl die n-Isomere der genannten Reste als auch verzweigte Isomere wie Isopropyl, Isobutyl, Isopentyl, sek-Butyl, tert-Butyl, Neopentyl, 3,3-Dimethylbutyl, 3-Ethylhexyl usw. mit umfasst. Bevorzugte Alkylgruppen sind Methyl, Ethyl, Isopropyl, tert-Butyl und CF₃.

Unter substituiertem oder unsubstituiertem C₅-C₂₀-Cycloalkyl sind Cycloalkylgruppen mit 5 bis 20, bevorzugt 5 bis 10, besonders bevorzugt 5 bis 8 Kohlenstoffatomen im Grundgerüst (Ring) zu verstehen. Geeignete Substituenten sind die bezüglich der Alkylgruppen genannten Substituenten. Beispiele für geeignete Cycloalkylgruppen, die unsubstituiert oder mit den vorstehend bezüglich der Alkylgruppen genannten Resten substituiert sein können, sind Cyclopentyl, Cyclohexyl, Cycloheptyl, Cyclooctyl, Cyclononyl und Cyclodecyl. Gegebenenfalls kann es sich auch um polycyclische Ringsysteme handeln, wie Decalinyl, Norbornyl, Bornanyl oder Adamantyl.

Unter substituiertem oder unsubstituiertem C₅-C₂₀-Cycloalkenyl sind Cycloalkenylgruppen mit 5 bis 20, bevorzugt 5 bis 10, besonders bevorzugt 5 bis 8 Kohlenstoffatomen im Grundgerüst (Ring) zu verstehen. Geeignete Substituenten sind die bezüglich der Alkylgruppen genannten Substituenten. Die Cycloalkenylgruppen können eine oder - in Abhängigkeit von der Ringgröße - mehrere Doppelbindungen innerhalb des Cycloalkenylrings aufweisen. Die Doppelbindungen können konjugiert oder nicht konjugiert sein. Bevorzugt weisen die Cycloalkenylgruppen eine Doppelbindung innerhalb des Cycloalkenylrings auf. Beispiele für geeignete Cycloalkenylgruppen, die unsubstituiert oder mit den vorstehend bezüglich der Alkylgruppen genannten Resten substituiert sein können, sind Cyclopentenyl, Cyclohexenyl, Cycloheptenyl, Cyclooctenyl, Cyclononenyl und Cyclodecenyl. Gegebenenfalls kann es sich auch um polycyclische Ringsysteme handeln, wobei mindestens einer der Ringe ein Cycloalkenylring ist.

Unter substituiertem oder unsubstituiertem Heterocycloalkyl mit 5 bis 30 Ringatomen sind Heterocycloalkylgruppen mit 5 bis 30, bevorzugt 5 bis 10, besonders bevorzugt 5 bis 8 Ringatomen zu verstehen, wobei in dem Heterocycloalkyl-Grundgerüst mindestens ein Kohlenstoffatom durch ein Heteroatom ersetzt ist. Bevorzugte Heteroatome sind N, O und S. Geeignete Substituenten sind die bezüglich der Alkylgruppen genannten Substituenten. Beispiele für geeignete Heterocycloalkylgruppen, die unsubstituiert oder mit den vorstehend bezüglich der Alkylgruppen genannten Resten substituiert sein können, sind von den folgenden Heterocyclen abgeleitete Reste: Pyrrolidin, Thiolan, Tetrahydrofuran, 1,2-Oxathiolan, Oxazolidin, Piperidin, Thian, Oxan, Dioxan, 1,3-Dithian, Morpholin, Piperazin. Gegebenenfalls kann es sich auch um polycyclische Ringsysteme handeln.

Unter substituiertem oder unsubstituiertem Heterocycloalkenyl mit 5 bis 30 Ringatomen sind Heterocycloalkenylgruppen mit 5 bis 30, bevorzugt 5 bis 10, besonders bevorzugt 5 bis 8 Ringatomen zu verstehen, wobei in dem Heterocycloalkenyl-Grundgerüst mindestens ein Kohlenstoffatom durch ein Heteroatom ersetzt ist und in dem Heterocycloalkenyl-Grundgerüst mindestens eine Doppelbindung vorliegt. Die Heterocycloalkenylgruppen können eine oder - in Abhängigkeit von der Ringgröße - mehrere Doppelbindungen innerhalb des Heterocycloalkenylrings aufweisen. Die Doppelbindungen können konjugiert oder nicht konjugiert sein. Bevorzugt weisen die Heterocycloalkenylgruppen eine Doppelbindung innerhalb des Heterocycloalkenylrings auf. Bevorzugte Heteroatome sind N, O und S. Geeignete Substituenten sind die bezüglich der Alkylgruppen genannten Substituenten.

Unter substituiertem oder unsubstituiertem C₂-C₂₀-Alkenyl sind Alkenylreste mit 2 bis 20 Kohlenstoffatomen zu verstehen. Bevorzugt sind C₂- bis C₁₀-Alkenylreste, besonders bevorzugt C₂- bis C₆-Alkenylreste. Die Alkenylreste können sowohl geradkettig als auch verzweigt sein. Des Weiteren können die Alkenylreste mit einem oder mehreren der bezüglich der Alkylreste genannten Substituenten substituiert sein. Die Alkenylreste können - in Abhängigkeit von der Kettenlänge - eine oder mehrere Doppelbindungen aufweisen, wobei die Doppelbindungen zueinander konjugiert oder voneinander isoliert sein können. Beispiele für geeignete Alkenylgruppen sind Ethenyl, Propenyl, Butenyl, Pentenyl, Hexenyl, Heptenyl und Octentyl, wobei die Doppelbindung an einer beliebigen Position in den vorstehend genannten Resten vorliegen kann, sowie mit C₁-C₂₀-Alkyl, C₁-C₂₀-Halogenalkyl, C₆-C₃₀-Aryl-, C₁-C₂₀-Alkoxy- und/oder Halogen, insbesondere F, substituierte Derivate der genannten Alkenylgruppen.

Unter substituiertem oder unsubstituiertem C₂-C₂₀-Alkinyl sind Alkinylreste mit 2 bis 20 Kohlenstoffatomen zu verstehen. Bevorzugt sind C₂- bis C₁₀-Alkinylreste, besonders bevorzugt C₂- bis C₆-Alkinylreste. Die Alkinylreste können sowohl geradkettig als auch verzweigt sein. Des Weiteren können die Alkinylreste mit einem oder mehreren der bezüglich der Alkylreste genannten Substituenten substituiert sein. Die Alkinylreste können - in Abhängigkeit von der Kettenlänge - eine oder mehrere Dreifachbindungen aufweisen, wobei die Dreifachbindungen zueinander konjugiert oder voneinander isoliert sein können. Beispiele für geeignete Alkinylgruppen sind Ethinyl, Propinyl, Butinyl, Pentinyl, Hexinyl, Heptinyl und Octintyl, wobei die Dreifachbindung an einer beliebigen Position in den vorstehend genannten Resten vorliegen kann, sowie mit C₁-C₂₀-Alkyl, C₁-C₂₀-Halogenalkyl, C₆-C₃₀-Aryl-, C₁-C₂₀-Alkoxy- und/oder Halogen, insbesondere F, substituierte Derivate der genannten Alkinylgruppen.

Geeignete C₁-C₂₀-Alkoxy- und C₁-C₂₀-Alkylthiogruppen leiten sich entsprechend von den vorstehend genannten C₁-C₂₀-Alkylresten ab. Beispielsweise sind hier zu nennen OCH₃, OC₂H₅, OC₃H₇, OC₄H₉ und OC₈H₁₇ sowie SCH₃, SC₂H₅, SC₃H₇, SC₄H₉ und SC₈H₁₇. Dabei sind unter C₃H₇, C₄H₉ und C₈H₁₇ sowohl die n-Isomere als auch verzweigte Isomere wie isoPropyl, iso-Butyl, sek-Butyl, tert-Butyl und 2-Ethylhexyl umfasst. Besonders bevorzugte Alkoxy- oder Alkylthio-Gruppen sind Methoxy, Ethoxy, n-Octyloxy, 2-Ethylhexyloxy und SCH₃.

Geeignete Halogenreste oder Halogensubstituenten im Sinne der vorliegenden Anmeldung sind Fluor, Chlor, Brom und Iod, bevorzugt Fluor, Chlor und Brom, besonders bevorzugt Fluor und Chlor, ganz besonders bevorzugt Fluor.

Geeignete Pseudohalogenreste im Sinne der vorliegenden Anmeldung sind CN, SCN, OCN, N₃ und SeCN zu verstehen, wobei CN und SCN bevorzugt sind. Ganz besonders bevorzugt ist CN.

Als C₆-C₃₀-Aryl werden in der vorliegenden Erfindung Reste bezeichnet, die von monocyclischen, bicyclischen oder tricyclischen Aromaten abgeleitet sind, die keine Ringheteroatome enthalten. Sofern es sich nicht um monocyclische Systeme handelt, ist bei der Bezeichnung Aryl für den zweiten Ring auch die gesättigte Form (Perhydroform) oder die teilweise ungesättigte Form (beispielsweise die Dihydroform oder Tetrahydroform), sofern die jeweiligen Formen bekannt und stabil sind, möglich. Das heißt, die Bezeichnung Aryl umfasst in der vorliegenden Erfindung beispielsweise auch bicyclische oder tricyclische Reste, in denen sowohl beide als auch alle drei Reste aromatisch sind, als auch bicyclische oder tricyclische Reste, in denen nur ein Ring aromatisch ist, sowie tricyclische Reste, worin zwei Ringe aromatisch sind. Beispiele für Aryl sind: Phenyl, Naphthyl, Indanyl, 1,2-Dihydronaphthenyl, 1,4-Dihydronaphthenyl, Indenyl, Anthracenyl, Phenanthrenyl oder 1,2,3,4-Tetrahydronaphthyl. Besonders bevorzugt sind C₆-C₁₀-Arylreste, zum Beispiel Phenyl oder Naphthyl, ganz besonders bevorzugt C₆-Arylreste, zum Beispiel Phenyl.

Die C₆-C₃₀-Arylreste können unsubstituiert sein oder mit einem mehreren weiteren Resten substituiert sein. Geeignete weitere Reste sind ausgewählt aus der Gruppe bestehend aus C₁-C₂₀-Alkyl, C₆-C₃₀-Aryl oder Substituenten mit Donor- oder Akzeptorwirkung, wobei geeignete Substituenten mit Donor- oder Akzeptorwirkung nachstehend genannt sind. Bevorzugt sind die C₆-C₃₀-Arylreste unsubstituiert oder mit einer oder mehreren C₁-C₂₀-Alkylgruppen, C₁-C₂₀-Alkoxygruppen, CN, CF₃, F oder Aminogruppen (NR⁴R⁵, wobei geeignete Reste R⁴ und R⁵ vorstehend genannt sind), substituiert. Weitere bevorzugte Substitutionen der C₆-C₃₀-Arylreste sind abhängig von dem Einsatzzweck der Verbindungen der allgemeinen Formel (I) und sind nachstehend genannt.

Geeignete C₆-C₃₀-Aryloxy-, C₆-C₃₀-Arylthioreste leiten sich entsprechend von den vorstehend genannten C₆-C₃₀-Arylresten ab. Besonders bevorzugt sind Phenoxy und Phenylthio.

Unter unsubstituiertem oder substituiertem Heteroaryl mit 5 bis 30 Ringatomen sind monocyclische, bicyclische oder tricyclische Heteroaromaten zu verstehen, die sich zum Teil vom vorstehend genannten Aryl ableiten lassen, in dem im Aryl-Grundgerüst mindestens ein Kohlenstoffatom durch ein Heteroatom ersetzt ist. Bevorzugte Heteroatome sind N, O und S. Besonders bevorzugt weisen die Heteroarylreste 5 bis 13 Ringatome auf. Insbesondere bevorzugt ist das Grundgerüst der Heteroarylreste ausgewählt aus Systemen wie Pyridin und fünfgliedrigen Heteroaromaten wie Thiophen, Pyrrol, Imidazol, Thiazol, Oxazol oder Furan. Diese Grundgerüste können gegebenenfalls mit einem oder zwei sechsgliedrigen aromatischen Resten anelliert sein. Geeignete anellierte Heteroaromaten sind Carbazolyl, Benzimidazolyl, Benzofuryl, Benzthiazol, Benzoxazol, Dibenzofuryl oder Dibenzothiophenyl. Das Grundgerüst kann an einer, mehreren oder allen substituierbaren Positionen substituiert sein, wobei geeignete Substituenten dieselben sind, die bereits unter der Definition von C₆-C₃₀-Aryl genannt wurden. Bevorzugt sind die Heteroarylreste jedoch unsubstituiert. Geeignete Heteroarylreste sind zum Beispiel Pyridin-2-yl, Pyridin-3-yl, Pyridin-4-yl, Thiophen-2-yl, Thiophen-3-yl, Pyrrol-2-yl, Pyrrol-3-yl, Furan-2-yl, Furan-3-yl, Thiazol-2-yl, Oxazol-2-yl und Imidazol-2-yl sowie die entsprechenden benzanellierten Reste, insbesondere Carbazolyl, Benzimidazolyl, Benzofuryl, Benzthiazol, Benzoxazol, Dibenzofuryl oder Dibenzothiophenyl.

Unter Gruppen mit Donor- oder Akzeptorwirkung sind im Sinne der vorliegenden Anmeldung die folgenden Gruppen zu verstehen:

C₁-C₂₀-Alkoxy, C₆-C₃₀-Aryloxy, C₁-C₂₀-Alkylthio, C₆-C₃₀-Arylthio, SiR⁴R⁵R⁶, Halogenresten, halogenierten C₁-C₂₀-Alkylresten, Carbonyl (-CO(R⁴)), Carbonylthio (- C = O (SR⁴)), Carbonyloxy (- C = O(OR⁴)), Oxycarbonyl (- OC = O(R⁴)), Thiocarbonyl (- SC = O(R⁴)), Amino (-NR⁴R⁵), OH, Pseudohalogenreste, Amido (- C = O (NR⁴R⁵)), -NR⁴C = O (R⁵), Phosphonat (- P(O) (OR⁴)₂, Phosphat (-OP(O) (OR⁴)₂), Phosphin (-PR⁴R⁵), Phosphinoxid (-P(O)R⁴₂), Sulfat (-OS(O)₂OR⁴), Sulfoxid (-S(O)R⁴), Sulfonat (-S(O)₂OR⁴), Sulfonyl (-S(O)₂R⁴), Sulfonamid (-S(O)₂NR⁴R⁵), NO₂, Boronsäureester (-OB(OR⁴)₂), Imino (-C = NR⁴R⁵)), Boranreste, Stannatreste, Hydrazinreste, Hydrazonreste, Oximreste, Nitroso-Gruppen, Diazo-Gruppen, Vinylgruppen, Sulfoximine, Alane, Germane, Boroxine und Borazine.

Bevorzugte Substituenten mit Donor- oder Akzeptorwirkung sind ausgewählt aus der Gruppe bestehend aus:

C₁- bis C₂₀-Alkoxy, bevorzugt C₁-C₆-Alkoxy, besonders bevorzugt Ethoxy oder Methoxy; C₆-C₃₀-Aryloxy, bevorzugt C₆-C₁₀-Aryloxy, besonders bevorzugt Phenyloxy; SiR⁴R⁵R⁶, wobei R⁴, R⁵ und R⁶ bevorzugt unabhängig voneinander substituiertes oder unsubstituiertes Alkyl oder substituiertes oder unsubstituiertes Phenyl bedeuten, wobei geeignete Substituenten vorstehend genannt sind; Halogenresten, bevorzugt F, Cl, Br, besonders bevorzugt F oder Cl, ganz besonders bevorzugt F, halogenierten C₁-C₂₀-Alkylresten, bevorzugt halogenierten C₁-C₆-Alkylresten, ganz besonders bevorzugt fluorierten C₁-C₆-Alkylresten, z. B. CF₃, CH₂F, CHF₂ oder C₂F₅; Amino, bevorzugt Dimethylamino, Diethylamino oder Diphenylamino; OH, Pseudohalogenresten, bevorzugt CN, SCN oder OCN, besonders bevorzugt CN, -C(O)OC₁-C₄-Alkyl, bevorzugt -C(O)OMe, P(O)R₂, bevorzugt P(O)Ph₂ und SO₂R₂, bevorzugt SO₂Ph.

Ganz besonders bevorzugte Substituenten mit Donor- oder Akzeptorwirkung sind ausgewählt aus der Gruppe bestehend aus Methoxy, Phenyloxy, halogeniertem C₁-C₄-Alkyl, bevorzugt CF₃, CH₂F, CHF₂, C₂F₅, Halogen, bevorzugt F, CN, SiR⁴R⁵R⁶, wobei geeignete Reste R⁴, R⁵ und R⁶ bereits genannt sind, Diphenylamino, -C(O)OC₁-C₄-Alkyl, bevorzugt -C(O)OMe, P(O)Ph₂ und SO₂Ph.

Durch die vorstehend genannten Gruppen mit Donor- oder Akzeptorwirkung soll nicht ausgeschlossen werden, dass auch weitere der vorstehend genannten Reste und Gruppen eine Donor- oder Akzeptorwirkung aufweisen können. Beispielsweise handelt es sich bei den vorstehend genannten Heteroarylresten ebenfalls um Gruppen mit Donor- oder Akzeptorwirkung und bei den C₁-C₂₀-Alkylresten handelt es sich um Gruppen mit Donorwirkung.

Die in den vorstehend genannten Gruppen mit Donor- oder Akzeptorwirkung erwähnten Reste R⁴, R⁵ und R⁶ haben die bereits vorstehend erwähnten Bedeutungen, d. h. R⁴, R⁵, R⁶ bedeuten unabhängig voneinander:

Wasserstoff, substituiertes oder unsubstituiertes C₁-C₂₀-Alkyl oder substituiertes oder unsubstituiertes C₆-C₃₀-Aryl oder substituiertes oder unsubstituiertes Heteroaryl mit 5 bis 30 Ringatomen, wobei geeignete und bevorzugte Alkyl- und Arylreste vorstehend genannt sind. Besonders bevorzugt bedeuten die Reste R⁴, R⁵ und R⁶ C₁-C₆-Alkyl, z. B. Methyl, Ethyl, i-Propyl, tert-Butyl, oder Phenyl oder Pyridyl.

Das Metallatom M ist in den erfindungsgemäßen verbrückten cyclometallierten Carbenkomplexen der allgemeinen Formel I ausgewählt aus der Gruppe bestehend aus Metallen der Gruppe IB, IIB, IIIB, IVB, VB, VIB, VIIB, VIIIB, den Lanthaniden und IIIA des Periodensystems der Elemente (CAS-Version) in jeder für das entsprechende Metallatom möglichen Oxidationsstufe; bevorzugt Fe, Os, Co, Rh, Ir, Ni, Ru, Pd und Pt, Cu, Au, Ce, Tb, Eu, besonders bevorzugt Os, Ru, Rh, Ir und Pt und ganz besonders bevorzugt Ir, Os und Pt, in jeder für das entsprechende Metallatom möglichen Oxidationsstufe.

Besonders bevorzugt ist das Metall M ausgewählt aus der Gruppe bestehend aus Ir, Os und Pt, wobei Os(II), Ir(III) und Pt(II) bevorzugt sind. Besonders bevorzugt ist Ir(III).

Die Zahl der Carbenliganden n sowie die Zahlen m und o der gegebenenfalls vorliegenden Liganden K und L sind von der Oxidationsstufe und der Koordinationszahl des Metalls M, der Zähnigkeit und der Ladung der Liganden L abhängig, wobei in den erfindungsgemäßen Carbenkomplexen der Formel I mindstens ein Carbenligand vorliegt, d.h. n mindestens 1 ist.

Im Folgenden sind bevorzugte Ausführungsformen efindungsgemäßer Carbenkomplexe der Formel I in Abhängigkeit von der Ladung und Koordinationszahl des eingesetzten Metalls M beschrieben:

In dem Fall, wenn M ein Metall mit einer Koordinationszahl von 4 ist (z.B. Pt(II) oder Pd(II), Ir(I), Rh(I)), weisen die erfindungsgemäßen Carbenkomplexe der Formel I einen oder zwei Carbenliganden auf, d. h. n ist 1 oder 2, wobei in dem Fall, wenn n 1 bedeutet und M ein Metall mit einer Koordinationszahl von 4 ist, in den erfindungsgemäßen Carbenkomplexen neben dem Carbenliganden ein monoanionischer bidentater Ligand L vorliegt, d.h. o ist 1. In dem Fall, wenn M ein Metall mit einer Koordinationszahl von 6 ist (z.B. Ir(III), Co(II), Co(III), Rh(III), Os(II), Pt(IV)), weisen die erfindungsgemäßen Carbenkomplexe der Formel I in Abhängigkeit von ihrer Ladung bevorzugt einen, zwei oder drei, bevorzugt zwei oder drei Carbenliganden der allgemeinen Formel I auf, die gleich oder verschieden sein können, d.h. n ist 1, 2 oder 3, bevorzugt 2 oder 3. Z.B. ist n in dem Fall von Ir(III), Co(III) oder Rh(III) im Allgemeinen 1, 2 oder 3, wobei in dem Fall von n = 1 zwei zusätzliche monoanionische bidentate Liganden L vorliegen, d.h. o ist 2. In dem Fall, wenn n = 2 ist, weisen die vorstehend genannten Carbenkomplexe einen zusätzlichen monoanionischen bidentaten Liganden L auf, d.h. o ist 1. In dem Fall, wenn n = 3 ist, was besonders bevorzugt ist, weisen die vorstehend genannten Carbenkomplexe keine weiteren Liganden K und L auf, d.h. m und o sind 0. In dem Fall von Os(II) ist n im Allgemeinen 1 oder 2, wobei in dem Fall von n = 1 ein zusätzlicher monoanionischer bidentater Ligand L und ein zusätzlicher neutraler bidentater Ligand K vorliegen, d.h. o ist 1 und m ist 1. In dem Fall, wenn n = 2 ist, was besonders bevorzugt ist, weisen die vorstehend genannten Carbenkomplexe einen zusätzlichen neutralen bidentaten Liganden K auf, d.h. m ist 1. Weist das Metallatom M eine Koordinationszahl von 8 oder mehr auf, können die erfindungsgemäßen Carbenkomplexe der allgemeinen Formel I neben einem, zwei oder drei Carbenliganden entweder einen oder mehrere weitere Carbenliganden und/oder einen oder mehrere zusätzliche Liganden K und/oder L afweisen. In einer bevorzugten Ausführungsform betrifft die vorliegende Erfindung verbrückte cyclometallierte Carbenkomplexe der allgemeinen Formel I, die ein Metall M mit einer Koordinationszahl von 6, bevorzugt Ir(III), aufweisen, wobei n = 3 ist und m und o 0 bedeuten.

In Abhängigkeit von der Koordinationszahl des eingesetzten Metalls M und der Zahl n der eingesetzten Carbenliganden und der Zahlen m und o der gegebenenfalls eingesetzten zusätzlichen Liganden K und L können verschiedene Isomere der entsprechenden Metallkomplexe bei gleichem Metall M und gleicher Natur der eingesetzten Carbenliganden und zusätzlichen vorliegen. Zum Beispiel sind bei Komplexen mit einem Metall M mit der Koordinationszahl 6 (also oktaedrischen Komplexen), zum Beispiel Ir(III)-Komplexen, "fac-mer-Isomere" (facial/meridional-Isomere) möglich, wenn es sich um Komplexe der allgemeinen Zusammensetzung M(AB)₃, wobei AB bidentate Liganden sind, handelt. Dabei sind im Sinne der vorliegenden Anmeldung unter "fac-mer-Isomeren" die im Folgenden dargestellten Isomere zu verstehen:

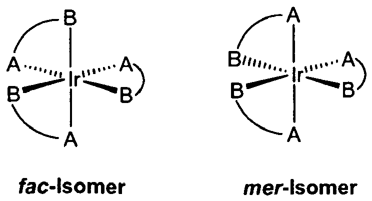

Bei quadratisch planaren Komplexen mit einem Metall M mit der Koordinationszahl 4, zum Beispiel Pt(II)-Komplexen, sind "cis/trans-Isomere" möglich, wenn es sich um Komplexe der allgemeinen Zusammmensetzung M(AB)₂, wobei AB bidentate Liganden sind, handelt. Dabei sind im Sinne der vorliegenden Anmeldung unter "Isomeren" die im Folgenden dargestellten Isomere zu verstehen:

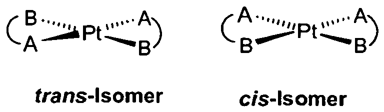

Bei den Symbolen A und B handelt es sich jeweils um eine Bindungsstelle eines Liganden, wobei nur bidentate Liganden vorliegen. Ein bidentater Ligand weist gemäß der vorstehend erwähnten allgemeinen Zusammensetzung zwei Gruppen A und zwei Gruppen B auf.

Dem Fachmann ist grundsätzlich bekannt, was unter cis/trans- bzw. fac-mer-Isomeren zu verstehen ist. Bei Komplexen der Zusammensetzung MA₃B₃ können drei Gruppen der gleichen Art entweder die Ecken einer Oktaederfläche besetzen (faciales Isomer) oder einen Meridian, das heißt zwei der drei Ligandenbindungsstellen sind zueinander trans-ständig (meridionales Isomer). Bezüglich der Definition von cis/trans-Isomeren bzw. fac-mer-Isomeren in oktaedrischen Metallkomplexen siehe zum Beispiel J. Huheey, E. Keiter, R. Keiter, Anorganische Chemie: Prinzipien von Struktur und Reaktivität, 2., neu bearbeitete Auflage, übersetzt und erweitert von Ralf Steudel, Berlin; New York: de Gruyter, 1995, Seiten 575, 576.

Bei quadratisch planaren Komplexen bedeutet cis-Isomerie, dass bei Komplexen der Zusammensetzung MA₂B₂ sowohl die beiden Gruppen A als auch die beiden Gruppen B benachbarte Ecken eines Quadrats belegen, während sowohl die beiden Gruppen A als auch die beiden Gruppen B bei der trans-Isomerie jeweils die beiden einander diagonal gegenüber liegenden Ecken eines Quadrats belegen. Bezüglich der Definition von cis/trans-Isomeren in quadratisch planaren Metallkomplexen siehe zum Beispiel J. Huheey, E. Keiter, R, Keiter, Anorganische Chemie: Prinzipien von Struktur und Reaktivität, 2., neu bearbeitete Auflage, übersetzt und erweitert von Ralf Stendel, Berlin; New York: de Gruyter, 1995, Seiten 557 bis 559.

Im Allgemeinen können die verschiedenen Isomere der erfindungsgemäßen Carbenkomplexe der Formel I nach dem Fachmann bekannten Verfahren, zum Beispiel durch Chromatographie, Sublimation oder Kristallisation, getrennt werden.

Die vorliegende Erfindung betrifft somit sowohl jeweils die einzelnen Isomere der Carbenkomplexe der Formel I als auch Gemische verschiedener Isomere in jedem beliebigen Mischungsverhältnis.

Die Zahl n der Carbenliganden beträgt in den erfindungsgemäßen verbrückten cyclometallierten Carbenkomplexen der Formel I, worin das Übergangsmetallatom M eine Koordinationszahl von 6 und die Oxidationsstufe III aufweist, wobei Ir(III) besonders bevorzugt ist, bevorzugt 3 und die Zahlen m und o der zusätzlichen Liganden K und L sind in diesen Komplexen bevorzugt 0.

Die Zahl n der Carbenliganden beträgt in den erfindungsgemäßen verbrückten cyclometallierten Carbenkomplexen der Formel I, worin das Übergangsmetallatom M eine Koordinationszahl von 6 und die Oxidationsstufe II aufweist, wobei Os(II) besonders bevorzugt ist, bevorzugt 2, wobei ein zusätzlicher neutraler bidentater Ligand K vorliegt, d.h. m ist bevorzugt 1. o ist in diesen Komplexen bevorzugt 0.

Die Zahl n der Carbenliganden beträgt in den erfindungsgemäßen verbrückten cyclometallierten Carbenkomplexen der Formel I, worin das Übergangsmetallatom M eine Koordinationszahl von 4 aufweist, wobei Pt(II) besonders bevorzugt ist, bevorzugt 1 oder 2, wobei in dem Fall von n = 1 bevorzugt ein zusätzlicher monoanionischer bidentater Ligand L vorliegt, d.h. o ist ebenfalls bevorzugt 1 und m ist bevorzugt 0. In dem Fall von n = 2 sind m und o jeweils bevorzugt 0.

In einer ganz besonders bevorzugten Ausführungsform ist M in den Carbenkomplexen der Formel I Ir(III), n 3 und m und o bedeuten 0.

Die n Carbenliganden können in dem Carbenkomplex bei n > 1 gleich oder verschieden sein. Bevorzugt sind sie gleich, d.h. in dem Fall von M = Ir(III) und n = 3 sind die drei Carbenliganden bevorzugt gleich.

Geeignete mono- oder dianionische Liganden L, bevorzugt monoanionische Liganden L, die mono- oder bidentat sein können, sind die üblicherweise als mono- oder bidentate mono- oder dianionische Liganden eingesetzten Liganden.

Geeignete monoanionische monodentate Liganden sind zum Beispiel Halogenide, insbesondere Cl⁻ und Br⁻, Pseudohalogenide, insbesondere CN⁻, Cyclopentadienyl (Cp⁻), Hydrid, Alkoxy, Aryloxy, Alkylreste, die mit dem Übergangsmetall M über eine Sigmabindung verknüpft sind, zum Beispiel CH₃, Alkylarylreste, die mit dem Übergangsmetall M¹ über eine Sigmabindung verknüpft sind, zum Beispiel Benzyl.

Geeignete monoanionische bidentate Liganden sind zum Beispiel Acetylacetonat und dessen Derivate, Picolinat, Schiffsche Basen, Aminosäuren, Arylazole, z.B. Phenylpyridin sowie die weiteren in WO 02/15645 genannten bidentaten monoanionischen Liganden, wobei Acetylacetonat, und Picolinat bevorzugt sind.

Geeignete dianionische bidentate Liganden sind zum Beispiel Dialkoholate, Dicarbonate, Dicarboxylate, Diamide, Diimide, Dithiolate, Biscyclopentadienyle, Bisphosphonate, Bissulfonate und 3-Phenylpyrazol.

Geeignete neutrale mono- oder bidentate Liganden K sind bevorzugt ausgewählt aus der Gruppe bestehend aus Phosphinen, sowohl Mono- als auch Bisphosphinen; Phosphonaten, sowohl Mono- als auch Bisphosphonaten, und Derivaten davon, Arsenaten, sowohl Monoals auch Bisarsenaten, und Derivaten davon; Phosphiten, sowohl Mono- als auch Bisphosphiten; CO; Pyridinen, sowohl Mono- als auch Bispyridinen; Nitrilen, Dinitrilen, Allyl, Diaminen, nicht konjugierten Dienen und konjugierten Dienen, die einen π-Komplex mit M¹ bilden. Besonders bevorzugte neutrale mono- oder bidentate Liganden K sind ausgewählt aus der Gruppe bestehend aus Phosphinen, sowohl Mono- als auch Bisphosphinen, bevorzugt Trialkyl-, Triaryl- oder Alkylarylphosphinen, besonders bevorzugt PAr₃, wobei Ar ein substituierter oder unsubstituierter Arylrest ist und die drei Arylreste in PAr₃ gleich oder verscheiden sein können, besonders bevorzugt PPh₃, PEt₃, PnBu₃, PEt₂Ph, PMe₂Ph, PnBu₂Ph; Phosphonaten und Derivaten davon, Arsenaten und Derivaten davon, Phosphiten, CO; Pyridinen, sowohl Mono- als auch Bispyridinen, wobei die Pyridine mit Alkyl- oder Arylgruppen substituiert sein können; Nitrilen und Dienen, die einen π-Komplex mit M¹ bilden, bevorzugt η⁴-Diphenyl-1,3-butadien, η⁴-1,3-Pentadien, η⁴-1 -Phenyl-1,3-pentadien, η⁴-1,4-Dibenzyl-1,3-butadien, η⁴-2,4-Hexadien, η⁴-3-Methyl-1,3-pentadien, η⁴-1,4-Ditolyl-1,3-butadien, η⁴-1,4-Bis(trimethylsilyl)-1,3-butadien und η²- oder η⁴-Cyclooctadien (je 1,3 und je 1,5), besonders bevorzugt 1,4-Diphenyl-1,3-butadien, 1-Phenyl-1,3-pentadien, 2,4-Hexadien, Butadien, η²-Cycloocten, η⁴-1,3-Cyclooctadien und η⁴-1,5-Cyclooctadien. Ganz besonders bevorzugte neutrale monodentate Liganden sind ausgewählt aus der Gruppe bestehend aus PPh₃, P(OPh)₃, AsPh₃, CO, Pyridin, Nitrilen und deren Derivaten. Geeignete neutrale mono- bzw. bidentate Liganden sind bevorzugt 1,4-Diphenyl-1,3-butadien, 1-Phenyl-1,3-pentadien, 2,4-Hexadien, η⁴-Cyclooctadien und η²-Cyclooctadien (je 1,3 und je 1,5).

Der Rest R¹ der Gruppe X bedeutet in den cyclometallierten Carbenkomplexen der Formel I F, CN, C₁-C₂₀-Alkoxy, C₆-C₃₀-Aryloxy, C₁-C₂₀-Alkylthio, C₆-C₃₀-Arylthio, substituiertes oder unsubstituiertes C₆-C₃₀-Aryl oder substituiertes oder unsubstituiertes Heteroaryl mit 5 bis 30 Ringatomen. Bevorzugt bedeutet der Rest R¹ der Gruppe X F, CN, C₁- bis C₄-Alkoxy, besonders bevorzugt Methoxy, C₆- bis C₁₀-Aryloxy, besonders bevorzugt Phenoxy, C₁- bis C₄-Alkylthio, besonders bevorzugt SCH₃, C₆- bis C₁₀-Arylthio, substituiertes oder unsubstituiertes Phenyl, besonders bevorzugt unsubstituiertes Phenyl, Tolyl, Dimethylphenyl, Trimethylphenyl, mit F, CN, Methoxy und/oder CF₃ substituiertes Phenyl, oder substituiertes oder unsubstituiertes Heteroaryl mit 5 bis 13 Ringatomen, besonders bevorzugt Pyridyl, Thienyl, Pyrrolyl, Furyl, Thiazolyl, Oxazolyl, Pyrazolyl oder Imidazolyl. Ganz besonders bevorzugt bedeutet der Rest R¹ F, CN oder Methoxy, Phenyl, Pyridyl.

Bevorzugt bedeutet die Gruppe X in den cyclometallierten Carbenkomplexen der Formel I N, d. h. der Rest R¹ ist nicht vorhanden.

Die Reste R² und R³ in den verbrückten cyclometallierten Carbenkomplexen der Formel I bedeuten unabhängig voneinander substituiertes oder unsubstituiertes C₁-C₂₀-Alkyl, substituiertes oder unsubstituiertes C₅-C₂₀-Cycloalkyl, substituiertes oder unsubstituiertes C₅-C₂₀-Cycloalkenyl, substituiertes oder unsubstituiertes Heterocycloalkyl mit 5 bis 30 Ringatomen, substituiertes oder unsubstituiertes Heterocycloalkenyl mit 5 bis 30 Ringatomen, substituiertes oder unsubstituiertes C₂-C₂₀-Alkenyl, substituiertes oder unsubstituiertes C₂-C₂₀-Alkinyl substituiertes oder unsubstituiertes C₆-C₃₀-Aryl, substituiertes oder unsubstituiertes Heteroaryl mit 5 bis 30 Ringatomen oder ein Substituent mit Donor- oder Akzeptorwirkung ausgewählt aus der Gruppe bestehend aus: C₁-C₂₀-Alkoxy, C₆-C₃₀-Aryloxy, C₁-C₂₀-Alkylthio, C₆-C₃₀-Arylthio, SiR⁴R⁵R⁶, Halogenresten, halogenierten C₁-C₂₀-Alkylresten, Carbonyl (-CO(R⁴)), Carbonylthio (-C=O(SR⁴)), Carbonyloxy (-C=O(OR⁴)), Oxycarbonyl (-OC=O(R⁴)), Thiocarbonyl (-SC=O(R⁴)), Amino (-NR⁴R⁵), OH, Pseudohalogenresten, Amido (-C=O(NR⁴R⁵)), -NR⁴C=O(R⁵), Phosphonat (- P(O)(OR⁴)₂, Phosphat (-OP(O)(OR⁴)₂), Phosphin (-PR⁴R⁵), Phosphinoxid (-P(O)R⁴₂), Sulfat (-OS(O)₂OR⁴), Sulfoxid (-S(O)R⁴), Sulfonat (-S(O)₂OR⁴), Sulfonyl (-S(O)₂R⁴, Sulfonamid (-S(O)₂NR⁴R⁵), NO₂, Boronsäureestern (-B(OR⁴)₂), Imino (-C=NR⁴R⁵)), Boranresten, Stannatresten, Hydrazinresten, Hydrazonresten, Oximresten, Nitroso-Gruppen, Diazo-Gruppen, Vinylgruppen, Sulfoximinen, Alanen, Germanen, Boroxinen und Borazinen;
oder
zwei benachbarte Reste R³ bilden gemeinsam eine gesättigte oder ungesättigte substituierte oder unsubstituierte Brücke aus 3 bis 6 Atomen, so dass die Reste R³ gemeinsam mit einem der Elemente A=D, D-E, A'=D_{'}, D'-E', E'=G' einen 5- bis 8-gliedrigen Ring bilden;
oder
die Reste R³ an den Positionen G' und A bilden gemeinsam eine gesättigte oder ungesättigte substituierte oder unsubstituierte Brücke aus 1 bis 4 Atomen, so dass die Reste R³ gemeinsam mit dem Element -G'-C-C-A- einen 5- bis 8-gliedrigen Ring bilden;
bevorzugt sind die Brücken unsubstituiert (d.h. alle substituierbaren Positionen sind mit Wasserstoff substituiert) oder mit einem oder mehreren Resten ausgewählt aus der Gruppe bestehend aus C₁- bis C₄-Alkyl, besonders bevorzugt Methyl, Ethyl, n-Propyl, Isopropyl, n-Butyl, Isobutyl, sek.-Butyl oder tert.-Butyl, substituiertem oder unsubstituiertem Phenyl, bevorzugt unsubstituiertem Phenyl, Tolyl, Dimethylphenyl, Trimethylphenyl, mit F, CN, Methoxy und/oder CF₃ substituiertem Phenyl, substituiertem oder unsubstituiertem Heteroaryl mit 5 bis 13 Ringatomen, bevorzugt Pyridyl, Thienyl, Pyrrolyl, Furyl oder Imidazolyl, C₁- bis C₄-Alkoxy, besonders bevorzugt Methoxy, C₆- bis C₁₀-Aryloxy, besonders Phenoxy, C₁- bis C₄-Alkylthio, bevorzugt SCH₃, C₆- bis C₁₀-Arylthio, bevorzugt SPh, SiR⁴R⁵R⁶, bevorzugt SiMe₃ oder SiPh₃, F, Cl, Br, bevorzugt F, halogenierten C₁-C₁₀-Alkylresten, bevorzugt CF₃, und Pseudohalogenresten, bevorzugt CN substituiert;
wobei die Brücken bevorzugt aus Kohlenstoffatomen aufgebaut sind und gegebenenfalls 1 oder 2 Heteroatome, bevorzugt 1 oder 2 N Atome, aufweisen.

In einer bevorzugten Ausführungsform sind R² und R³ unabhängig voneinander ausgewählt aus der Gruppe bestehend aus substituiertem oder unsubstituiertem C₁-C₂₀-Alkyl, substituiertem oder unsubstituiertem C₂-C₂₀-Alkenyl, substituiertem oder unsubstituiertem C₂-C₂₀-Alkinyl, substituiertem oder unsubstituiertem C₆-C₃₀-Aryl, substituiertem oder unsubstituiertem Heteroaryl mit 5 bis 30 Ringatomen, C₁-C₂₀-Alkoxy, C₆-C₃₀-Aryloxy, C₁-C₂₀-Alkylthio, C₆-C₃₀-Arylthio, SiR⁴R⁵R⁶, Halogenresten, halogenierten C₁-C₂₀-Alkylresten und Pseudohalogenresten. Besonders bevorzugt sind R² und R³ unabhängig voneinander ausgewählt aus der Gruppe bestehend aus substituiertem oder unsubstituiertem C₁-C₂₀-Alkyl, bevorzugt C₁- bis C₄-Alkyl, besonders bevorzugt Methyl, Ethyl, n-Propyl, Isopropyl, n-Butyl, Isobutyl, sek.-Butyl oder tert.-Butyl, substituiertem oder unsubstituiertem C₆-C₃₀-Aryl, bevorzugt substituiertem oder unsubstituiertem Phenyl, besonders bevorzugt unsubstituiertem Phenyl, Tolyl, Dimethylphenyl, Trimethylphenyl, mit F, CN, Methoxy und/oder CF₃ substituiertem Phenyl, substituiertem oder unsubstituiertem Heteroaryl mit 5 bis 30 Ringatomen, bevorzugt substituiertem oder unsubstituiertem Heteroaryl mit 5 bis 13 Ringatomen, besonders bevorzugt Pyridyl, Thienyl, Pyrrolyl, Furyl, Thiazolyl, Oxazolyl, Pyrazolyl oder Imidazolyl, C₁-C₂₀-Alkoxy, bevorzugt C₁- bis C₄-Alkoxy, besonders bevorzugt Methoxy, C₆-C₃₀-Aryloxy, bevorzugt C₆- bis C₁₀-Aryloxy, besonders bevorzugt Phenoxy, C₁-C₂₀-Alkylthio, bevorzugt C₁- bis C₄-Alkylthio, besonders bevorzugt SCH₃, C₆-C₃₀-Arylthio, bevorzugt C₆- bis C₁₀-Arylthio, besonders bevorzugt SPh, SiR⁴R⁵R⁶, bevorzugt SiMe₃ oder SiPh₃, Halogenresten, bevorzugt F, Cl, Br, besonders bevorzugt F, halogenierten C₁-C₂₀-Alkylresten, bevorzugt halogenierten C₁-C₁₀-Alkylresten, besonders bevorzugt CF₃, und Pseudohalogenresten, bevorzugt CN;
oder
zwei benachbarte Reste R³ bilden gemeinsam eine gesättigte oder ungesättigte mit Methyl, Phenyl, Methoxy, SiMe₃, SiPh₃, F, CF₃ oder CN substituierte oder unsubstituierte Brücke aus 3 oder 4 Kohlenstoffatomen, so dass die Reste R³ gemeinsam mit einem der Elemente A=D, D-E, A'=D', D'-E', E'=G' einen 5- oder 6-gliedrigen Ring bilden;
oder
die Reste R³ an den Positionen G' und A bilden gemeinsam eine gesättigte oder ungesättigte mit Methyl, Phenyl, Methoxy, SiMe₃, SiPh₃, F, CF₃ oder CN substituierte oder unsubstituierte Brücke aus 1 oder 2 Kohlenstoffatomen, so dass die Reste R³ gemeinsam mit dem Element -G'-C-C-A- einen 5- oder 6-gliedrigen Ring bilden.

In einer besonders bevorzugten Ausführungsform haben R¹ (wenn der Rest R¹ vorhanden ist) und R³ die vorstehend für R¹ und R³ genanten Bedeutungen und R² ist ausgewählt aus der Gruppe bestehend aus substituiertem oder unsubstituiertem C₁-C₂₀-Alkyl, das in 1-Position verzweigt ist, bevorzugt Isopropyl, Isobutyl, Isopentyl, sek-Butyl oder tert-Butyl; substituiertem oder unsubstituiertem C₆-Aryl, bevorzugt unsubstituiertem Phenyl oder Phenyl, das in 2- und/oder 6-Position substituiert ist, bevorzugt mit Methyl, Methoxy, CF₃, CN und/oder F; besonders bevorzugt 2-Tolyl, 2-Methoxyphenyl, 2-Cyanophenyl, 2-Trifluormethylphenyl, 2,6-Difluorophenyl, 2,3-, 2,4-, 2,5- oder 2,6-Dimethylphenyl oder 2,4,6-, 2,3,4- oder 2,3,5-Trimethylphenyl; substituiertem oder unsubstituiertem Heteroaryl mit 5 bis 13 Ringatomen, bevorzugt Pyridin-2-yl, Pyridin-3-yl, Pyridin-4-yl, Thiophen-2-yl, Thiophen-3-yl, Pyrrol-2-yl, Pyrrol-3-yl, Furan-2-yl, Furan-3-yl, Thiazol-2-yl, Oxazol-2-yl, Pyrazol-3-yl oder Imidazol-2-yl sowie den entsprechenden benzanellierten Resten.

Es wurde gefunden, dass sich Carbenkomplexe der Formel I, die die vorstehend genannten besonders bevorzugten Reste R² aufweisen, eine besonders gute Stabilität aufweisen.

In einer bevorzugten Ausführungsform betrifft die vorliegende Erfindung verbrückte cyclometallierte Carbenkomplexe der Formel I worin X N bedeutet. Y bedeutet bevorzugt NR², wobei geeignete Reste R² vorstehend genannt sind. Besonders bevorzugt sind somit Carbenkomplexe der Formel I, worin:
- X: N, und
- Y: NR² bedeuten,
wobei R² die vorstehend genannten Bedeutungen aufweist.

Die Gruppen A, D, G, E, A', D', G' und E' bedeuten in den Carbenkomplexen der Formel I unabhängig voneinander CH, CR³ oder N. Bevorzugt bedeuten 0, 1 oder 2, besonders bevorzugt 0 oder 1 Gruppe ausgewählt aus den Gruppen A, D, G und E bzw. ausgewählt aus den Gruppen A', D', G' und E' N. In einer besonders bevorzugten Ausführungsform bedeuten die Gruppen A, D, G, E, A', D', G' und E' CH oder CR³, ganz besonders bevorzugt CH. Geeignete Reste R³ sind vorstehend genannt.

Besonders bevorzugte Carbenkomplexe der Formel I sind ausgewählt aus Carbenkomplexen der-Formeln Ia und Ib: 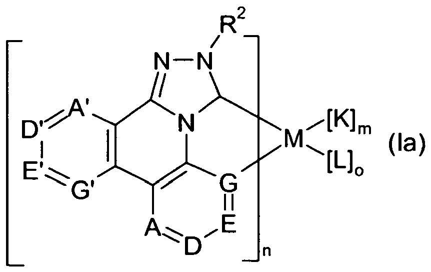 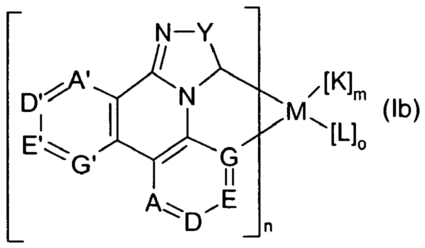 worin bedeuten:
- A, D, G, E, A', D', G' und E': unabhängig voneinander CH, CR³ oder N, bevorzugt CH oder CR³, besonders bevorzugt CH;
- R², R³: unabhängig voneinander substituiertes oder unsubstituiertes C₁-C₂₀-Alkyl, substituiertes oder unsubstituiertes C₅-C₂₀-Cycloalkyl, substituiertes oder unsubstituiertes C₅-C₂₀-Cycloalkenyl, substituiertes oder unsubstituiertes Heterocycloalkyl mit 5 bis 30 Ringatomen, substituiertes oder unsubstituiertes Heterocycloalkenyl mit 5 bis 30 Ringatomen, substituiertes oder unsubstituiertes C₂-C₂₀-Alkenyl, substituiertes oder unsubstituiertes C₂-C₂₀-Alkinyl substituiertes oder unsubstituiertes C₆-C₃₀-Aryl, substituiertes oder unsubstituiertes Heteroaryl mit 5 bis 30 Ringatomen oder ein Substituent mit Donor- oder Akzeptorwirkung ausgewählt aus der Gruppe bestehend aus: C₁-C₂₀-Alkoxy, C₆-C₃₀-Aryloxy, C₁-C₂₀-Alkylthio, C₆-C₃₀-Arylthio, SiR⁴R⁵R⁶, Halogenresten, halogenierten C₁-C₂₀-Alkylresten, Carbonyl (-CO(R⁴)), Carbonylthio (-C=O(SR⁴)), Carbonyloxy (-C=O(OR⁴)), Oxycarbonyl (-OC=O(R⁴)), Thiocarbonyl (-SC=O(R⁴)), Amino (-NR⁴R⁵), OH, Pseudohalogenresten, Amido (-C=O(NR⁴R⁵)), -NR⁴C=O(R⁵), Phosphonat (- P(O)(OR⁴)₂, Phosphat (-OP(O)(OR⁴)₂), Phosphin (-PR⁴R⁵), Phosphinoxid (-P(O)R⁴₂), Sulfat (-OS(O)₂OR⁴), Sulfoxid (-S(O)R⁴), Sulfonat (-S(O)₂OR⁴), Sulfonyl (-S(O)₂R⁴, Sulfonamid (-S(O)₂NR⁴R⁵), NO₂, Boronsäureestern (-B(OR⁴)₂), Imino (-C=NR⁴R⁵)), Boranresten, Stannatresten, Hydrazinresten, Hydrazonresten, Oximresten, Nitroso-Gruppen, Diazo-Gruppen, Vinylgruppen, Sulfoximinen, Alanen, Germanen, Boroxinen und Borazinen;
oder
zwei benachbarte Reste R³ bilden gemeinsam eine gesättigte oder ungesättigte substituierte oder unsubstituierte Brücke aus 3 bis 6 Atomen, so dass die Reste R³ gemeinsam mit einem der Elemente A=D, D-E, A'=D', D'-E', E'=G' einen 5- bis 8-gliedrigen Ring bilden;
oder
die Reste R³ an den Positionen G' und A bilden gemeinsam eine gesättigte oder ungesättigte substituierte oder unsubstituierte Brücke aus 1 bis 4 Atomen, so dass die Reste R³ gemeinsam mit dem Element -G'-C-C-A- einen 5- bis 8-gliedrigen Ring bilden;
wobei R² bevorzugt ausgewählt ist aus der Gruppe bestehend aus substituiertem oder unsubstituiertem C₁-C₂₀-Alkyl, das in 1-Position verzweigt ist, bevorzugt Isopropyl, Isobutyl, Isopentyl, sek-Butyl oder tert-Butyl; substituiertem oder unsubstituiertem C₆-Aryl, bevorzugt unsubstituiertem Phenyl oder Phenyl, das in 2- und/oder 6-Position substituiert ist, bevorzugt mit Methyl, Methoxy, CF₃, CN und/oder F; besonders bevorzugt 2-Tolyl, 2-Methoxyphenyl, 2-Cyanophenyl, 2-Trifluormethylphenyl, 2,6-Difluorophenyl, 2,3-, 2,4-, 2,5- oder 2,6-Dimethylphenyl oder 2,4,6-, 2,3,4- oder 2,3,5-Trimethylphenyl; substituiertem oder unsubstituiertem Heteroaryl mit 5 bis 13 Ringatomen, bevorzugt Pyridin-2-yl, Pyridin-3-yl, Pyridin-4-yl, Thiophen-2-yl, Thiophen-3-yl, Pyrrol-2-yl, Pyrrol-3-yl, Furan-2-yl, Furan-3-yl, Thiazol-2-yl, Oxazol-2-yl, Pyrazol-3-yl oder Imidazol-2-yl sowie den entsprechenden benzanellierten Resten;
- R⁴, R⁵, R⁶: unabhängig voneinander H, substituiertes oder unsubstituiertes C₁-C₂₀-Alkyl oder substituiertes oder unsubstituiertes C₆-C₃₀-Aryl oder substituiertes oder unsubstituiertes Heteroaryl mit 5 bis 30 Ringatomen;
- Y: CR²₂;
- M: Ir, Os oder Pt; bevorzugt Ir(III), Os(II) oder Pt(II), besonders bevorzugt Ir(III);
- K: neutraler bidentater Ligand;
- L: monoanionischer bidentater Ligand;
- n: Zahl der Carbenliganden, wobei n im Falle von Ir 3 bedeutet, im Falle von Os 2 bedeutet und im Falle von Pt 1 oder 2 bedeutet, und die Carbenliganden in dem Komplexen der Formeln Ia, Ib, Ic, und Id gleich oder verschieden sein können;
- m: im Falle von M = Ir oder Pt 0 und im Falle von Os 1;
- o: im Falle von M = Ir oder Os und Pt, für den Fall, dass n = 2 bedeutet, 0 und im Falle von Pt, für den Fall, dass n = 1 bedeutet, 1.

Besonders bevorzugte Reste, Gruppen und Indizes M, R², R³, R⁴, R⁵, R⁶, A, D, G, E, A', D', G', E', Y, M, K, L, n, m und o sind vorstehend genannt. Ganz besonders bevorzugt ist M in den Carbenkomplexen der Formeln Ia, Ib, Ic und Id Ir(III), n ist 3 und m und o sind 0.

Ganz besonders bevorzugt sind Carbenkomplexe der nachstehend genannten Formeln:

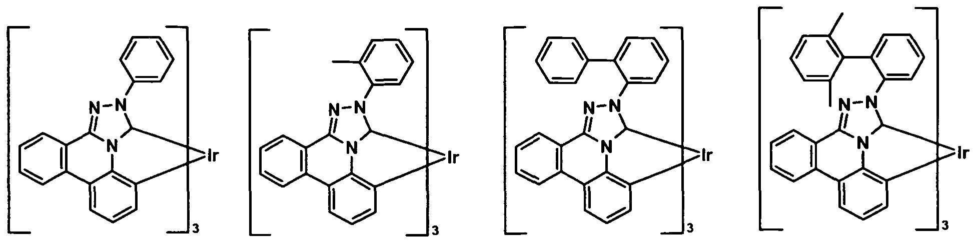

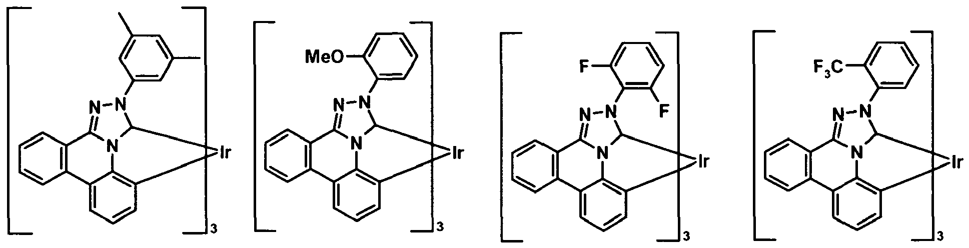

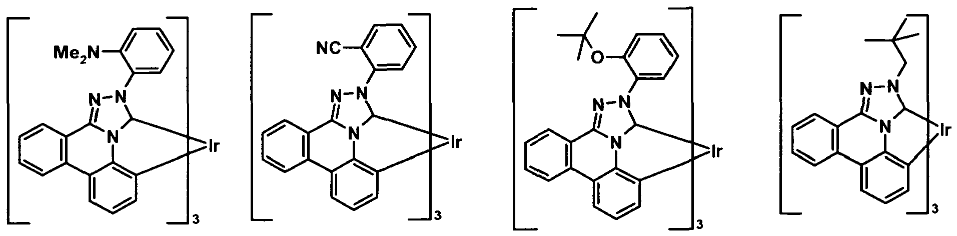

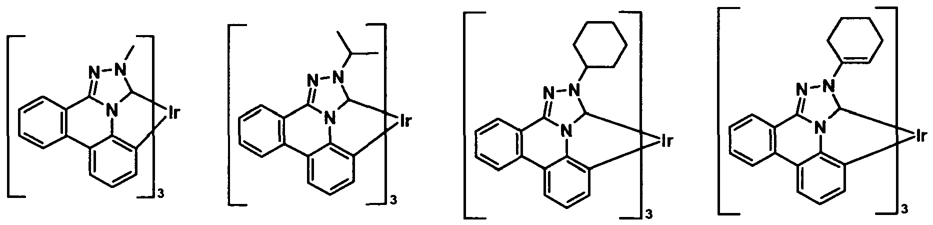

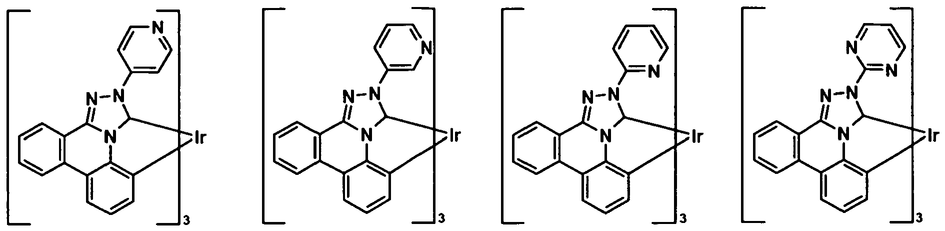

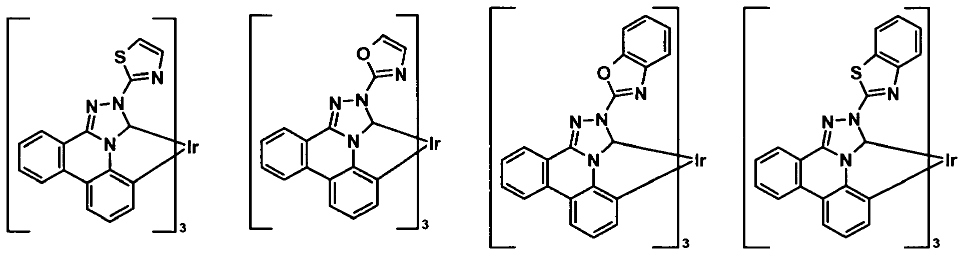

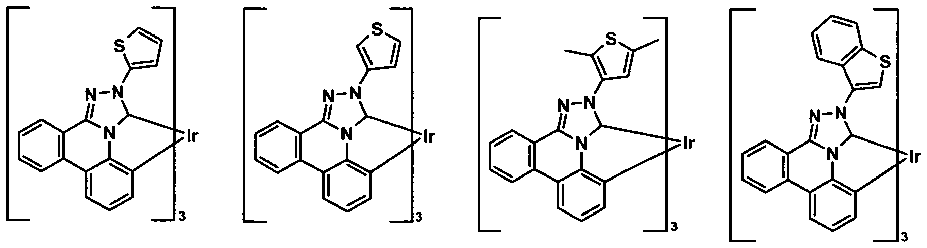

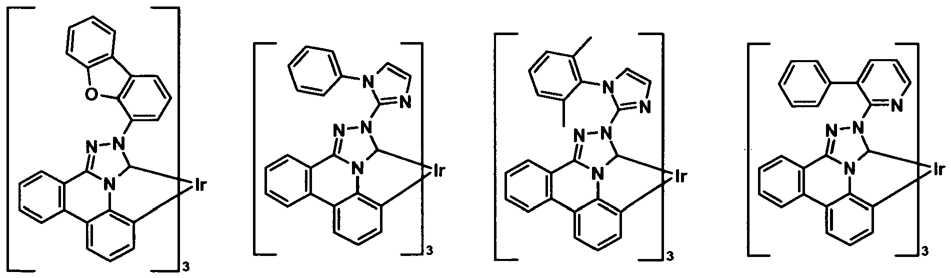

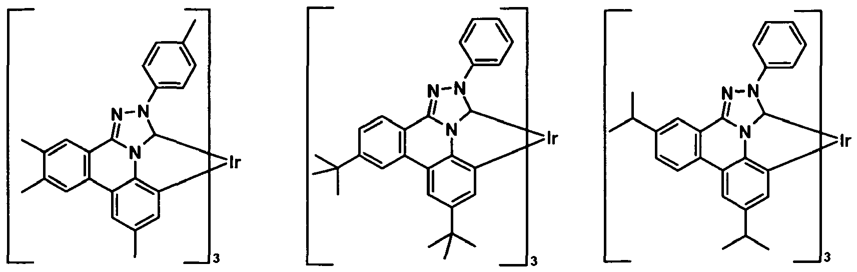

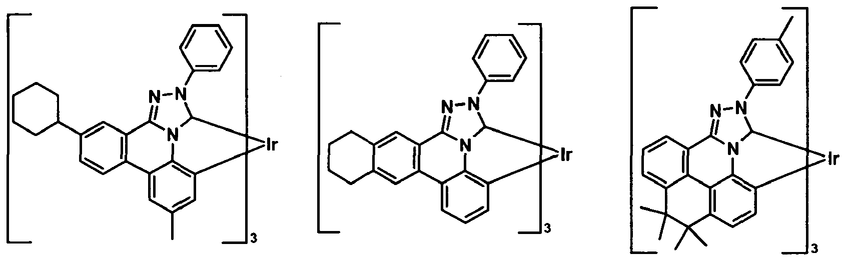

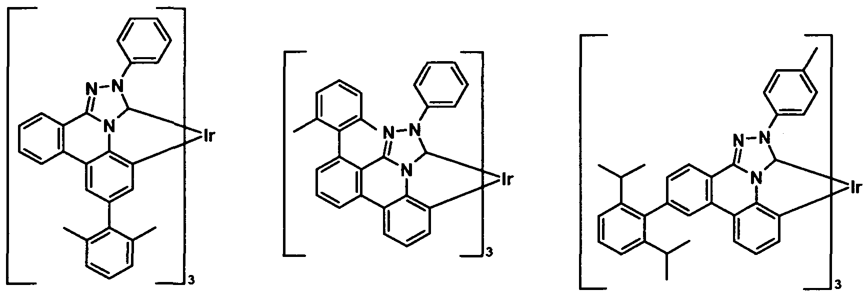

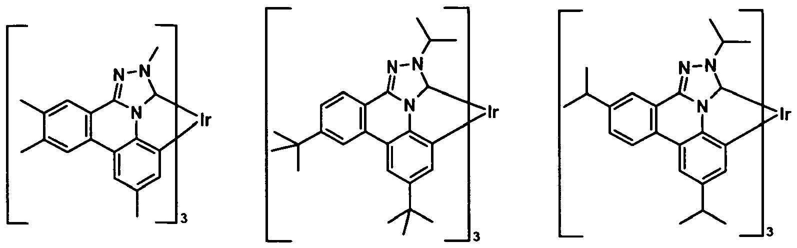

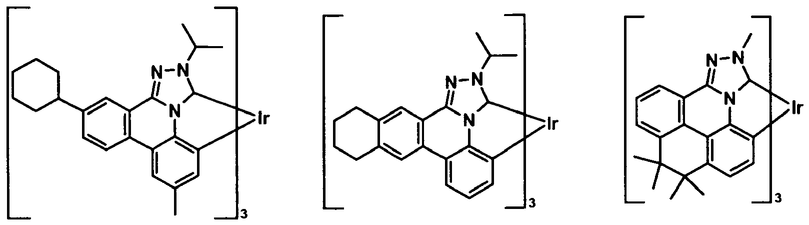

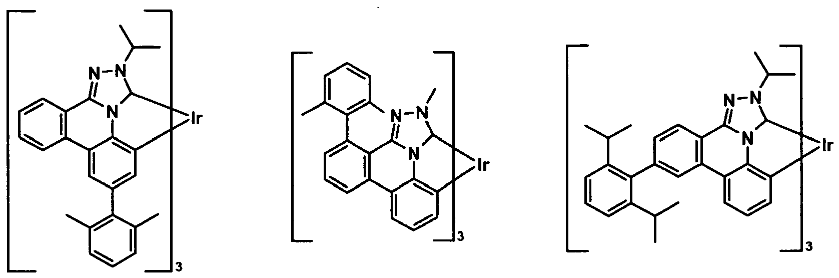

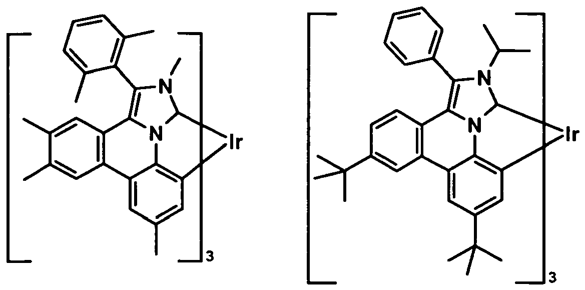

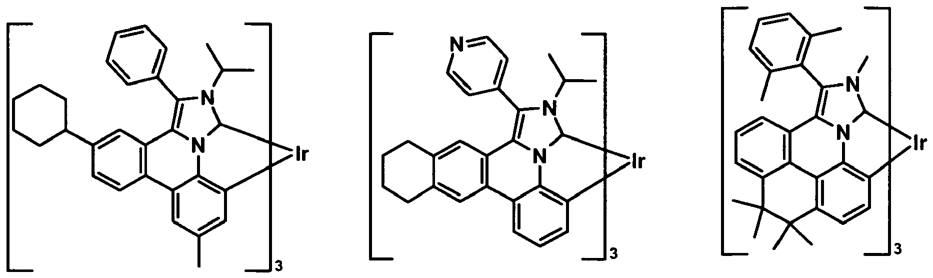

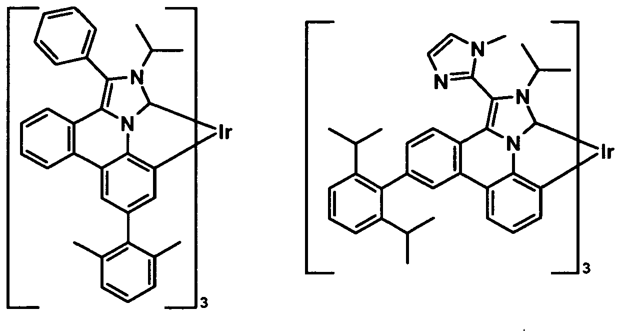

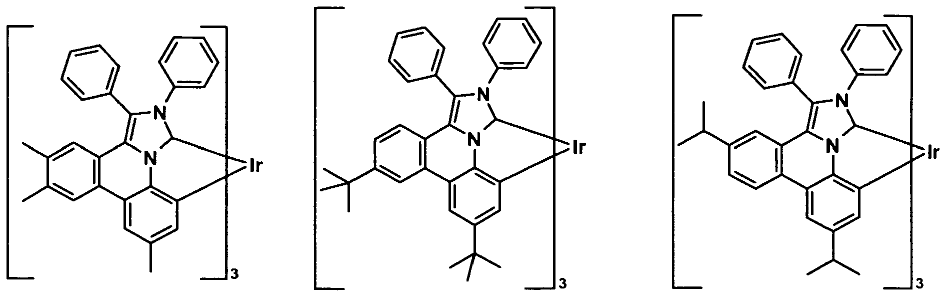

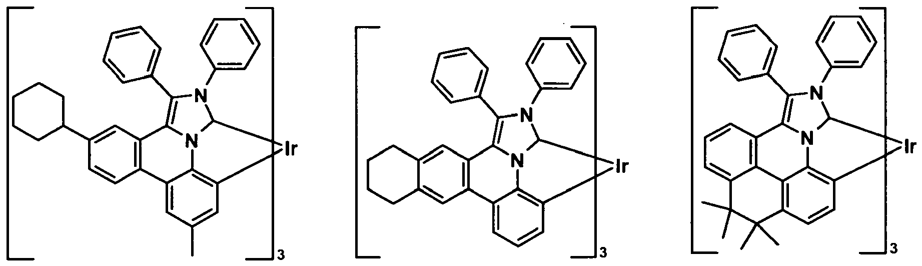

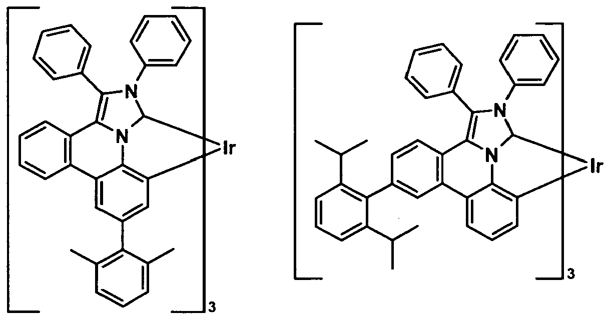

Die vorstehend genannten Verbindungen können ggf. mit einem oder mehreren weiteren Substituenten entsprechend der Definition der allgemeinen Formel I substituiert sein.

Die erfindungsgemäßen verbrückten cyclometallierten Carbenkomplexe der Formel I können grundsätzlich analog zu dem Fachmann bekannten Verfahren hergestellt werden. Geeignete Verfahren zur Herstellung von Carbenkomplexen sind zum Beispiel in den Obersichtsartikeln W. A. Hermann et al., Advances in Organometallic Chemistry, 2001 Vol. 48, 1 bis 69, W. A. Hermann et al., Angew. Chem. 1997, 109, 2256 bis 2282 und G. Bertrand et al. Chem. Rev. 2000, 100, 39 bis 91 und der darin zitierten Literatur aufgeführt, sowie in WO 2005/113704, WO 2005/019373 und in WO 2007/088093.

In einer Ausführungsform werden die erfindungsgemäßen verbrückten cyclometallierten Carbenkomplexe der Formel I aus den Carbenliganden entsprechenden Ligandvorläufern und geeigneten, das gewünschte Metall enthaltenden, Metallkomplexen hergestellt.

Geeignete Ligandvorläufer der Carbenliganden sind dem Fachmann bekannt. Bevorzugt handelt es sich um kationische Vorstufen der Carbenliganden der allgemeinen Formel III 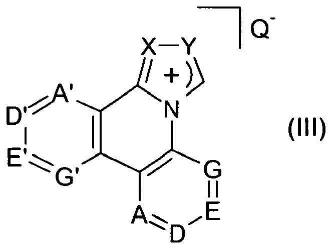 worin
- Q⁻: ein monoanionisches Gegenion, bevorzugt Halogenid, Pseudohalogenid, BF₄⁻, BPh₄⁻, PF₆⁻, AsF₆⁻ oder SbF₆⁻;
bedeutet; und
die weiteren Reste, Symbole und Indizes in dem Ligandvorläufer der allgemeinen Formel III die vorstehend genannten Bedeutungen aufweisen.

Die Ligandvorläufer der allgemeinen Formel III können analog zu dem Fachmann bekannten Verfahren hergestellt werden. Geeignete Verfahren sind z.B. in WO 2005/019373 und der darin zitierten Literatur, z.B. Organic Letters, 1999, 1, 953-956; Angewandte Chemie, 2000, 112, 1672-1674 genannt. Weitere geeignete Verfahren sind z.B. in T. Weskamp et al., J. Organometal. Chem. 2000, 600, 12-22; G. Xu et al., Org. Lett. 2005, 7, 4605-4608 ; V. Lavallo et al., Angew. Chem. Int. Ed. 2005, 44, 5705-5709 genannt.

In einer bevorzugten Ausführungsform betrifft die vorliegende Erfindung ein Verfahren zur Herstellung der efindungsgemäßen cyclometallierten verbrückten Carbenkomplexe der allgemeinen Formel I, wobei die Herstellung den folgenden Schritt umfasst:

Umsetzung von mindestens einem Ligandvorläufer der allgemeinen Formel (III) 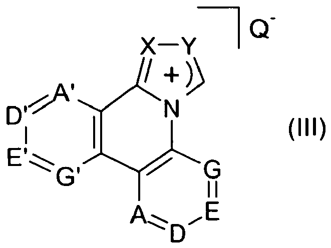 worin
- Q⁻: ein monoanionisches Gegenion, bevorzugt Halogenid, Pseudohalogenid, BF₄⁻, BPh₄⁻, PF₆⁻, AsF₆⁻ oder SbF₆⁻; bedeutet;
und
die weiteren Symbole in dem Ligandvorläufer der allgemeinen Formel II die folgenden Bedeutungen aufweisen:
- X: CR¹ oder N, bevorzugt N;
- Y: NR² oder CR²₂;
- A, D, G, E, A', D', G' oder E': unabhängig voneinander CH, CR³ oder N;
- R¹: F, CN, C₁-C₂₀-Alkoxy, C₆-C₃₀-Aryloxy, C₁-C₂₀-Alkylthio, C₆-C₃₀-Arylthio, substituiertes oder unsubstituiertes C₆-C₃₀-Aryl oder substituiertes oder unsubstituiertes Heteroaryl mit 5 bis 30 Ringatomen;
- R², R³: unabhängig voneinander substituiertes oder unsubstituiertes C₁-C₂₀-Alkyl, substituiertes oder unsubstituiertes C₅-C₂₀-Cycloalkyl, substituiertes oder unsubstituiertes C₅-C₂₀-Cycloalkenyl, substituiertes oder unsubstituiertes Heterocycloalkyl mit 5 bis 30 Ringatomen, substituiertes oder unsubstituiertes Heterocycloalkenyl mit 5 bis 30 Ringatomen, substituiertes oder unsubstituiertes C₂-C₂₀-Alkenyl, substituiertes oder unsubstituiertes C₂-C₂₀-Alkinyl substituiertes oder unsubstituiertes C₆-C₃₀-Aryl, substituiertes oder unsubstituiertes Heteroaryl mit 5 bis 30 Ringatomen oder ein Substituent mit Donor- oder Akzeptorwirkung ausgewählt aus der Gruppe bestehend aus: C₁-C₂₀-Alkoxy, C₆-C₃₀-Aryloxy, C₁-C₂₀-Alkylthio, C₆-C₃₀-Arylthio, SiR⁴R⁵R⁶, Halogenresten, halogenierten C₁-C₂₀-Alkylresten, Carbonyl (-CO(R⁴)), Carbonylthio (-C=O(SR⁴)), Carbonyloxy (-C=O(OR⁴)), Oxycarbonyl (-OC=O(R⁴)), Thiocarbonyl (-SC=O(R⁴)), Amino (-NR⁴R⁵), OH, Pseudohalogenresten, Amido (-C=O(NR⁴R⁵)), -NR⁴C=O(R⁵), Phosphonat (- P(O)(OR⁴)₂, Phosphat (-OP(O)(OR⁴)₂), Phosphin (-PR⁴R⁵), Phosphinoxid (-P(O)R⁴₂), Sulfat (-OS(O)₂OR⁴), Sulfoxid (-S(O)R⁴), Sulfonat (-S(O)₂OR⁴), Sulfonyl (-S(O)₂R⁴, Sulfonamid (-S(O)₂NR⁴R⁵), NO₂, Boronsäureestern (-B(OR⁴)₂), Imino (-C=NR⁴R⁵)), Boranresten, Stannatresten, Hydrazinresten, Hydrazonresten, Oximresten, Nitroso-Gruppen, Diazo-Gruppen, Vinylgruppen, Sulfoximinen, Alanen, Germanen, Boroxinen und Borazinen;
oder
zwei benachbarte Reste R³ bilden gemeinsam eine gesättigte oder ungesättigte substituierte oder unsubstituierte Brücke aus 3 bis 6 Atomen, so dass die Reste R³ gemeinsam mit einem der Elemente A=D, D-E, A'=D', D'-E', E'=G' einen 5- bis 8-gliedrigen Ring bilden;
oder
die Reste R³ an den Positionen G' und A bilden gemeinsam eine gesättigte oder ungesättigte substituierte oder unsubstituierte Brücke aus 1 bis 4 Atomen, so dass die Reste R³ gemeinsam mit dem Element -G'-C-C-A- einen 5- bis 8-gliedrigen Ring bilden;
und
- R⁴, R⁵, R⁶: unabhängig voneinander H, substituiertes oder unsubstituiertes C₁-C₂₀-Alkyl oder substituiertes oder unsubstituiertes C₆-C₃₀-Aryl oder substituiertes oder unsubstituiertes Heteroaryl mit 5 bis 30 Ringatomen;
mit einem Metallkomplex enthaltend mindestens ein Metall M, wobei M die folgenden Bedeutungen aufweist:
- M: Metallatom ausgewählt aus der Gruppe bestehend aus Metallen der Gruppe IB, IIB, IIIB, IVB, VB, VIB, VIIB, VIIIB, den Lanthaniden und IIIA des Periodensystems der Elemente (CAS-Version) in jeder für das entsprechende Metallatom möglichen Oxidationsstufe; bevorzugt Fe, Os, Co, Rh, Ir, Ni, Ru, Pd und Pt, Cu, Au, Ce, Tb, Eu, besonders bevorzugt Os, Ru, Rh, Ir und Pt und ganz besonders bevorzugt Ir, Os und Pt.

Besonders bevorzugte Reste, Gruppen und Indizes M, R², R³, R⁴, R⁵, R⁶, A, D, G, E, A', D', G', E', Y, M, K, L, n, m und o sind vorstehend genannt.

Gegebenenfalls erfolgt die erfindungsgemäße Umsetzung der Ligandvorläufer der Formel III mit dem Metallkomplex in Anwesenheit von geeigneten Ligandvorläufern der Liganden K und/oder L ("Eintopfverfahren"), falls m und/oder o in den Carbenkomplexen der Formel I nicht 0 bedeuten. Geeignete Ligandvorläufer der Liganden K und L sind dem Fachmann bekannt. Oder es erfolgt, falls m und/oder o nicht 0 bedeuten, eine sequentielle Umsetzung. Die sequentielle Umsetzung kann entweder durch Umsetzung des Metallkomplexes mit mindestens einem Carbenligandvorläufer der allgemeinen Formel III in einem ersten Schritt erfolgen, wobei zunächst als Zwischenstufe ein Carbenkomplex hergestellt wird, der mindestens einen Carbenliganden in cyclometallierter oder nicht-cyclometallierter Form aufweist und mindestens eine weitere Koordinationsmöglichkeit (wobei die weitere Koordinationsmöglichkeit entweder durch eine freie Koordinationsstelle am Metall M oder durch die Verdrängung anderer Liganden vorliegt) für mindestens einen weiteren bidentaten Liganden K und/oder oder L aufweist; oder durch Umsetzung des Metallkomplexes mit mindestens einem Ligandvorläufer für die Liganden K und/oder L in einem ersten Schritt, wobei zunächst als Zwischenstufe ein Komplex hergestellt wird, der mindestens einen Liganden K und/oder L und mindestens eine weitere Koordinationsmöglichkeit (wobei die weitere Koordinationsmöglichkeit entweder durch eine freie Koordinationsstelle am Metall M' oder durch die Verdrängung anderer Liganden vorliegt) für mindestens einen bidentaten Carbenliganden aufweist. In einem auf den ersten Schritt folgenden zweiten Schritt erfolgt eine Umsetzung des jeweiligen im ersten Schritt erhaltenen Komplexes mit mindestens einem Ligandvorläufer der Liganden K und/oder L (wenn im ersten Schritt mindestens ein Carbenligandvorläufer eingesetzt wurde) bzw. mit mindestens einem Carbenligandvorläufer der allgemeinen Formel III (wenn im ersten Schritt mindestens ein Ligandvorläufer der Liganden K und/oder L eingesetzt wurde).

In dem besonders bevorzugten Fall, dass das Metall M in den erfindungsgemäßen Carbenkomplexen der Formel I Ir(III) mit einer Koordinationszahl von 6 und n = 3 und m und o 0 sind, erfolgt eine Umsetzung mit einem oder verschiedenen Carbenligandvorläufern der Formel III. Werden verschiedene Carbenligandvorläufer der Formel III eingesetzt, kann die Umsetzung in Form einer "Eintopfreaktion" oder sequentiell - wie vorstehend anhand eines Carbenligandvorläufers und Ligandvorläufern für die Liganden K und L beschrieben - erfolgen. Bevorzugt sind die Carbenliganden in dem Carbenkomplex der Formel I identisch, so dass eine Umsetzung des Carbenligandvorläufers der Formel III mit einem geeigneten Metallkomplex erfolgt.

Für den ganz besonders bevorzugten Fall (M = Ir(III), n = 3) ist die Stöchiometrie Metall : Ligandvorläufer im Allgemeinen 1:3 bis 1:9, bevorzugt 1:3 bis 1:6.

Für den Fall, dass in den erfindungsgemäßen Carbenkomplexen der Formel I ein Carbenligand vorliegt und das Metallatom Ir(III) ist (M = Ir(III), n = 1) ist die Stöchiometrie Metall : Ligandvorläufer im Allgemeinen 1:1 bis 1:3, bevorzugt 1:1 bis 1:2.

Bei dem Metallkomplex enthaltend mindestens ein Metall M handelt es sich um einen Metallkomplex enthaltend mindestens ein Metall ausgewählt aus der Gruppe bestehend aus Metallen der Gruppe IB, IIB, IIIB, IVB, VB, VIB, VIIB, VIIIB, den Lanthaniden und IIIA des Periodensystems der Elemente (CAS-Version) in jeder für das entsprechende Metallatom möglichen Oxidationsstufe; bevorzugt Fe, Os, Co, Rh, Ir, Ni, Ru, Pd und Pt, Cu, Au, Ce, Tb, Eu, besonders bevorzugt Os, Ru, Rh, Ir und Pt und ganz besonders bevorzugt Ir, Os und Pt. Bevorzugt werden Pt(II), Os(II), Ir(I) oder Ir(III) in den in dem erfindungsgemäßen Verfahren eingesetzten Metallkomplexen eingesetzt, wobei Ir(I) und Ir(III) besonders bevorzugt sind und Ir(I) ganz besonders bevorzugt ist. Geeignete Metallkomplexe sind dem Fachmann bekannt. Beispiele für geeignete Metallkomplexe sind Pt(cod)Cl₂, Pt(cod)Me₂, Pt(acac)₂, Pt(PPh₃)₂Cl₂, PtCl₂, [Rh(cod)Cl]₂, Rh(acac)CO(PPh₃), Rh(acac)(CO)₂, Rh(cod)₂BF₄, RhCl(PPh₃)₃, RhCl₃ x n H₂O, Rh(acac)₃, [Os(CO)₃I₂]₂, [(Os₃(CO)₁₂], OsH₄(PPH₃)₃, CP₂OS, Cp*₂Os, H₂OsCl₆ x 6H₂O, OsCl₃ x H₂O), sowie [(µ-Cl)Ir(η⁴-1,5-cod)]₂, [(µ-Cl)Ir(η₂-coe)₂]₂, Ir(acac)₃, IrCl₃ x n H₂O, (tht)₃IrCl₃, Ir(η³-Allyl)₃, Ir(η³-Methallyl)3, worin cod Cyclooctadien, coe Cycloocten, acac Acetylacetonat und tht Tetrahydrothiophen bedeuten. Die Metallkomplexe können gemäß dem Fachmann bekannten Verfahren hergestellt werden bzw. sind kommerziell erhältlich.

Bei der Herstellung von Iridium(III)-Komplexen der allgemeinen Formel I (M in Formel I ist Ir), die gemäß der vorliegenden Anmeldung besonders bevorzugt sind, können die vorstehend genannten Iridium(I)- oder (III)-Komplexe eingesetzt werden, insbesondere [(µ-Cl)Ir(η⁴-1,5-cod)]₂, [(N-Cl)Ir(η²-coe)₂]₂, Ir(acac)₃, IrCl₃ x n H₂O, (tht)₃IrCl₃, Ir(η³-Allyl)₃, Ir(η³-Methallyl)₃, wobei [(µ-Cl)Ir(η⁴-1,5-cod)]₂ ganz besonders bevorzugt eingesetzt wird, worin cod Cyclooctadien, coe Cycloocten, acac Acetylacetonat und tht Tetrahydrothiophen bedeuten.

Besonders bevorzugt erfolgt die efindungsgemäße Umsetzung des Carbenligandvorläufers der Formel III mit dem geeigneten Metallkomplex in Anwesenheit einer Base und eines Hilfsreagenzes oder eines basischen Hilfsreagenzes, wobei das basische Hilfsreagenz bzw. das Hilfsreagenz mindestens ein Metall ausgewählt aus der Gruppe bestehend aus Ag, Hg, Sb, Mg, B und Al enthalten, bevorzugt erfolgt die erfindungsgemäße Umsetzung in Anwesenheit von Ag₂O. Ein geeignetes Verfahren, das entsprechend für die Herstellung der erfindungsgemäßen Carbenkomplexe der Formel I angewandt werden kann, ist zum Beispiel in WO 2007/088093 offenbart.

Im dem Fall, wenn Y NR² bedeutet, erfolgt die Herstellung der geeigneten Ligandvorläufer der Formel III z.B. ausgehend von Ligandvorläufern der Formel IVa durch Alkylierung, z.B. durch Methylierung mit Mel oder Me₃OBF₄ oder ausgehend von Ligandvorläufern der Formel IVb durch Cyclisierung, z.B. mit CH(OEt)₃. 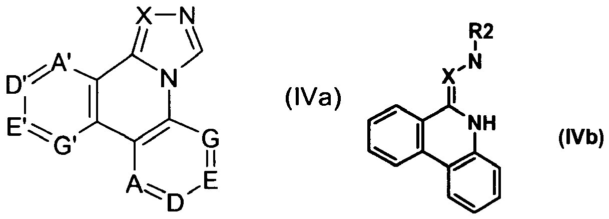 worin die Symbole die vorstehend genannten Bedeutungen aufweisen.

Es sind auch andere Verfahren zur Herstellung der Ligandvorläufer der Formel III, worin Y NR² bedeutet, möglich, wie nachstehend beispielhaft gezeigt ist.

Die Verbindungen der Formeln IVa und IVb können gemäß dem Fachmann bekannten Verfahren hergestellt werden, wobei geeignete Verfahren in der nachstehend genannten Literatur erwähnt sind.

Im Folgenden sind beispielhaft Herstellungsverfahren zur Herstellung von ganz besonders bevorzugten erfindungsgemäßen Carbenkomplexen der Formel I dargestellt, wobei die unten stehenden Beispiele die Herstellung geeigneter Verbindungen der Formeln IVa und IVb sowie die Herstellung geeigneter Ligandvorläufer der Formel III ausgehend von kommerziell erhältlichen bzw. nach dem Fachmann bekannten Verfahren herstellbaren Verbindungen umfassen. Die in den nachstehenden Beispielen genannten Verbindungen sind beispielhaft und können entsprechend dem Substitutionsmuster der Verbindungen der Formel I substituiert sein und/oder in ihren Ringsystemen entsprechend den Verbindungen der Formel I Heteroatome aufweisen.

Synthese eines Triazolophenanthridin-basierten Komplexes **2 - Alkyl** aus 1,2,4-Triazolo[4,3-f]-phenanthridin (A.G. Mikhailovskii, V.S. Shklyaev, Chem. Heterocycl. Comp. 1992, 445):

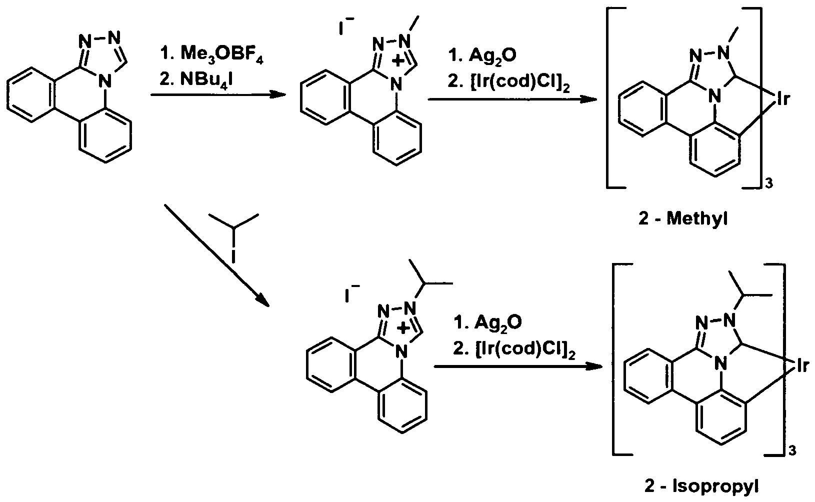

Synthese von Triazolophenanthridin-basierten Komplexen **2 - Aryl** aus 6-Chlorphenanthridin (A.G. Mikhailovskii, V.S. Shklyaev, Chem. Heterocycl. Comp. 1992, 445):

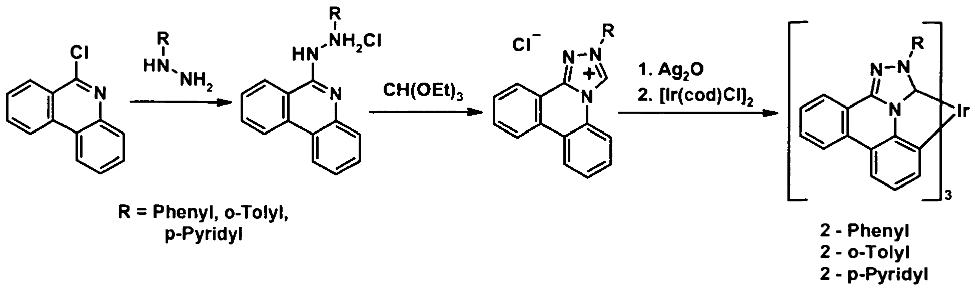

Im Anschluss an die Umsetzung wird der erfindungsgemäße cyclometallierte verbrückte Carbenkomplex der Formel I nach dem Fachmann bekannten Verfahren aufgearbeitet und ggf. gereinigt. Üblicherweise erfolgen die Aufarbeitung und Reinigung durch Extraktion, Säulenchromatographie und/oder Umkristallisation gemäß dem Fachmann bekannten Verfahren.

Die erfindungsgemäßen cyclometallierten verbrückten Carbenkomplexe der Formel I eignen sich hervorragend als phosphoreszierende Emittersubstanzen, da sie eine Emission (Elektrolumineszenz) im sichtbaren Bereich des elektromagnetischen Spektrums, bevorzugt im blauen Bereich des elektromagnetischen Spektrums, aufweisen. Mit Hilfe der erfindungsgemäßen Carbenkomplexe der Formel I als Emittersubstanzen ist es möglich, Verbindungen bereit zu stellen, die Elektrolumineszenz guter Effizienz zeigen, wobei sich die erfindungsgemäßen Carbenkomplexe durch eine gute Stabilität im Device auszeichnen. Dabei ist die Quantenausbeute hoch.

Des Weiteren sind die erfindungsgemäßen Carbenkomplexe der Formel 1 als Elektronen-, Excitonen- oder Lochblocker oder Lochleiter, Elektronenleiter, Lochinjektionsschicht oder Matrixmaterial in OLEDs geeignet, im Allgemeinen in Abhängigkeit von den eingesetzten Liganden und dem eingesetzten Zentralmetall.

Ein weiterer Gegenstand der vorliegenden Erfindung ist daher die Verwendung der erfindungsgemäßen cyclometallierten verbrückten Carbenkomplexe der Formel I in organischen Leuchtdioden, bevorzugt als Emittermaterial, Matrixmaterial, Ladungsblockermaterial und/oder Ladungstransportmaterial, besonders bevorzugt als Emittermaterial, ganz besonders bevorzugt als Blauemitter.

Organische Licht-emittierende Dioden (OLEDs) sind grundsätzlich aus mehreren Schichten aufgebaut, z.B.:
1. Anode (1)
2. Löcher-transportierende Schicht (2)
3. Licht-emittierende Schicht (3)
4. Elektronen-transportierende Schicht (4)
5. Kathode (5)

Es ist jedoch auch möglich, dass das OLED nicht alle der genannten Schichten aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Die erfindungsgemäßen cyclometallierten verbrückten Carbenkomplexe der Formel I können in verschiedenen Schichten eines OLEDs eingesetzt werden. Dabei kann ein Carbenkomplex der Formel I in einer Schicht einer OLED eingesetzt werden, es ist jedoch ebenfalls möglich, dass zwei oder mehr verschiedene Carbenkomplexe der Formel I in einer oder mehreren Schichten der OLED eingesetzt werden. Z.B. kann sowohl das Emittermaterial als auch das Matrixmaterial in der Licht emittierenden Schicht der OLED einen Carbenkomplex der Formel 1 aufweisen, wobei der als Emittermaterial und der als Matrixmaterial eingesetzte Carbenkomplex der Formel I im Allgemeinen verschieden sind. Es ist ebenfalls möglich, dass das Emittermaterial und das Lochleitermaterial einen Carbenkomplex der Formel I aufweisen, wobei die Carbenkomplexe der Formel I im Allgemeinen verschieden sind. Weitere Kombinationen verschiedener Carbenkomplexe sind möglich und für den Fachmann zu ermitteln. Ein weiterer Gegenstand der vorliegenden Erfindung ist daher eine OLED enthaltend mindestens einen erfindungsgemäßen cyclometallierten verbrückten Carbenkomplex der Formel I. Die erfindungsgemäßen cyclometallierten verbrückten Carbenkomplexe der Formel I werden bevorzugt in der Licht-emittierenden Schicht, z.B. als Matrixmoleküle oder Emittermoleküle, besonders bevorzugt als Emittermoleküle, eingesetzt. Ein weiterer Gegenstand der vorliegenden Erfindung ist daher eine Licht-emittierende Schicht enthaltend mindestens einen erfindungsgemäßen cyclometallierten verbrückten Carbenkomplex der Formel I, bevorzugt als Emittermolekül. Bevorzugte erfindungsgemäße cyclometallierte verbrückte Carbenkomplexe der Formel I sind vorstehend genannt.

Die erfindungsgemäßen cyclometallierten verbrückten Carbenkomplexe der Formel I können in Substanz - ohne weitere Zusätze - in der Licht-emittierenden Schicht oder einer anderen Schicht des OLEDs, bevorzugt in der Licht-emittierenden Schicht, vorliegen. Es ist jedoch ebenfalls möglich und bevorzugt, dass neben den erfindungsgemäßen cyclometallierten verbrückten Carbenkomplexen der Formel I weitere Verbindungen in den Schichten enthaltend mindestens einen erfindungsgemäßen cyclometallierten verbrückten Carbenkomplex der Formel I, bevorzugt in der Licht-emittierenden Schicht, vorliegen. Beispielsweise kann in der Licht-emittierenden Schicht ein fluoreszierender Farbstoff anwesend sein, um die Emissionsfarbe des als Emittermoleküls eingesetzten erfindungsgemäßen cyclometallierten verbrückten Carbenkomplexes der Formel I zu verändern. Des Weiteren kann - in einer bevorzugten Ausführungsform - ein Verdünnungsmaterial eingesetzt werden. Dieses Verdünnungsmaterial kann ein Polymer sein, zum Beispiel Poly(N-vinylcarbazol) oder Polysilan. Das Verdünnungsmaterial kann jedoch ebenfalls ein kleines Molekül sein, zum Beispiel 4,4'-N, N'-Dicarbazolbiphenyl (CDP=CBP) oder tertiäre aromatische Amine. Des Weiteren kann der Carbenkomplex der Formel I in der Licht emittierenden Schicht gemeinsam mit einem Matrixmaterial eingesetzt werden, wobei geeignete Matrixmaterialien nachstehend genannt sind. Der Einsatz der erfindungsgemäßen Carbenkomplexe der Formel I als Matrixmaterial (gemeinsam mit dem Einsatz der Carbenkomplexe der Formel I als Emittermaterial (wobei die als Matrix- und Emittermaterial eingesetzten Carbenkomplexe im Allgemeinen verschieden sind) wurde bereits vorstehend erwähnt.

Die einzelnen der vorstehend genannten Schichten des OLEDs können wiederum aus 2 oder mehreren Schichten aufgebaut sein. Beispielsweise kann die Löcher-transportierende Schicht aus einer Schicht aufgebaut sein, in die aus der Elektrode Löcher injiziert werden und einer Schicht, die die Löcher von der Lochinjektionsschicht weg in die Licht-emittierende Schicht transportiert. Die Elektronen-transportierende Schicht kann ebenfalls aus mehreren Schichten bestehen, zum Beispiel einer Schicht, worin Elektronen durch die Elektrode injiziert werden, und einer Schicht, die aus der Elektroneninjektionsschicht Elektronen erhält und in die Licht-emittierende Schicht transportiert. Der Fachmann ist in der Lage, den Aufbau der OLEDs so zu wählen, dass er optimal an die erfindungsgemäß, bevorzugt als Emittersubstanzen, verwendeten erfindungsgemäßen Carbenkomplexe der Formel I angepasst ist.

Um besonders effiziente OLEDs zu erhalten, sollte das HOMO (höchstes besetztes Molekülorbital) der Loch-transportierenden Schicht mit der Arbeitsfunktion der Anode angeglichen sein und das LUMO (niedrigstes unbesetztes Molekülorbital) der elektronentransportierenden Schicht sollte mit der Arbeitsfunktion der Kathode angeglichen sein.

Ein weiterer Gegenstand der vorliegende Anmeldung ist ein OLED enthaltend mindestens eine erfindungsgemäße Licht-emittierende Schicht. Die weiteren Schichten in dem OLED können aus einem beliebigen Material aufgebaut sein, das üblicherweise in solchen Schichten eingesetzt wird und dem Fachmann bekannt ist.

Geeignete Materialien für die vorstehend genannten Schichten (Anode, Kathode, Loch- und Elektroneninjektionsmaterialien, Loch- und Elektronentransportmaterialien und Loch- und Elektronenblockermaterialien, Matrixmaterialien, Fluoreszenz- und Phosphoreszenzemitter) sind dem Fachmann bekannt und z.B. in H. Meng, N. Herron, Organic Small Molecule Materials for Organic Light-Emitting Devices in Organic Light-Emitting Materials and Devices, Ed.: Z. Li, H. Meng, Taylor & Francis, 2007, Chapter 3, Seiten 295 bis 411 genannt.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen 11, 4, 5 und 6 des Periodensystems der Elemente sowie die Übergangsmetalle der Gruppen 8 bis 10. Wenn die Anode lichtdurchlässig sein soll, werden im Allgemeinen gemischte Metalloxide der Gruppen 12, 13 und 14 des Periodensystems der Elemente eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) des erfindungsgemäßen OLEDs sind zum Beispiel in Kirk-Othmer Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl (α-NPD), N, N'-Diphenyl-N, N'-Bis(3-methylphenyl)-[1,1'-biphenyl]-4,4'-diamin (TPD), 1,1-Bis[(di-4-tolylamino)phenyl]cyclohexan (TAPC), N, N'-Bis(4-methylphenyl)-N, N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methylphenyl)methan (MPMP), 1-Phenyl-3-[p-(diethylamino)styryl]-5-[p-(diethylamino)-phenyl]pyrazolin (PPR oder DEASP), 1,2-trans-Bis(9H-carbazol-9-yl)cyclobutan (DCZB), N,N,N',N'-tetrakis(4-methylphenyl)-(1,1'-biphenyl)-4,4'-diamin (TTB), 4,4',4"-tris(N,N-Diphenylamino)triphenylamin (TDTA), 4,4',4"-Tris(N-3-methylphenyl-N-phenyl-amino)-triphenylamin (m-MTDATA), 2,2,7,7-tetrakis-(diphenylamino)-9,9-spirobifluoren (Spiro-TAD), 4,4',4"-Tris(carbazol-9-yl)-triphenylamin (TCTA) und Porphyrinverbindungen sowie Phthalocyaninen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen, PEDOT (Poly(3,4-ethylendioxythiophen), bevorzugt PEDOT dotiert mit PSS (Polystyrolsulfonat), und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Geeignete Elektronentransportmaterialien für die Schicht (4) der erfindungsgemäßen OLEDs umfassen mit oxinoiden Verbindungen chelatisierte Metalle wie Tris(8-hydroxychinolato)aluminium (Alq₃) oder Bis(2-methyl-8-quinolato)-(p-phenylphenolato)aluminum (BAlq), Verbindungen auf Phenanthrolinbasis wie 2,9-Dimethyl, 4,7-Diphenyl-1, 10-phenanthrolin (DDPA = BCP) oder 4,7-Diphenyl-1, 10-phenanthrolin (BPhen) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ), 1,3-bis(4-tert-butylphenyl-1,3,4-oxadiazoyl)phenylen (OXD7), 2,2',2"-(1,3,5-Benzoltriyl)-tris(1-phenylbenzimidazol) (TPBI). Dabei kann die Schicht (4) sowohl zur Erleichterung des Elektronentransports dienen als auch als Pufferschicht oder als Sperrschicht, um ein Quenchen des Excitons an den Grenzflächen der Schichten des OLEDs zu vermeiden. Vorzugsweise verbessert die Schicht (4) die Beweglichkeit der Elektronen und reduziert ein Quenchen des Excitons.

Von den vorstehend als Lochtransportmaterialien und Elektronen transportierende Materialien genannten Materialien können einige mehrere Funktionen erfüllen. Zum Beispiel sind einige der Elektronen leitenden Materialien gleichzeitig Löcher blockende Materialien, wenn sie ein tief liegendes HOMO aufweisen.

Die Ladungstransportschichten können auch elektronisch dotiert sein, um die Transporteigenschaften der eingesetzten Materialien zu verbessern, um einerseits die Schichtdicken großzügiger zu gestalten (Vermeidung von Pinholes/Kurzschlüssen) und um andererseits die Betriebsspannung des Devices zu minimieren. Beispielsweise können die Lochtransportmaterialien mit Elektronenakzeptoren dotiert werden, zum Beispiel können Phthalocyanine bzw. Arylamine wie TPD oder TDTA mit Tetrafluorotetracyanochinodimethan (F4-TCNQ) dotiert werden. Die Elektronentransportmaterialien können zum Beispiel mit Alkalimetallen dotiert werden, beispielsweise Alq₃ mit Lithium. Die elektronische Dotierung ist dem Fachmann bekannt und zum Beipsiel in W. Gao, A. Kahn, J. Appl. Phys., Vol. 94, No. 1, 1 July 2003 (p-dotierte organische Schichten); A. G. Werner, F. Li, K. Harada, M. Pfeiffer, T. Fritz, K. Leo, Appl. Phys. Lett., Vol. 82, No. 25, 23 June 2003 und Pfeiffer et al., Organic Electronics 2003, 4, 89 - 103 und K. Walzer, B. Maennig, M. Pfeiffer, K. Leo, Chem. Soc. Rev. 2007, 107, 1233 offenbart.

Als Matrixmaterialien sind grundsätzlich die als Loch- und Elektronentransportmaterialien genannten Materialien sowie Carbenkomplexe, z.B. die Carbenkomplexe der Formel I oder die in WO 2005/019373 genannten Carbenkomplexe, geeignet. Besonders geeignet sind Carbazolderivate, z.B. 4,4'-Bis(carbazol-9-yl)-2,2'-dimethyl-biphenyl (CDBP), 4,4'-Bis(carbazol-9-yl)-biphenyl (CBP), 1,3-Bis(N-carbazolyl)benzol (mCP), sowie die in den nicht vorveröffentlichten Anmeldungen mit den folgenden Aktenzeichen genannten Matrixmaterialien: PCT/EP2007/059648, EP 07 111 824.4.

In dem Fall, wenn in der Licht-emittierenden Schicht der erfindungsgemäßen OLED mindestens Emittermaterial gemeinsam mit mindestens einem Matrixmaterial eingesetzt werden, der Anteil des mindestens einen Matrixmaterials in der Licht-emittierenden Schicht der erfindungsgemäßen OLED im Allgemeinen 10 bis 99 Gew.-%, bevorzugt 50 bis 99 Gew.-%, besonders bevorzugt 70 bis 97 Gew.-%. Der Anteil des mindestens einen Emitter-Materials in der Licht-emittierenden Schicht beträgt im Allgemeinen 1 bis 90 Gew.-%, bevorzugt 1 bis 50 Gew.-%, besonders bevorzugt 3 bis 30 Gew.-%, wobei die Anteile an dem mindestens einen Matrixmaterial und dem mindestens einen Emittermaterial 100 Gew.-% ergeben. Es ist jedoch auch möglich, dass die Licht-emittierende Schicht neben dem mindestens einen Matrixmaterial und dem mindestens einen Emittermaterial weitere Substanzen enthält, z. B. weiteres Verdünnungsmaterial, wobei weiteres Verdünnungsmaterial vorstehend genannt wurde.

Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe 1, zum Beispiel Li, Cs, Erdalkalimetallen der Gruppe 2, Metallen der Gruppe 12 des Periodensystems der Elemente, umfassend die Seltenerdmetalle und die Lanthanide und Aktinide. Des Weiteren können Metalle wie Aluminium, Indium, Calcium, Barium, Samarium und Magnesium sowie Kombinationen davon eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Das OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält das erfindungsgemäße OLED zusätzlich zu den Schichten (1) bis (5) mindestens eine der im Folgenden genannten weiteren Schichten:
- eine Loch-Injektionsschicht zwischen der Anode (1) und der Löcher-transportierenden Schicht (2);
- eine Blockschicht für Elektronen und/oder Excitonen zwischen der Löcher-transportierenden Schicht (2) und der Licht-emittierenden Schicht (3);
- eine Blockschicht für Löcher und/oder Excitonen zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Wie bereits vorstehend erwähnt, ist es jedoch auch möglich, dass das OLED nicht alle der genannten Schichten (1) bis (5) aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Dem Fachmann ist bekannt, wie er (zum Beispiel auf Basis von elektrochemischen Untersuchungen) geeignete Materialien auswählen muss. Geeignete Materialien für die einzelnen Schichten sowie geeignete OLED-Aufbauten sind dem Fachmann bekannt und z.B. in W02005/113704 offenbart.

Des Weiteren kann jede der genannten Schichten des erfindungsgemäßen OLEDs aus zwei oder mehreren Schichten aufgebaut sein. Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, ein OLED mit einer hohen Effizienz zu erhalten.

Die Herstellung des erfindungsgemäßen OLEDs kann nach dem Fachmann bekannten Methoden erfolgen. Im Allgemeinen wird das OLED durch aufeinander folgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden. Zusammensetzungen, die neben dem mindestens einen efindungsgemäßen cyclometallierten verbrückten Carbenkomplex der Formel I ein polymeres Material in einer der Schichten des OLEDs, bevorzugt in der Licht-emittierenden Schicht, aufweisen, werden im Allgemeinen mittels lösungsverarbeitenden Verfahren als Schicht aufgebracht.

Im Allgemeinen haben die verschiedenen Schichten folgende Dicken: Anode (2) 500 bis 5000 Å, bevorzugt 1000 bis 2000 Ä; Löcher-transportierende Schicht (3) 50 bis 1000 Å, bevorzugt 200 bis 800 Å, Licht-emittierende Schicht (4) 10 bis 1000 Å, bevorzugt 100 bis 800 Å, Elektronen transportierende Schicht (5) 50 bis 1000 Å, bevorzugt 200 bis 800 Å, Kathode (7) 200 bis 10.000 Å, bevorzugt 300 bis 5000 Å. Die Lage der Rekombinationszone von Löchern und Elektronen in dem erfindungsgemäßen OLED und somit das Emissionsspektrum des OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in dem OLED ist von den eingesetzten Materialien abhängig. Die Schichtdicken von gegebenenfalls eingesetzten zusätzlichen Schichten sind dem Fachmann bekannt.

Durch Einsatz der erfindungsgemäßen cyclometallierten verbrückten Carbenkomplexe der Formel I in mindestens einer Schicht des erfindungsgemäßen OLEDs, bevorzugt als Emittermolekül in der Licht-emittierenden Schicht der erfindungsgemäßen OLEDs, können OLEDs mit hoher Effizienz und langer Lebensdauer erhalten werden. Die Effizienz der erfindungsgemäßen OLEDs kann des Weiteren durch Optimierung der anderen Schichten verbessert werden. Beispielsweise können hoch effiziente Kathoden wie Ca, Ba oder LiF eingesetzt werden. Geformte Substrate und neue Löcher-transportierende Materialien, die eine Reduktion der Operationsspannung oder eine Erhöhung der externen Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen sowie Beleuchtungsmitteln. Stationäre Bildschirme sind z.B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Digitalkameras, Fahrzeugen sowie Zielanzeigen an Bussen und Bahnen. Beleuchtungsmittel sind zum Beispiel Hintergrundbeleuchtungen von LCDs, Leuchtflächen, z.B. leuchtende Tapeten.

Die erfindungsgemäßen cyclometallierten Carbenkomplexe der Formel I, insbesondere die in der vorliegenden Anmeldung genannten bevorzugten und besonders bevorzugten Auführungsformen der erfindungsgemäßen cyclometallierten Carbenkomplexe der Formel I können in einer bevorzugten Ausführungsform in einer OLED eingesetzt werden, wie sie in der nicht vorveröffentlichten Anmeldung mit dem Aktenzeichen PCT/EP2008/058106 beschrieben ist, wobei der erfindungsgemäße cyclometallierte Carbenkomplex der Formel I bevorzugt den in PCT/EP2008/058106 genannten in der Licht-emittierenden Schicht vorliegenden Carbenkomplex der allgemeinen Formel I ersetzt. Die erfindungsgemäßen cyclometallierten Carbenkomplexe können in der OLED gemäß PCT/EP2008/058106 als phosphoreszierende Emittersubstanzen eingesetzt werden. Es ist jedoch des Weiteren möglich, dass die erfindungsgemäßen cyclometallierten Carbenkomplexe der Formel I in Abhängigkeit von dem eingesetzten Zentralmetall und den eingesetzten Liganden sowie von den weiteren in der OLED verwendeten Materialien als Elektronen-, Excitonen- oder Lochblocker oder Lochleiter, Elektronenleiter, Lochinjektionsschicht oder Matrixmaterial (insbesondere als Matrixmaterial in der Licht-emittierenden Schicht) eingesetzt werden.

Weiterhin können die erfindungsgemäßen cyclometallierten verbrückten Carbenkomplexe der Formel I in OLEDs mit inverser Struktur eingesetzt werden. Bevorzugt werden die erfindungsgemäßen cyclometallierten verbrückten Carbenkomplexe der Formel I in diesen inversen OLEDs wiederum in der Licht-emittierenden Schicht eingesetzt. Der Aufbau von inversen OLEDs und die üblicherweise darin eingesetzten Materialien sind dem Fachmann bekannt.

Die vorstehend beschriebenen erfindungsgemäßen cyclometallierten verbrückten Carbenkomplexe der Formel I können neben dem Einsatz in OLEDs als Färbemittel eingesetzt werden, die bei Einstrahlung von Licht im sichtbaren Bereich des elektromagnetischen Spektrums emittieren (Photolumineszenz).

Ein weiterer Gegenstand der vorliegenden Anmeldung ist daher die Verwendung der vorstehend beschriebenen erfindungsgemäßen cyclometallierten verbrückten Carbenkomplexe der Formel I zur Massenfärbung polymerer Materialien.

Geeignete polymere Materialien sind Polyvinylchlorid, Celluloseacetat, Polycarbonate, Polyamide, Polyurethane, Polyimide, Polybenzimidazole, Melaminharze, Silikone, Polyester, Polyether, Polystyrol, Polymethylmethacrylat, Polyethylen, Polypropylen, Polyvinylacetat, Polyacrylnitril, Polybutadien, Polychlorbutadien, Polyisopren bzw. die Copolymere der aufgeführten Monomere.

Des Weiteren können die vorstehend beschriebenen erfindungsgemäßen cyclometallierten verbrückten Carbenkomplexe der Formel I in den folgenden Anwendungen eingesetzt werden:
- Anwendung der erfindungsgemäßen cyclometallierten verbrückten Carbenkomplexe der Formel I als oder in Küpenfarbstoffe(n), zum Beispiel zur Färbung von Naturstoffen, Beispiele sind Papier, Holz, Stroh, Leder, Felle oder natürliche Fasermaterialien wie Baumwolle, Wolle, Seide, Jute, Sisal, Hanf, Flachs oder Tierhaare (zum Beispiel Rosshaar) und deren Umwandlungsprodukte wie zum Beispiel die Viskosefaser, Nitratseide oder Kupferrayon (Reyon)
- Anwendung der efindungsgemäßen cyclometallierten verbrückten Carbenkomplexe der Formel I als Farbmittel, zum Beispiel zur Färbung von Farben, Lacken und anderen Anstrichstoffen, Papierfarben, Druckfarben, Tinten und andere Farben für Mal- und Schreib-Zwecke.
- Anwendung der erfindungsgemäßen cyclometallierten verbrückten Carbenkomplexe der Formel I als Pigmentfarbstoffe, zum Beispiel zur Färbung von Farben, Lacken und anderen Anstrichsstoffen, Papierfarben, Druckfarben, Tinten und andere Farben für Mal- und Schreib-Zwecke.
- Anwendung der erfindungsgemäßen cyclometallierten verbrückten Carbenkomplexe der Formel I als Pigmente in der Elektrophotographie: zum Beispiel für Trockenkopiersysteme (Xerox-Verfahren) und Laserdrucker.
- Anwendung der erfindungsgemäßen cyclometallierten verbrückten Carbenkomplexe der Formel I für Sicherheitsmarkierungs-Zwecke, wobei die große chemische und photochemische Beständigkeit und gegebenenfalls auch die Lumineszenz der Substanzen von Bedeutung ist. Bevorzugt ist dies für Schecks, Scheckkarten, Geldscheine Coupons, Dokumente, Ausweispapiere und dergleichen, bei denen ein besonderer, unverkennbarer Farbeindruck erzielt werden soll.
- Anwendung der erfindungsgemäßen cyclometallierten verbrückten Carbenkomplexe der Formel I als Zusatz zu anderen Farben, bei denen eine bestimmte Farbnuance erzielt werden soll, bevorzugt sind besonders leuchtende Farbtöne.
- Anwendung der erfindungsgemäßen cyclometallierten verbrückten Carbenkomplexe der Formel I zum Markieren von Gegenständen zum maschinellen Erkennen dieser Gegenstände über die Lumineszenz, bevorzugt ist die maschinelle Erkennung von Gegenständen zum Sortieren, zum Beispiel auch für das Recycling von Kunststoffen.
- Anwendung der erfindungsgemäßen cyclometallierten verbrückten Carbenkomplexe der Formel I als Lumineszenzfarbstoffe für maschinenlesbare Markierungen, bevorzugt sind alphanumerische Aufdrucke oder Barcodes.
- Anwendung der erfindungsgemäßen cyclometallierten verbrückten Carbenkomplexe der Formel I zur Frequenzumsetzung von Licht, zum Beispiel um aus kurzwelligem Licht längerwelliges, sichtbares Licht zu machen.
- Anwendung der erfindungsgemäßen cyclometallierten verbrückten Carbenkomplexe der Formel I in Anzeigeelementen für vielerlei Anzeige-, Hinweis- und Markierungszwecke, zum Beispiel in passiven Anzeigeelementen, Hinweis- und Verkehrszeichen, wie Ampeln.
- Anwendung der erfindungsgemäßen cyclometallierten verbrückten Carbenkomplexe der Formel I in Tintenstrahldruckern, bevorzugt in homogener Lösung als lumineszierende Tinte.
- Anwendung der erfindungsgemäßen cyclometallierten verbrückten Carbenkomplexe der Formel I als Ausgangsmaterial für supraleitende organische Materialien.
- Anwendung der erfindungsgemäßen cyclometallierten verbrückten Carbenkomplexe der Formel I für Feststoff-Lumineszenz-Markierungen.
- Anwendung der erfindungsgemäßen cyclometallierten verbrückten Carbenkomplexe der Formel I für dekorative Zwecke.
- Anwendung der erfindungsgemäßen cyclometallierten verbrückten Carbenkomplexe der Formel I zu Tracer-Zwecken, zum Beispiel in der Biochemie, Medizin, Technik und Naturwissenschaft. Hierbei können die Farbstoffe kovalent mit Substraten verknüpft sein oder über Nebenvalenzen wie Wasserstoffbrückenbindungen oder hydrophobe Wechselwirkungen (Adsorption).
- Anwendung der erfindungsgemäßen cyclometallierten verbrückten Carbenkomplexe der Formel I als Lumineszenzfarbstoffe in hochempfindlichen Nachweisverfahren (siehe C. Aubert, J. Fünfschilling, I. Zschocke-Gränacher und H. Langhals, Z. Analyt. Chem. 320 (1985) 361).
- Anwendung der erfindungsgemäßen cyclometallierten verbrückten Carbenkomplexe der Formel I als Lumineszenzfarbstoffe in Szintillatoren.
- Anwendung der erfindungsgemäßen cyclometallierten verbrückten Carbenkomplexe der Formel alls Farbstoffe oder Lumineszenzfarbstoffe in optischen Lichtsammelsystemen.
- Anwendung der erfindungsgemäßen cyclometallierten verbrückten Carbenkomplexe der Formel I als Farbstoffe oder Lumineszenzfarbstoffe in Lumineszenz-Solarkollektoren (siehe Langhals, Nachr. Chem. Tech. Lab. 28 (1980) 716).
- Anwendung der erfindungsgemäßen cyclometallierten verbrückten Carbenkomplexe der Formel I als Farbstoffe oder Lumineszenzfarbstoffe in Lumineszenz-aktivierten Displays (siehe W. Greubel und G. Baur, Elektronik 26 (1977) 6).
- Anwendung der erfindungsgemäßen cyclometallierten verbrückten Carbenkomplexe der Formel I als Farbstoffe oder Lumineszenzfarbstoffe in Kaltlichtquellen zur lichtinduzierten Polymerisation zur Darstellung von Kunststoffen.
- Anwendung der erfindungsgemäßen cyclometallierten verbrückten Carbenkomplexe der Formel I als Farbstoffe oder Lumineszenzfarbstoffe zur Materialprüfung, zum Beispiel bei der Herstellung von Halbleiterschaltungen.
- Anwendung der erfindungsgemäßen cyclometallierten verbrückten Carbenkomplexe der Formel I als Farbstoffe oder Lumineszenzfarbstoffe zur Untersuchung von Mikrostrukturen von integrierten Halbleiterbauteilen.
- Anwendung der erfindungsgemäßen cyclometallierten verbrückten Carbenkomplexe der Formel alls Farbstoffe oder Lumineszenzfarbstoffe in Photoleitern.
- Anwendung der erfindungsgemäßen cyclometallierten verbrückten Carbenkomplexe der Formel I als Farbstoffe oder Lumineszenzfarbstoffe in fotografischen Verfahren.
- Anwendung der erfindungsgemäßen cyclometallierten verbrückten Carbenkomplexe der Formel I als Farbstoffe oder Lumineszenzfarbstoffe in Anzeige-, Beleuchtungs- oder Bildwandlersystemen, bei denen die Anregung durch Elektronen, Ionen oder UV-Strahlung erfolgt, zum Beispiel in Lumineszenzanzeigen, Braunschen Röhren oder in Leuchtstoffröhren.
- Anwendung der erfindungsgemäßen cyclometallierten verbrückten Carbenkomplexe der Formel I als Farbstoffe oder Lumineszenzfarbstoffe als Teil einer integrierten Halbleiterschaltung, die Farbstoffe als solche oder in Verbindung mit anderen Halbleitern zum Beispiel in Form einer Epitaxie.
- Anwendung der erfindungsgemäßen cyclometallierten verbrückten Carbenkomplexe der Formel I als Farbstoffe oder Lumineszenzfarbstoffe in Chemilumineszenzsystemen, zum Beispiel in Chemilumineszenz-Leuchtstäben, in Lumineszenzimmunessays oder anderen Lumineszenznachweisverfahren.
- Anwendung der erfindungsgemäßen cyclometallierten verbrückten Carbenkomplexe der Formel I als Farbstoffe oder Lumineszenzfarbstoffe als Signalfarben, bevorzugt zum optischen Hervorheben von Schriftzügen und Zeichnungen oder anderen graphischen Produkten, zum Kennzeichnen von Schildern und anderen Gegenständen, bei denen ein besonderer optischer Farbeindruck erreicht werden soll.
- Anwendung der efindungsgemäßen cyclometallierten verbrückten Carbenkomplexe der Formel I als Farbstoffe oder Lumineszenzfarbstoffe in Farbstoff-Lasern, bevorzugt als Lumineszenzfarbstoffe zur Erzeugung von Laserstrahlen.
- Anwendung der erfindungsgemäßen cyclometallierten verbrückten Carbenkomplexe der Formel I als aktive Substanzen für eine nichtlineare Optik, zum Beispiel für die Frequenzverdopplung und die Frequenzverdreifachung von Laserlicht.
- Anwendung der erfindungsgemäßen cyclometallierten verbrückten Carbenkomplexe der Formel I als Rheologieverbesserer.
- Anwendung der erfindungsgemäßen cyclometallierten verbrückten Carbenkomplexe der Formel I als Farbstoffe in photovoltaischen Anordnungen zur Umwandlung elektromagnetischer Strahlung in elektrische Energie.

Die nachfolgenden Beispiele erläutern die Erfindung zusätzlich.

### Beispiele

### I) Synthesevorschriften

### Komplexe mit Triazolophenantridin-Liganden

### Synthese von 2 - Methyl

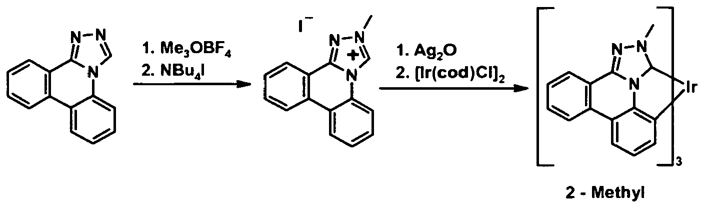

### 1-Methyl-1,2,4-triazolo[4,3-f]phenanthridinium-tetrafluoroborat

Eine Lösung von 1,2,4-Triazolo[4,3-f]phenanthridin (A.G. Mikhailovskii, V.S. Shklyaev, Chem. Heterocycl. Comp. 1992, 445) (5.9 g, 27 mmol) in Dichlormethan (200 mL) und Methanol (20 mL) wird unter Argon bei 2 °C mit Trimethyloxonium-tetrafluoroborat (4.3 g, 29 mmol) versetzt und 1 h bei 2 °C sowie 16 h bei Raumtemperatur gerührt. Der entstandene Niederschlag wird abfiltriert und mit Dichlormethan, Methanol und Petrolether gewaschen. Ausbeute: 5.9 g (69%).

¹H-NMR (d₆-DMSO, 400 MHz): δ = 4.39 (s, 3H), 7.84-7.98 (m, 3H), 8.04 (td, 1H), 8.41 (dd, 1H), 8.54 (dd, 1H), 8.83 (dd, 1H), 8.86 (dd, 1H), 11.47 (s, 1H).

### 1-Methyl-1,2,4-triazolo[4,3-f]phenanthridinium-iodid

Eine Suspension von 1-Methyl-1,2,4-triazolo[4,3-f]phenanthridinium-tetrafluoroborat (4.7 g, 5.9 mmol) in Methanol (80 mL) wird unter Argon mit Tetrabutylammonium-iodid (6.5 g, 17.6 mmol) versetzt und 11 h unter Rückfluß gerührt. Nach Abkühlung auf Raumtemperatur wird der Niederschlag abfiltriert und mit Methanol gewaschen. Ausbeute: 4.1 g eines Gemisches von lodid- und Tetrafluoroborat-Salz (3:1, 83%).

Elementaranalyse: ber. für C₁₄H₁₃IN₃ / C₁₄H₁₃BF₄N₃ (3:1): C 51.44, H 3.46, N 12.00, I 26.36; gef.: C 51.4, H 3.5, N 12.0, I 26.3.

### mer-Tris-[1-Methyl-1,2,4-triazolo[4,3-f]phenanthridin-5-yliden-C5,C6]-iridium(III)

Eine Suspension von 1-Methyl-1,2,4-triazolo[4,3-f]phenanthridinium-iodid (4.0 g, 11.0 mmol) und Silber(I)oxid (1.3 g, 5.5 mmol) in Methanol (200 mL) wird 16 h bei Raumtemperatur unter Argon gerührt. Die Mischung wird mit Methanol (70 mL) verdünnt und weitere 5 h gerührt. Der Niederschlag wird abfiltriert und mit Methanol und Petrolether gewaschen. Ausbeute: 4.9 g (94%). Eine Mischung des Silbercarbens (4.8 g, 5.1 mmol) und von 1,5-Cyclooctadien-iridium(I)chlorid-Dimer (0.7 g, 1.1 mmol) in Mesitylen (200 mL) wird unter Argon 20 h unter Rückfluß gerührt. Nach Abkühlung auf Raumtemperatur wird der Niederschlag abfiltriert und mit Toluol gewaschen. Die vereinigten Filtrate werden zur Trockne eingeengt und säulenchromatographisch aufgereinigt (Aluminiumoxid, Dichlormethan/Toluol 4:1). Ausbeute: 1.4 g (75%).

¹H-NMR (*d*₆-DMSO, 400 MHz): δ = 3.47 (s, 3H), 3.60 (s, 3H), 3.68 (s, 3H), 6.81 (d, 1H), 6.93 (d, 1H), 7.00-7.09 (m, 5H), 7.18 (d, 1H), 7.25 (d, 1H), 7.68-7.76 (m, 3H), 7.81-7.96 (m, 6H), 8.30-8.38 (m, 3H), 8.56-8.64 (m, 3H).

### Synthese von 2 - o-Tolyl

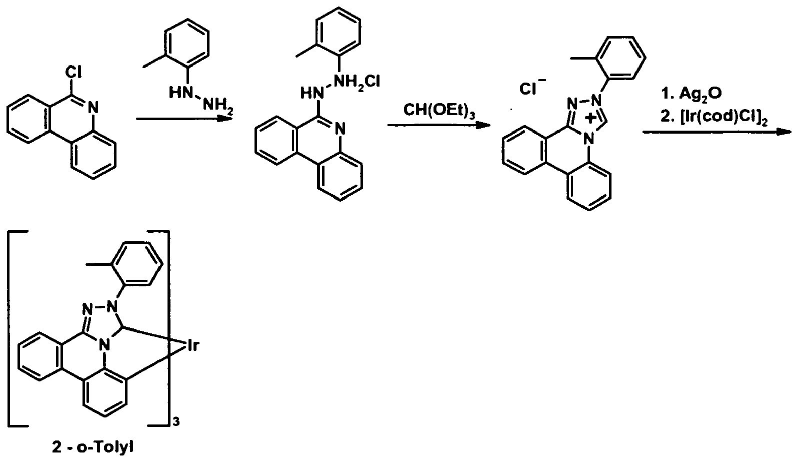

### N-Phenanthridin-6-yl-N'-o-tolylhydrazin-hydrochlorid

Eine Lösung von o-Tolylhydrazin-hydrochlorid (7.6 g, 47 mmol) in Dichlormethan (450 mL) wird je dreimal mit gesättigter, wässriger Natriumhydrogencarbonat-Lösung (je 90 mL) und VE-Wasser ausgeschüttelt. Die organische Phase wird über Natriumsulfat getrocknet, filtriert und zur Trockne eingeengt. Ausbeute: 4.9 g (86%). Das Hydrazin (4.8 g, 39 mmol) wird in Ethanol (100 mL) gelöst und unter Argon mit 6-Chlorphenanthridin *(A.G. Mikhailovskii, V.S. Shklyaev, Chem. Heterocycl. Comp. 1992, 445) (7.0 g, 33 mmol) versetzt. Die Mischung wird 16 h unter Rückfluß gerührt. Nach Abkühlung auf Raumtemperatur wird der entstandene Niederschlag abfiltriert und mit Ethanol und Petrolether gewaschen. Ausbeute: 9.3 g (85%).

¹H-NMR (*d₆*-DMSO, 400 MHz): δ = 2.41 (s, 3H), 6.90 (t, 1H), 6.97 (d, 1H), 7.11 (t, 1H), 7.20 (d, 1H), 7.60 (t, 1H), 7.74 (t, 1H), 7.92 (t, 1H), 8.16 (t, 1H), 8.24 (d, 1H), 8.30 (br s, 1H), 8.71 (d, 1H), 8.88 (d, 1H), 8.89 (d, 1H), 12.23 (br s, 1H), 13.02 (br s, 1H).

### 1-o-Tolyl-1,2,4-triazolo[4,3-f]phenanthridinium-chlorid

Eine Suspension von *N*-Phenanthridin-6-yl-*N*'-o-tolylhydrazin-hydrochlorid (9.0 g, 27 mmol) in Triethylorthoformiat (360 mL) wird unter Argon 17 h unter Rückfluß gerührt. Nach Abkühlung auf Raumtemperatur wird der Niederschlag abfiltriert und mit Triethylorthoformiat und kaltem Aceton gewaschen. Ausbeute: 8.2 g (88%).

¹H-NMR (*d*₆-DMSO, 400 MHz): δ = 2.47 (s, 3H), 7.56-7.73 (m, 3H), 7.81 (d, 1H), 7.90-8.02 (m, 3H), 8.09 (t, 1H), 8.63 (d, 1H), 8.70 (d, 1H), 8.90 (d, 1H), 8.93 (d, 1H), 12.22 (s, 1H).

### mer-Tris-[1-o-tolyl-1,2,4-triazolo[4,3-f]phenanthridin-5-yliden-C5,C6]-iridium(III)

Eine Suspension von 1-*o*-Tolyl-1,2,4-triazolo[4,3-f]-phenanthridinium-chlorid (10.0 g, 28.8 mmol) und Silber(I)oxid (3.3 g, 14.4 mmol) in Methanol (1200 mL) wird 44 h bei Raumtemperatur unter Argon gerührt. Der Niederschlag wird abfiltriert und mit Methanol und Petrolether gewaschen. Ausbeute: 10.5 g (80%). Eine Mischung des Silbercarbens (10.5 g, 11.6 mmol) und von 1,5-Cyclooctadien-iridium(I)chlorid-Dimer (1.6 g, 2.3 mmol) in Mesitylen (420 mL) wird unter Argon 16 h unter Rückfluß gerührt. Nach Abkühlung auf Raumtemperatur wird der Niederschlag abfiltriert und mit Dichlormethan gewaschen. Die vereinigten Filtrate werden zur Trockne eingeengt und der Rückstand wird säulenchromatographisch aufgereinigt (Aluminiumoxid, Dichlormethan/ Cyclohexan 1:1). Ausbeute: 1.6 g (25%) fac-Isomer und 1.5 g (25%) *mer*-Isomer.

*fac*-Isomer: ¹H-NMR (CD₂Cl₂, 400 MHz): δ = 1.51 (s, 9H), 6.47 (br s, 3H), 6.65 (m_{c}, 6H), 6.73 (d, 3H), 6.94 (dd, 3H), 7.01 (dd, 3H), 7.59 (dd, 3H), 7.76 (d, 3H), 7.80 (dd, 3H), 8.23 (d, 3H), 8.45 (d, 3H). *mer*-Isomer: ¹H-NMR (CD₂Cl₂, 400 MHz): δ = 1.02 (s, 3H), 1.51 (s, 3H), 1.71 (s, 3H), 5.85 (br s, 1H), 6.22 (br s, 1H), 6.29 (d, 1H), 6.44 (br s, 1H), 6.52-6.74 (m, 7H), 6.80 (dd, 1H), 6.82 (dd, 1H), 7.00-7.14 (m, 3H), 7.31 (br s, 1H), 7.40 (d, 1H), 7.49 (d, 1H), 7.56 (dd, 1H), 7.58 (dd, 1H), 7.64 (dd, 1H), 7.69-7.84 (m, 5H), 8.28-8.43 (m, 6H).

### Synthese von 2 - Phenyl

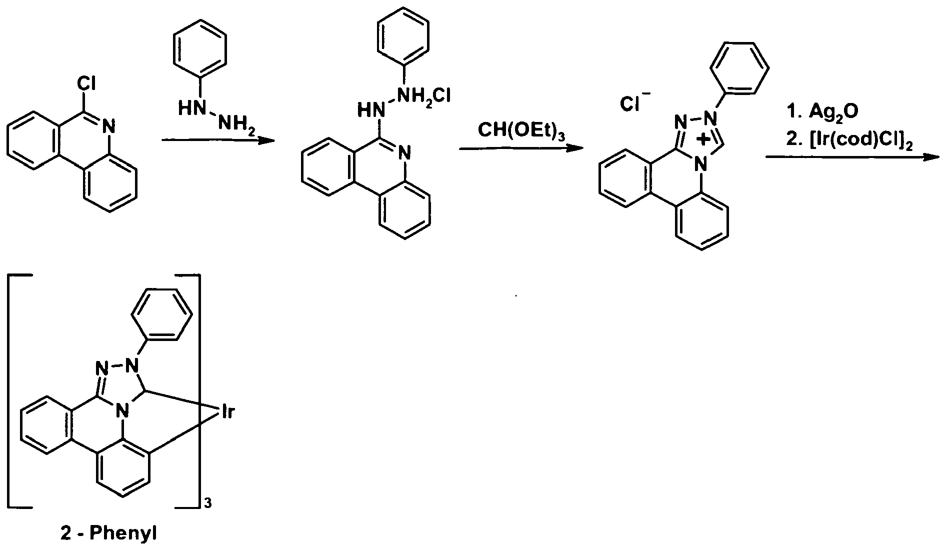

### N-Phenanthridin-6-yl-N'-phenylhydrazin-hydrochlorid

Phenylhydrazin (1.3 g, 12 mmol) wird in Ethanol (50 mL) gelöst und unter Argon mit 6-Chlorphenanthridin (A.G. Mikhailovskii, V.S. Shklyaev, Chem. Heterocycl. Comp. 1992, 445) (2.1 g, 10 mmol) versetzt. Die Mischung wird 16 h unter Rückfluß gerührt. Nach Abkühlung auf Raumtemperatur wird die Mischung aufkonzentriert und der entstandene Niederschlag abfiltriert und mit Methyl-*tert*-butylether gewaschen. Ausbeute: 2.6 g (82%).

¹H-NMR (*d₆*-DMSO, 400 MHz): δ = 6.95 (t, 1H), 7.10 (d, 2H), 7.29 (t, 2H), 7.55 (br s, 1H), 7.69 (br t, 1H), 7.88 (br t, 1H), 8.11 (br s, 1H), 8.17 (br s, 1H), 8.65 (br s, 1H), 8.84 (br s, 2H), 8.99 (br s, 1H), 12.30 (br s, 1H), 13.05 (br s, 1H).

### 1-Phenyl-1,2,4-triazolo[4,3-f]phenanthridinium-chlorid

Eine Suspension von N-Phenanthridin-6-yl-*N*'-phenylhydrazin-hydrochlorid (2.0 g, 6.2 mmol) in Triethylorthoformiat (100 mL) wird unter Argon 17 h unter Rückfluß gerührt. Nach Abkühlung auf Raumtemperatur wird die Mischung aufkonzentriert und der Niederschlag abfiltriert und mit Petrolether, Methyl-*tert*-butylether und Aceton gewaschen. Ausbeute: 1.2 g (57%).

¹H-NMR (*d₆*-DMSO, 400 MHz): δ = 7.74 (t, 1H), 7.82 (t, 2H), 7.88-8.01 (m, 3H), 8.08 (t, 1H), 8.31 (d, 2H), 8.68 (d, 1H), 8.80 (d, 1H), 8.86 (d, 1H), 8.88 (d, 1H), 12.62 (s, 1H).

### mer-Tris-[1-phenyl-1,2,4-triazolo[4,3-flphenanthridin-5-yliden-C5,C6]-iridium(III)

Eine Suspension von 1-Phenyl-1,2,4-triazolo[4,3-f]¬phenanthridinium-chlorid (1.18 g, 3.6 mmol) und Silber(I)oxid (0.42 g, 1.8 mmol) in Methanol (200 mL) wird 32 h bei Raumtemperatur unter Argon gerührt. Der Niederschlag wird abfiltriert und mit Methanol gewaschen. Ausbeute: 1.24 g (78%). Eine Mischung des Silbercarbens (1.24 g, 1.4 mmol) und von 1,5-Cyclooctadien-iridium(I)chlorid-Dimer (0.19 g, 0.3 mmol) in Mesitylen (100 mL) wird unter Argon 16 h unter Rückfluß gerührt. Nach Abkühlung auf Raumtemperatur wird der Niederschlag abfiltriert und mit Essigester gewaschen. Die vereinigten Filtrate werden zur Trockne eingeengt und der Rückstand wird säulenchromatographisch aufgereinigt (Kieselgel, Essigester/Cyclohexan 1:1). Ausbeute: 0.03 g (5%) *fac*-Isomer, 0.01 g (2%) mer-Isomer und 0.34 g (57%) Isomerengemisch.

*fac*-Isomer: ¹H-NMR (CD₂Cl₂, 400 MHz): δ = 6.16 (d, 6H), 6.88 (d, 3H), 6.93 (dd, 6H), 7.11 (dd, 3H), 7.26 (dd, 3H), 7.63 (dd, 3H), 7.80 (dd, 3H), 7.87 (d, 3H), 8.35 (d, 3H), 8.49 (d, 3H). ESI-MS: *m*/*z* = 1074.2786 (ber. für M+H⁺: 1074.2778). *mer*-Isomer: ¹H-NMR (CD₂Cl₂, 400 MHz): δ = 6.29-6.37 (m, 2H), 6.44 (d, 1H), 6.47 (dd, 1H), 6.54 (dd, 2H), 6.66 (d, 1H), 6.78 (dd, 1H), 6.95 (dd, 2H), 7.00-7.23 (m, 9H), 7.55-7.79 (m, 8H), 7.84 (d, 1H), 8.15 (d, 1H), 8.29 (d, 1H), 8.34 (d, 1H), 8.39 (d, 1H), 8.43 (dd, 2H), 8.55 (d, 1H), 8.98 (d, 1H).

### Synthese von 2 - Isopropyl

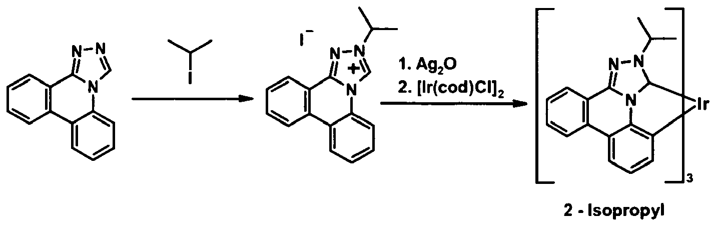

Der Komplex **2 - Isopropyl** wird analog zur Synthese von **2 - Methyl** ausgehend von 1,2,4-Triazolo[4,3-f]phenanthridin *(A.G. Mikhailovskii, V.S. Shklyaev, Chem. Heterocycl. Comp. 1992, 445) hergestellt.

ESI-MS: *m*/*z* = 973 (ber. für M+H⁺: 973).

Synthese von 2 - **p-Pyridyl**

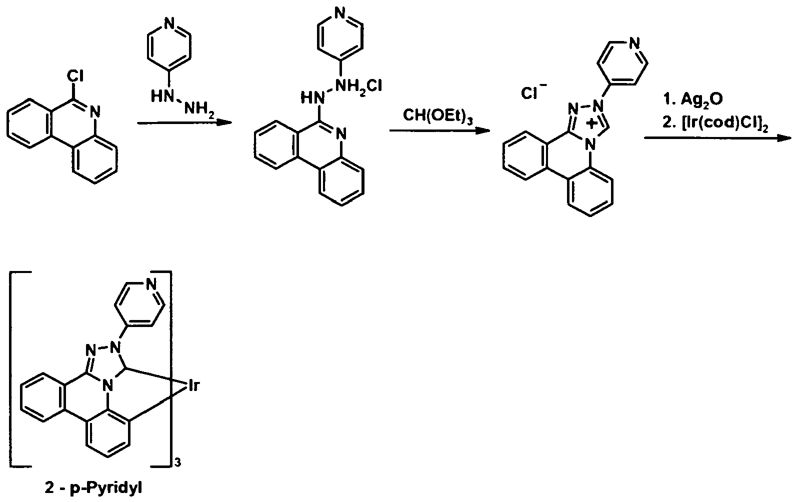

Der Komplex **2** - **p-Pyridyl** wird analog zur Synthese von **2 - Pheny**l ausgehend von Chlorphenanthridin (A.G. Mikhailovskii, V.S. Shklyaev, Chem. Heterocycl. Comp. 1992, 445) und 4-Hydrazinopyridin * E.M. Isin, M. Jonge, N. Castagnoli, J. Org. Chem. 2001, 66, 4220) hergestellt.

**2 - p-Pyridyl**: ESI-MS: *m*/*z* = 1078 (ber. für M+H⁺: 1078).

### II) Photophysikalische Charakterisierung

Die Photolumineszenz der emittierenden Komplexe wurde in dünnen PMMA-Filmen (Polymethylmethacrylat) mit einer Emitterdotierung von 2% durchgeführt. Die Filme wurden wie folgt hergestellt: 2mg/l Emitter wurden in einer 10%igen PMMA-Lösung in DCM (Mw 120kD) gelöst und auf einen Objektträger mit einem 60µm Rakel aufgerakelt. Die Anregung erfolgte bei einer Wellenlänge von 325 nm (HeCd-Laser) senkrecht zum Objektträger und die Detektion der Emission in einem Winkel von 45° mittels Faseroptik im Diodenarrayspektrometer.

| Komplex | λₘₐₓ [nm] | QA [%] | CIE x | CIE y |
|---|---|---|---|---|
| **2 - Methyl** (*mer*-Isomer) | 448,481 | 45 | 0.15 | 0.18 |
| **2 - Phenyl** (*fac*-Isomer) | 448,475 | 45 | 0.15 | 0.17 |
| **2 - Phenyl** (*mer*-Isomer) | 452, 478 | 65 | 0.15 | 0.18 |
| **2 - o-Tolyl** (*fac*-Isomer) | 445,473 | 71 | 0.15 | 0.15 |
| **2 - o-Tolyl** (*mer*-Isomer) | 449,475 | 49 | 0.15 | 0.18 |

### III) OLED-Devicetests

### III.1) Licht-emittierende Schicht: Verbindung der Formel I + Silylcarbazol

Das als Anode verwendete ITO-Substrat wird zuerst mit kommerziellen Reinigungsmitteln für die LCD-Produktion (Deconex® 20NS und Neutralisationsmittel 25ORGAN-ACID®) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert auch die Lochinjektion des ITOs.

Danach werden die nachfolgend genannten organischen Materialien mit einer Rate von 0.5-5.0 nm/min bei etwa 10⁻⁸ mbar auf das gereinigte Substrat aufgedampft. Als Lochleiter und Exciton-Blocker wird zuerst die Verbindung V1 in einer Schichtdicke von 45 nm auf das Substrat aufgebracht.

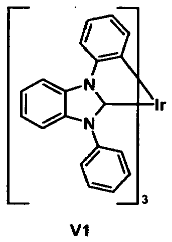

(Zur Herstellung von Verbindung V1 siehe Ir-Komplex (7) in WO 2005/019373.)

Anschließend wird eine Mischung aus 6.5 Gew.-% der Verbindung **2 - Methyl** 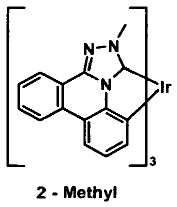 und 93.5 Gew.-% der Verbindung V2

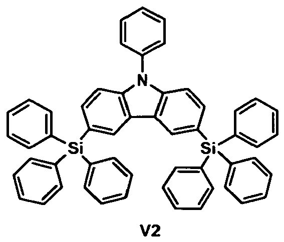

(Zur Herstellung von Verbindung V2 siehe Beispiel (4b) in der nicht vorveröffentlichen Anmeldung mit dem Aktenzeichen EP 07 111 824.4 (Titel: "Organische Leuchtdioden enthaltend mindestens eine Disilylverbindung ausgewählt aus Disilylcarbazolen, Disilyldibenzofuranen, Disilyldibenzothiophenen, Disilyldibenzophospholen, Disilyldibenzothiophen-S-oxiden und Disilyldibenzothiophen-S,S-dioxiden").

in einer Dicke von 40 nm aufgedampft, wobei **2 - Methyl** als Emitter und V2 als Matrixmaterial fungiert Danach wird eine Excitonenblockerschicht aus V2 in einer Dicke von 10 nm aufgedampft.

Danach wird eine Elektronenleiterschicht aus BCP (2,9-Dimethyl-4,7-diphenyl-1,10-phenanthrolin) in einer Dicke von 45 nm, eine 0.7 nm dicke Lithiumfluorid-Schicht und abschliessend eine 100 nm dicke Al-Elektrode aufgedampft.

Zur Charakterisierung der OLED werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden. Zur Bestimmung der Lebensdauer wird die OLED bei einer konstanten Stromdichte betrieben und die Abnahme der Lichtleistung aufgezeichnet. Die Lebensdauer ist als diejenige Zeit definiert, die zur Abnahme der Leuchtdichte auf die Hälfte der anfänglichen Leuchtdichte verstreicht.

Für das beschriebene OLED ergeben sich die folgenden elektrooptischen Daten:

| | |
|---|---|
| Emissionsmaximum | 452, 479 nm |
| CIE(x, y) | 0.15; 0.18 |
| Photometrischer Wirkungsgrad | 13.4 cd/A (max.) |
| Externe Quantenausbeute | 7.2 % (max.) |
| Maximale Leuchtdichte | 1300 cd/m² (max.) |

### III.2) Licht-emittierende Schicht: Verbindung der Formel I + Ir(dpbic)₃

Das als Anode verwendete ITO-Substrat wird zuerst mit kommerziellen Reinigungsmitteln für die LCD-Produktion (Deconex^{®} 20NS und Neutralisationsmittel 25ORGAN-ACID^{®}) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert weiterhin die Lochinjektionseigenschaften des ITOs.

Danach werden die nachfolgend genannten organischen Materialien mit einer Rate von ca. 0.5-5 nm/min bei etwa 10⁻⁸ mbar auf das gereinigte Substrat aufgedampft. Als Lochleiter und Excitonenblocker wird Ir(dpbic)₃ mit einer Dicke von 45 nm auf das Substrat aufgebracht. 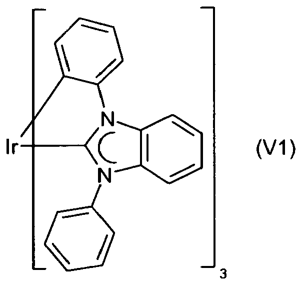 Ir(dpbic)₃
(zur Herstellung siehe Ir-Komplex (7) in der Anmeldung WO 2005/019373).

Anschließend wird eine Mischung aus 7 Gew.-% der Verbindung **2-R** 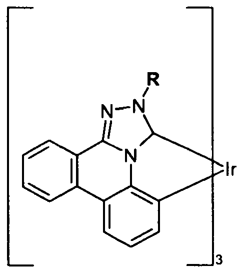 **2-R**
und 93 Gew.-% der Verbindung Ir(dpbic)₃ in einer Dicke von 40 nm aufgedampft, wobei erstere Verbindung als Emitter, letztere als Matrixmaterial fungiert.

Anschließend wird das Material 9-(4-Phenyl)-3,6-bis(triphenylsilyl)-9H-carbazol mit einer Dicke von 10 nm als Excitonen- und Lochblocker aufgedampft.

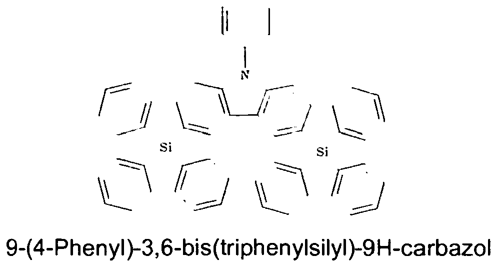

Als nächstes wird ein Elektronentransporter BCP 2,9-Dimethyl-4,7-diphenyl-1,10-phenanthrolin in einer Dicke von 45 nm, eine 0,75 nm dicke Lithiumfluorid-Schicht und abschließend eine 110 nm dicke Al-Elektrode aufgedampft.

Zur Charakterisierung des OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden.

Für die beschriebenen OLEDs ergeben sich die folgenden elektrooptischen Daten:

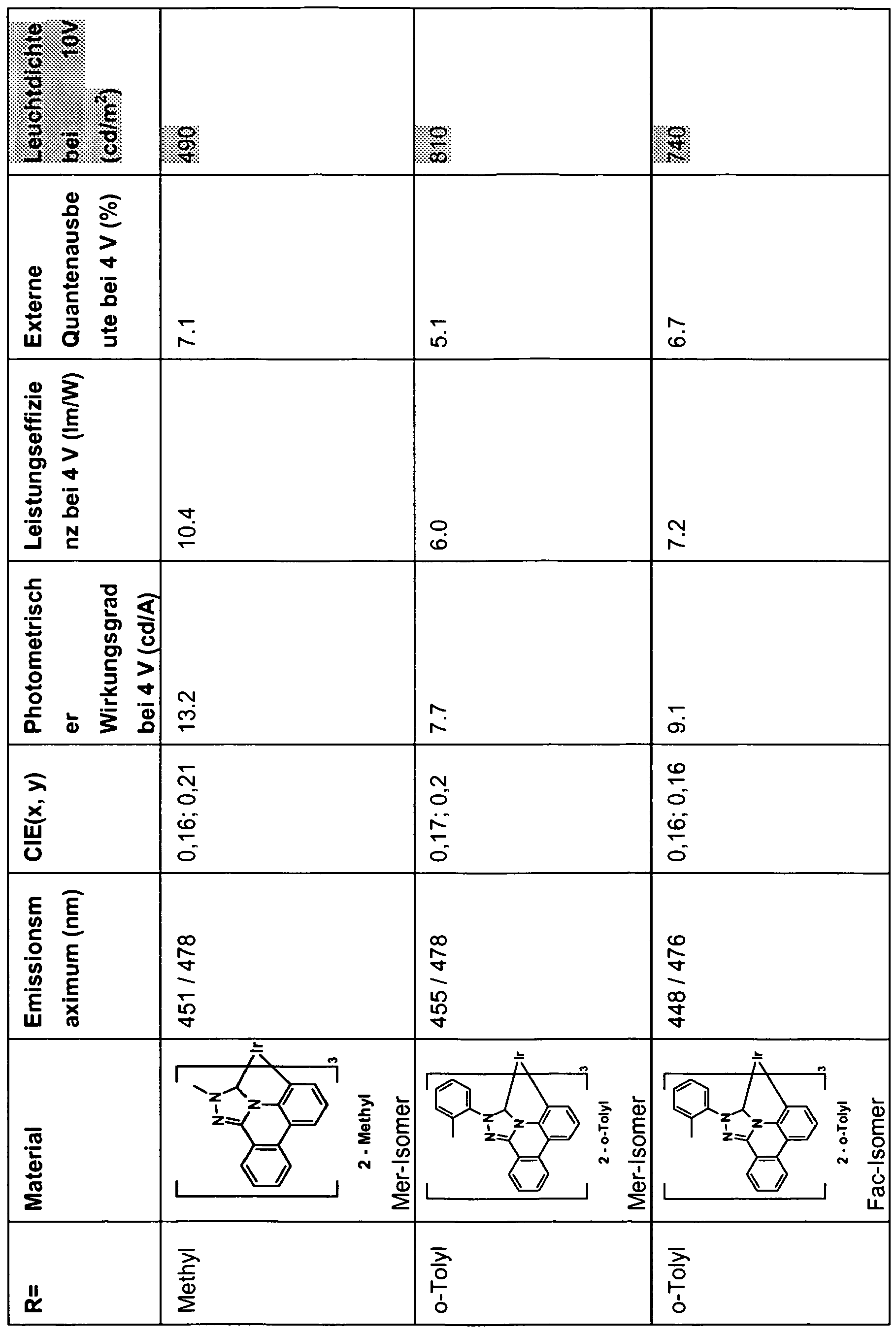

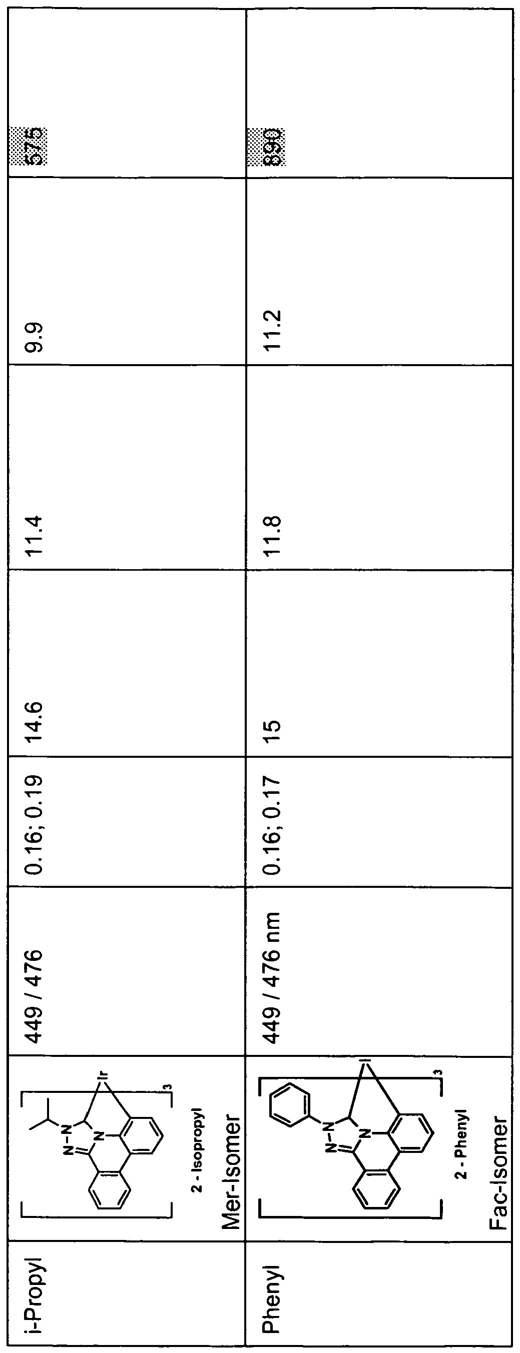

## Patentansprüche

1. Cyclometallierte Carbenkomplexe der allgemeinen Formel (I) 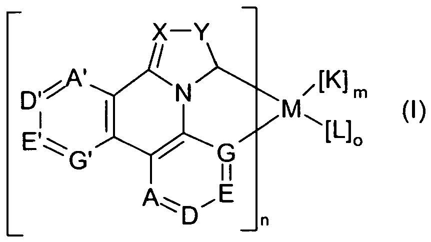 worin die Symbole die folgenden Bedeutungen aufweisen:
M Metallatom ausgewählt aus der Gruppe bestehend aus Metallen der Gruppe IB, IIB, IIIB, IVB, VB, VIB, VIIB, VIIIB, den Lanthaniden und IIIA des Periodensystems der Elemente (CAS-Version) in jeder für das entsprechende Metallatom möglichen Oxidationsstufe; bevorzugt Fe, Os, Co, Rh, Ir, Ni, Ru, Pd und Pt, Cu, Au, Ce, Tb, Eu, besonders bevorzugt Os, Ru, Rh, Ir und Pt und ganz besonders bevorzugt Ir, Os und Pt;
K neutraler mono- oder bidentater Ligand;
L mono- oder dianionischer Ligand, bevorzugt monoanionischer Ligand, der mono- oder didentat sein kann;
X CR¹ oder N, bevorzugt N;
Y NR² oder CR²₂;
A, D, G, E, A', D', G' oder E' unabhängig voneinander CH, CR³ oder N;
R¹ F, CN, C₁-C₂₀-Alkoxy, C₆-C₃₀-Aryloxy, C₁-C₂₀-Alkylthio, C₆-C₃₀-Arylthio, substituiertes oder unsubstituiertes C₆-C₃₀-Aryl oder substituiertes oder unsubstituiertes Heteroaryl mit 5 bis 30 Ringatomen;
R², R³ unabhängig voneinander substituiertes oder unsubstituiertes C₁-C₂₀-Alkyl, substituiertes oder unsubstituiertes C₅-C₂₀-Cycloalkyl, substituiertes oder unsubstituiertes C₅-C₂₀-Cycloalkenyl, substituiertes oder unsubstituiertes Heterocycloalkyl mit 5 bis 30 Ringatomen, substituiertes oder unsubstituiertes Heterocycloalkenyl mit 5 bis 30 Ringatomen, substituiertes oder unsubstituiertes C₂-C₂₀-Alkenyl, substituiertes oder unsubstituiertes C₂-C₂₀-Alkinyl substituiertes oder unsubstituiertes C₆-C₃₀-Aryl, substituiertes oder unsubstituiertes Heteroaryl mit 5 bis 30 Ringatomen oder ein Substituent mit Donor- oder Akzeptorwirkung ausgewählt aus der Gruppe bestehend aus: C₁-C₂₀-Alkoxy, C₆-C₃₀-Aryloxy, C₁-C₂₀-Alkylthio, C₆-C₃₀-Arylthio, SiR⁴R⁵R⁶, Halogenresten, halogenierten C₁-C₂₀-Alkylresten, Carbonyl (-CO(R⁴)), Carbonylthio (-C=O(SR⁴)), Carbonyloxy (-C=O(OR⁴)), Oxycarbonyl (-OC=O(R⁴)), Thiocarbonyl (-SC=O(R⁴)), Amino (-NR⁴R⁵), OH, Pseudohalogenresten, Amido (-C=O(NR⁴R⁵)), -NR⁴C=O(R⁵), Phosphonat (-P(O)(OR⁴)₂, Phosphat (-OP(O)(OR⁴)₂), Phosphin (-PR⁴R⁵), Phosphinoxid (-P(O)R⁴₂), Sulfat (-OS(O)₂OR⁴), Sulfoxid (-S(O)R⁴), Sulfonat (-S(O)₂OR⁴), Sulfonyl (-S(O)₂R⁴, Sulfonamid (-S(O)₂NR⁴R⁵), NO₂, Boronsäureestern (-B(OR⁴)₂), Imino (-C=NR⁴R⁵)), Boranresten, Stannatresten, Hydrazinresten, Hydrazonresten, Oximresten, Nitroso-Gruppen, Diazo-Gruppen, Vinylgruppen, Sulfoximinen, Alanen, Germanen, Boroxinen und Borazinen;
oder
zwei benachbarte Reste R³ bilden gemeinsam eine gesättigte oder ungesättigte substituierte oder unsubstituierte Brücke aus 3 bis 6 Atomen, so dass die Reste R³ gemeinsam mit einem der Elemente A=D, D-E, A'=D', D'-E', E'=G' einen 5- bis 8-gliedrigen Ring bilden;
oder
die Reste R³ an den Positionen G' und A bilden gemeinsam eine gesättigte oder ungesättigte substituierte oder unsubstituierte Brücke aus 1 bis 4 Atomen, so dass die Reste R³ gemeinsam mit dem Element -G'-C-C-A- einen 5- bis 8-gliedrigen Ring bilden;
R⁴, R⁵, R⁶ unabhängig voneinander H, substituiertes oder unsubstituiertes C₁-C₂₀-Alkyl oder substituiertes oder unsubstituiertes C₆-C₃₀-Aryl oder substituiertes oder unsubstituiertes Heteroaryl mit 5 bis 30 Ringatomen;
n Zahl der Carbenliganden, wobei n mindestens 1 ist und die Carbenliganden in dem Komplex der Formel I bei n > 1 gleich oder verschieden sein können;
m Zahl der Liganden K, wobei m 0 oder ≥ 1 sein kann, und die Liganden K bei m > 1 gleich oder verschieden sein können;
o Zahl der Liganden L, wobei o 0 oder ≥ 1 sein kann, und die Liganden L bei o > 1 gleich oder verschieden sein können;
wobei die Summe n + m + o von der Oxidationsstufe und Koordinationszahl des eingesetzten Metallatoms und von der Zähnigkeit der Liganden L und K sowie von der Ladung des Liganden L abhängig ist, mit der Bedingung, dass n mindestens 1 ist.

2. Carbenkomplexe nach Anspruch 1, **dadurch gekennzeichnet, dass**
M Ir(III),
n 3, und
m, o 0 bedeuten.

3. Carbenkomplexe nach Anspruch 1 oder 2, **dadurch gekennzeichnet, dass**
R¹ ,R², R³ unabhängig voneinander ausgewählt sind aus der Gruppe bestehend aus substituiertem oder unsubstituiertem C₁-C₂₀-Alkyl, substituiertem oder unsubstituiertem C₂-C₂₀-Alkenyl, substituiertem oder unsubstituiertem C₂-C₂₀-Alkinyl, substituiertem oder C₆-C₃₀-Aryl, substituiertem oder unsubstituiertem Heteroaryl mit 5 bis 30 Ringatomen, C₁-C₂₀-Alkoxy, C₆-C₃₀-Aryloxy, C₁-C₂₀-Alkylthio, C₆-C₃₀-Arylthio, SiR⁴R⁵R⁶, Halogenresten, halogenierten C₁-C₂₀-Alkylresten und Pseudohalogenresten; besonders bevorzugt sind R² und R³ unabhängig voneinander ausgewählt aus der Gruppe bestehend aus substituiertem oder unsubstituiertem C₁-C₂₀-Alkyl, bevorzugt C₁- bis C₄-Alkyl, besonders bevorzugt Methyl, Ethyl, n-Propyl, Isopropyl, n-Butyl, Isobutyl, sek.-Butyl oder tert.-Butyl, substituiertem oder unsubstituiertem C₆-C₃₀-Aryl, bevorzugt substituiertem oder unsubstituiertem Phenyl, besonders bevorzugt unsubstituiertem Phenyl, Tolyl, Dimethylphenyl, Trimethylphenyl, mit F, CN, Methoxy und/oder CF₃ substituiertem Phenyl, substituiertem oder unsubstituiertem Heteroaryl mit 5 bis 30 Ringatomen, bevorzugt substituiertem oder unsubstituiertem Heteroaryl mit 5 bis 13 Ringatomen, besonders bevorzugt Pyridyl, Thienyl, Pyrrolyl, Furyl, Thiazolyl, Oxazolyl, Pyrazolyl oder Imidazolyl, C₁-C₂₀-Alkoxy, bevorzugt C₁- bis C₄-Alkoxy, besonders bevorzugt Methoxy, C₆-C₃₀-Aryloxy, bevorzugt C₆- bis C₁₀-Aryloxy, besonders bevorzugt Phenoxy, C₁-C₂₀-Alkylthio, bevorzugt C₁- bis C₄-Alkylthio, besonders bevorzugt SCH₃, C₆-C₃₀-Arylthio, bevorzugt C₆- bis C₁₀-Arylthio, besonders bevorzugt SPh, SiR⁴R⁵R⁶, bevorzugt SiMe₃ oder SiPh₃, Halogenresten, bevorzugt F, Cl, Br, besonders bevorzugt F, halogenierten C₁-C₂₀-Alkylresten, bevorzugt halogenierten C₁-C₁₀-Alkylresten, besonders bevorzugt CF₃, und Pseudohalogenresten, bevorzugt CN;
oder zwei benachbarte Reste R³ bilden gemeinsam eine gesättigte oder ungesättigte mit Methyl, Methoxy, Phenyl, SiMe₃, SiPh₃, F, CF₃ oder CN substituierte oder unsubstituierte Brücke aus 3 oder 4 Kohlenstoffatomen, so dass die Reste R³ gemeinsam mit einem der Elemente A=D, D-E, A'=D', D'-E', E'=G' einen 5- oder 6-gliedrigen Ring bilden;
oder
die Reste R³ an den Positionen G' und A bilden gemeinsam eine gesättigte oder ungesättigte mit Methyl, Methoxy, Phenyl, SiMe₃, SiPh₃, F, CF₃ oder CN substituierte oder unsubstituierte Brücke aus 1 oder 2 Kohlenstoffatomen, so dass die Reste R³ gemeinsam mit dem Element -G'-C-C-A- einen 5- oder 6-gliedrigen Ring bilden.

4. Carbenkomplexe nach einem der Ansprüche 1 bis 3, **dadurch gekennzeichnet, dass**
R² ausgewählt ist aus der Gruppe bestehend aus substituiertem oder unsubstituiertem C₁-C₂₀-Alkyl, das in 1-Position verzweigt ist, bevorzugt Isopropyl, Isobutyl, Isopentyl, sek-Butyl oder tert-Butyl; substituiertem oder unsubstituiertem C₆-Aryl, bevorzugt unsubstituiertem Phenyl oder Phenyl, das in 2- und/oder 6-Position substituiert ist, bevorzugt mit Methyl, Methoxy, CF₃, CN und/oder F; besonders bevorzugt 2-Tolyl, 2-Methoxyphenyl, 2-Cyanophenyl, 2-Trifluormethylphenyl, 2,6-Difluorophenyl, 2,3-, 2,4-, 2,5- oder 2,6-Dimethylphenyl oder 2,4,6-, 2,3,4- oder 2,3,5-Trimethylphenyl; substituiertem oder unsubstituiertem Heteroaryl mit 5 bis 13 Ringatomen, bevorzugt Pyridin-2-yl, Pyridin-3-yl, Pyridin-4-yl, Thiophen-2-yl, Thiophen-3-yl, Pyrrol-2-yl, Pyrrol-3-yl, Furan-2-yl, Furan-3-yl, Thiazol-2-yl, Oxazol-2-yl, Pyrazol-3-yl oder Imidazol-2-yl sowie den entsprechenden benzanellierten Resten.

5. Carbenkomplexe nach einem der Ansprüche 1 bis 4, **dadurch gekennzeichnet, dass**
X N, und
Y NR²;
bedeuten.

6. Carbenkomplexe nach einem der Ansprüche 1 bis 5, **dadurch gekennzeichnet, dass**
A, D, G, E, A', D', G'und E'
CH oder CR³, bevorzugt CH bedeuten.

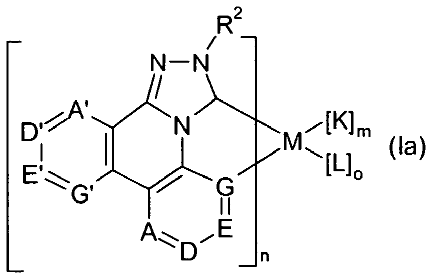

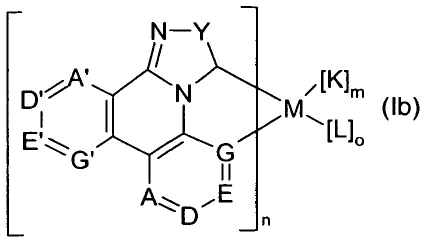

7. worin bedeuten:
A, D, G, E, A', D', G'und E' unabhängig voneinander CH, CR³ oder N, bevorzugt CH oder CR³, besonders bevorzugt CH;
R², R³ unabhängig voneinander substituiertes oder unsubstituiertes C₁-C₂₀-Alkyl, substituiertes oder unsubstituiertes C₅-C₂₀-Cycloalkyl, substituiertes oder unsubstituiertes C₅-C₂₀-Cycloalkenyl, substituiertes oder unsubstituiertes Heterocycloalkyl mit 5 bis 30 Ringatomen, substituiertes oder unsubstituiertes Heterocycloalkenyl mit 5 bis 30 Ringatomen, substituiertes oder unsubstituiertes C₂-C₂₀-Alkenyl, substituiertes oder unsubstituiertes C₂-C₂₀-Alkinyl substituiertes oder unsubstituiertes C₆-C₃₀-Aryl, substituiertes oder unsubstituiertes Heteroaryl mit 5 bis 30 Ringatomen oder ein Substituent mit Donor- oder Akzeptorwirkung ausgewählt aus der Gruppe bestehend aus: C₁-C₂₀-Alkoxy, C₆-C₃₀-Aryloxy, C₁-C₂₀-Alkylthio, C₆-C₃₀-Arylthio, SiR⁴R⁵R⁶, Halogenresten, halogenierten C₁-C₂₀-Alkylresten, Carbonyl (-CO(R⁴)), Carbonylthio (-C=O(SR⁴)), Carbonyloxy (-C=O(OR⁴)), Oxycarbonyl (-OC=O(R⁴)), Thiocarbonyl (-SC=O(R⁴)), Amino (-NR⁴R⁵), OH, Pseudohalogenresten, Amido (-C=O(NR⁴R⁵)), -NR⁴C=O(R⁵), Phosphonat (-P(O)(OR⁴)₂, Phosphat (-OP(O)(OR⁴)₂), Phosphin (-PR⁴R⁵), Phosphinoxid (- P(O)R⁴₂), Sulfat (-OS(O)₂OR⁴), Sulfoxid (-S(O)R⁴), Sulfonat (-S(O)₂OR⁴), Sulfonyl (-S(O)₂R⁴, Sulfonamid (-S(O)₂NR⁴R⁵), NO₂, Boronsäureestern (-B(OR⁴)₂), Imino (-C=NR⁴R⁵)), Boranresten, Stannatresten, Hydrazinresten, Hydrazonresten, Oximresten, Nitroso-Gruppen, Diazo-Gruppen, Vinylgruppen, Sulfoximinen, Alanen, Germanen, Boroxinen und Borazinen;
oder
zwei benachbarte Reste R³ bilden gemeinsam eine gesättigte oder ungesättigte substituierte oder unsubstituierte Brücke aus 3 bis 6 Atomen, so dass die Reste R³ gemeinsam mit einem der Elemente A=D, D-E, A'=D', D'-E', E'=G' einen 5- bis 8-gliedrigen Ring bilden;
oder
die Reste R³ an den Positionen G' und A bilden gemeinsam eine gesättigte oder ungesättigte substituierte oder unsubstituierte Brücke aus 1 bis 4 Atomen, so dass die Reste R³ gemeinsam mit dem Element -G'-C-C-A- einen 5- bis 8-gliedrigen Ring bilden;
wobei R² bevorzugt ausgewählt ist aus der Gruppe bestehend aus substituiertem oder unsubstituiertem C₁-C₂₀-Alkyl, das in 1-Position verzweigt ist, bevorzugt Isopropyl, Isobutyl, Isopentyl, sek-Butyl oder tert-Butyl; substituiertem oder unsubstituiertem C₆-Aryl, bevorzugt unsubstituiertem Phenyl oder Phenyl, das in 2- und/oder 6-Position substituiert ist, bevorzugt mit Methyl, Methoxy, CF₃, CN und/oder F; besonders bevorzugt 2-Tolyl, 2-Methoxyphenyl, 2-Cyanophenyl, 2-Trifluormethylphenyl, 2,6-Difluorophenyl, 2,3-, 2,4-, 2,5- oder 2,6-Dimethylphenyl oder 2,4,6-, 2,3,4- oder 2,3,5-Trimethylphenyl; substituiertem oder unsubstituiertem Heteroaryl mit 5 bis 13 Ringatomen, bevorzugt Pyridin-2-yl, Pyridin-3-yl, Pyridin-4-yl, Thiophen-2-yl, Thiophen-3-yl, Pyrrol-2-yl, Pyrrol-3-yl, Furan-2-yl, Furan-3-yl, Thiazol-2-yl, Oxazol-2-yl, Pyrazol-3-yl oder Imidazol-2-yl sowie den entsprechenden benzanellierten Resten;
R⁴, R⁵ R⁶ unabhängig voneinander H, substituiertes oder unsubstituiertes C₁-C₂₀-Alkyl oder substituiertes oder unsubstituiertes C₆-C₃₀-Aryl oder substituiertes oder unsubstituiertes Heteroaryl mit 5 bis 30 Ringatomen;
Y CR²₂;
M Ir, Os oder Pt; bevorzugt Ir(III), Os(II) oder Pt(II), besonders bevorzugt Ir(III);
K neutraler bidentater Ligand;
L monoanionischer bidentater Ligand;
n Zahl der Carbenliganden, wobei n im Falle von Ir 3 bedeutet, im Falle von Os 2 bedeutet und im Falle von Pt 1 oder 2 bedeutet, und die Carbenliganden in dem Komplexen der Formeln Ia, Ib, Ic, und Id gleich oder verschieden sein können;
m im Falle von M = Ir oder Pt 0 und im Falle von Os 1;
o im Falle von M = Ir oder Os und Pt, für den Fall, dass n = 2 bedeutet, 0 und im Falle von Pt, für den Fall, dass n = 1 bedeutet, 1.

8. Verfahren zur Herstellung von Carbenkomplexen nach einem der Ansprüche 1 bis 7, umfassend die Umsetzung von mindestens einem Ligandvorläufer der Formel (III) 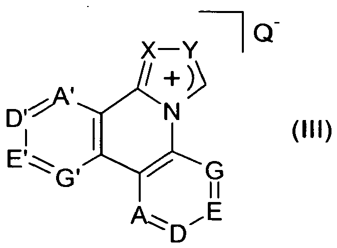 worin
Q⁻ ein monoanionisches Gegenion, bevorzugt Halogenid, Pseudohalogenid, BF₄⁻, BPh₄⁻, PF₆⁻, AsF₆⁻ oder SbF₆⁻; bedeutet;
und
die weiteren Symbole in dem Ligandvorläufer der allgemeinen Formel II die folgenden Bedeutungen aufweisen:
X CR¹ oder N, bevorzugt N;
Y NR² oder CR²₂;
A, D, G, E, A', D', G' oder E' unabhängig voneinander CH, CR³ oder N;
R¹ F, CN, C₁-C₂₀-Alkoxy, C₆-C₃₀-Aryloxy, C₁-C₂₀-Alkylthio, C₆-C₃₀-Arylthio, substituiertes oder unsubstituiertes C₆-C₃₀-Aryl oder substituiertes oder unsubstituiertes Heteroaryl mit 5 bis 30 Ringatomen;
R², R³ und unabhängig voneinander substituiertes oder unsubstituiertes C₁-C₂₀-Alkyl, substituiertes oder unsubstituiertes C₅-C₂₀-Cycloalkyl, substituiertes oder unsubstituiertes C₅-C₂₀-Cycloalkenyl, substituiertes oder unsubstituiertes Heterocycloalkyl mit 5 bis 30 Ringatomen, substituiertes oder unsubstituiertes Heterocycloalkenyl mit 5 bis 30 Ringatomen, substituiertes oder unsubstituiertes C₂-C₂₀-Alkenyl, substituiertes oder unsubstituiertes C₂-C₂₀-Alkinyl substituiertes oder unsubstituiertes C₆-C₃₀-Aryl, substituiertes oder unsubstituiertes Heteroaryl mit 5 bis 30 Ringatomen oder ein Substituent mit Donor- oder Akzeptorwirkung ausgewählt aus der Gruppe bestehend aus: C₁-C₂₀-Alkoxy, C₆-C₃₀-Aryloxy, C₁-C₂₀-Alkylthio, C₆-C₃₀-Arylthio, SiR⁴R⁵R⁶, Halogenresten, halogenierten C₁-C₂₀-Alkylresten, Carbonyl (-CO(R⁴)), Carbonylthio (-C=O(SR⁴)), Carbonyloxy (-C=O(OR⁴)), Oxycarbonyl (-OC=O(R⁴)) , Thiocarbonyl (-SC=O(R⁴)) , Amino (-NR⁴R⁵), OH, Pseudohalogenresten, Amido (-C=O(NR⁴R⁵)), -NR⁴C=O(R⁵), Phosphonat (-P(O(OR⁴)₂, Phosphat (-OP(O)(OR⁴)₂), Phosphin (-PR⁴R⁵), Phosphinoxid (-P(O)R⁴₂), Sulfat (-OS(O)₂OR⁴), Sulfoxid (-S(O)R⁴), Sulfonat (-S(O)₂OR⁴), Sulfonyl (-S(O)₂R⁴, Sulfonamid (-S(O)₂NR⁴R⁵), NO₂, Boronsäureestern (-B(OR⁴)₂), Imino (-C=NR⁴R⁵)), Boranresten, Stannatresten, Hydrazinresten, Hydrazonresten, Oximresten, Nitroso-Gruppen, Diazo-Gruppen, Vinylgruppen, Sulfoximinen, Alanen, Germanen, Boroxinen und Borazinen;
oder
zwei benachbarte Reste R³ bilden gemeinsam eine gesättigte oder ungesättigte substituierte oder unsubstituierte Brücke aus 3 bis 6 Atomen, so dass die Reste R³ gemeinsam mit einem der Elemente A=D, D-E, A'=D', D'-E', E'=G' einen 5- bis 8-gliedrigen Ring bilden;
oder
die Reste R³ an den Positionen G' und A bilden gemeinsam eine gesättigte oder ungesättigte substituierte oder unsubstituierte Brücke aus 1 bis 4 Atomen, so dass die Reste R³ gemeinsam mit dem Element -G'-C-C-A- einen 5- bis 8-gliedrigen Ring bilden;
und
R⁴, R⁵, R⁶ unabhängig voneinander H, substituiertes oder unsubstituiertes C₁-C₂₀-Alkyl oder substituiertes oder unsubstituiertes C₆-C₃₀-Aryl oder substituiertes oder unsubstituiertes Heteroaryl mit 5 bis 30 Ringatomen; mit einem Metallkomplex enthaltend mindestens ein Metall M, wobei M die folgenden Bedeutungen aufweist:
M Metallatom ausgewählt aus der Gruppe bestehend aus Metallen der Gruppe IB, IIB, IIIB, IVB, VB, VIB, VIIB, VIIIB, den Lanthaniden und IIIA des Periodensystems der Elemente (CAS-Version) in jeder für das entsprechende Metallatom möglichen Oxidationsstufe; bevorzugt Fe, Os, Co, Rh, Ir, Ni, Ru, Pd und Pt, Cu, Au, Ce, Tb, Eu, besonders bevorzugt Os, Ru, Rh, Ir und Pt und ganz besonders bevorzugt Ir, Os und Pt.

9. Verfahren nach Anspruch 8, **dadurch gekennzeichnet, dass** als Metall M Ir, Os oder Pt eingesetzt wird.

10. Verwendung von Carbenkomplexen gemäß einem der Ansprüche 1 bis 7 oder hergestellt gemäß Anspruch 8 oder 9 in organischen Leuchtdioden, bevorzugt als Emittermaterial, Matrixmaterial, Ladungsblockermaterial und/oder Ladungstransportmaterial, besonders bevorzugt als Emittermaterial, ganz besonders bevorzugt als Blauemitter.

11. Organische Leuchtdiode enthaltend mindestens einen Carbenkomplex gemäß einem der Ansprüche 1 bis 7 oder hergestellt gemäß Anspruch 8 oder 9.

12. Licht-emittierende Schicht enthaltend mindestens einen Carbenkomplex gemäß einem der Ansprüche 1 bis 7 oder hergestellt gemäß Anspruch 8 oder 9.

13. Organische Leuchtdiode enthaltend mindestens eine Licht-emittierende Schicht nach Anspruch 12.

14. Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Digitalkameras, Fahrzeugen sowie Zielanzeigen an Bussen und Bahnen sowie Beleuchtungsmitteln enthaltend mindestens eine organische Leuchtdiode gemäß Anspruch 11 oder 13.

## Claims

1. A cyclometalated carbene complex of the general formula (I) 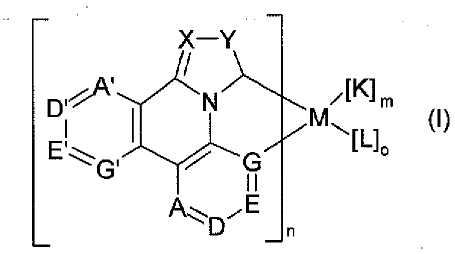 in which the symbols are each defined as follows:
M is a metal atom selected from the group consisting of metals of group IB, IIB, IIIB, IVB, VB, VIB, VIIB, VIIIB, the lanthanides and IIIA of the Periodic Table of the Elements (CAS version) in any oxidation state possible for the appropriate metal atom; preferably Fe, Os, Co, Rh, Ir, N, Ru, Pd and Pt, Cu, Au, Ce, Tb, Eu, more preferably Os, Ru, Rh, Ir and Pt and most preferably Ir, Os and Pt;
K is an uncharged mono- or bidentate ligand;
L is a mono- or dianionic ligand, preferably a monoanionic ligand, which may be mono- or bidentate;
X is CR¹ or N, preferably N;
Y is NR² or CR²₂;
A, D, G, E, A', D', G' and E' are each independently CH, CR³ or N;
R¹ is F, CN, C₁-C₂₀-alkoxy, C₆-C₃₀ -aryloxy, C₁-C₂₀-alkylthio, C₆-C₃₀-arylthio, substituted or unsubstituted C₆-C₃₀-aryl or substituted or unsubstituted heteroaryl having from 5 to 30 ring atoms;
R², R³ are each independently substituted or unsubstituted C₁-C₂₉-alkyl, substituted or unsubstituted C₅-C₂₀-cycloalkyl, substituted or unsubstituted C₅-C₂₀-cycloalkenyl, substituted or unsubstituted heterocycloalkyl having from 5 to 30 ring atoms, substituted or unsubstituted heterocycloalkenyl having from 5 to 30 ring atoms, substituted or unsubstituted C₂-C₂₀-alkenyl, substituted or unsubstituted C₂-C₂₀-alkynyl, substituted or unsubstituted C₆-C₃₀-aryl, substituted or unsubstituted heteroaryl having from 5 to 30 ring atoms or a substituent with donor or acceptor action selected from the group consisting of: C₁-C₂₀-alkoxy, C₆-C₃₀-aryloxy, C₁-C₂₀-alkylthioc, C₆-C₃₀-arylthio, SiR⁴R⁵R⁶, halogen radicals, halogenated C₁-C₂₀-alkyl radicals, carbonyl (-CO(R⁴)), carbonylthio (-C=O(SR⁴)), carbonyloxy (-C=O(OR⁴)), oxycarbonyl (-OC=O(R⁴)), thiocarbonyl (- SC=O(R⁴)), amino (-NR⁴R⁵), OH, pseudohalogen radicals, amido (-C=O(NR⁴R⁵)), -NR⁴C=O(R⁵), phosphonate (-P(O)(OR⁴)₂), phosphate (-OP(C)(OR⁴)₂) phosphine (-PR⁴R⁵), phosphine oxide (-P(O)R⁴₂), sulfate (-OS(O)₂OR⁴), sulfoxide (-S(C)R⁴) sulfonate (-S(O)₂OR⁴), sulfonyl (-S(O)₂R⁴) sulfonamide (-S(O)₂NR⁴R⁵), NO₂, boronic esters (-B(OR⁴)₂), amino (-C=NR⁴), borane radicals, stannate radicals, hydrazine radicals, hydrazone radicals, oxime radicals, nitroso groups, diazo groups, vinyl groups, sulfoximines, alanes, germanes, boroxines and borazines;
or
two adjacent R³ radicals together form a saturated or unsaturated, substituted or unsubstituted bridge composed of from 3 to 6 atoms, such that the R³ radicals together with one of the elements A=D, D-E, A'=D', D'=E', E'=G' form a 5- to 8-membered ring;
or
the R³ radicals at the G' and A positions together form a saturated or unsaturated, substituted or unsubstituted bridge composed of from 1 to 4 atoms, such that the R³ radicals together with the element -G'-C-C-A-form a 5- to 8-membered ring;
R⁴, R⁵, R⁶ are each independently H, substituted or unsubstituted C₁-C₂₀-alkyl or substituted or unsubstituted C₆-C₃₀-aryl or substituted or unsubstituted heteroaryl having from 5 to 30 ring atoms;
n is the number of carbene ligands, where n is at least 1 and the carbene ligands in the complex of the formula I, when n > 1, may be the same or different;
m is the number of ligands K, where m may be 0 or ≥ 1, and the ligands K, when m > 1, may be the same or different;
o is the number of ligands L, where o may be 0 or ≥ 1, and the ligands L, when o > 1, may be the same or different;
where the sum of n + m + o depends on the oxidation state and coordination number of the metal atom used and on the denticity of the ligands L and K, and also on the charge of the ligand L, with the condition that n is at least 1.

2. A carbene complex according to claim 1, wherein
Mis Ir(III),
n is 3, and
m, o are each 0.

3. A carbene complex according to claim 1 or 2,
wherein
R¹, R², R³ are each independently selected from the group consisting of substituted or unsubstituted C₁-C₂₀-alkyl, substituted or unsubstituted C₂-C₂₀-alkenyl, substituted or unsubstituted C₂-C₂₀-alkynyl, substituted or unsubstituted C₆-C₃₀-aryl, substituted or unsubstituted heteroaryl having from 5 to 30 ring atoms, C₁-C₂₀-alkoxy, C₆-C₃₀-aryloxy, C₁-C₂₀-alkylthio, C₆-C₃₀-arylthio, SiR⁴R⁵R⁶, halogen radicals, halogenated C₁-C₂₀-alkyl radicals and pseudohalogen radicals; more preferably, R² and R³ are each independently selected from the group consisting of substituted or unsubstituted C₁-C₂₀-alkyl, preferably C₁-C₄-alkyl, more preferably methyl, ethyl, n-propyl, isopropyl, n-butyl, isobutyl, sec-butyl or tert-butyl, substituted or unsubstituted C₆-C₃₀-aryl, preferably substituted or unsubstituted phenyl, more preferably unsubstituted phenyl, tolyl, dimethylphenyl, trimethylphenyl, F-, CN-, methoxy- and/or CF₃- substituted phenol, substituted or unsubstituted heteroaryl having from 5 to 30 ring atoms, preferably substituted or unsubstituted heteroaryl having from 5 to 13 ring atoms, more preferably pyridyl, thienyl, pyrrolyl, furyl, thiazolyl, oxazolyl, pyrazolyl or imidazolyl, C₁-C₂₀-alkoxy, preferably C₁-C₄-alkoxy, more preferably methoxy, C₆-C₃₀-aryloxy, preferably C₆-C₁₀-aryloxy, more preferably phenoxy, C₁-C₂₀-alkylthio, preferably C₁-C₄-alkylthio, more preferably SCH₃, C₆-C₃₀-arylthio, preferably C₆-C₁₀-arylthio, more preferably SPh, SiR⁴R⁵R⁶, preferably SiMe₃ or SiPh₃, halogen radicals, preferably F, Cl, Br, more preferably F, halogenated C₁-C₂₀-alkyl radicals, preferably halogenated C₁-C₁₀-alkyl radicals, more preferably CF₃, and pseudohalogen radicals, preferably CN;
or
two adjacent R³ radicals together form a saturated or unsaturated, methyl-, methoxy-, phenyl-, SiMe₃-, SiPh₃-, F-, CF₃- or CN-substituted or unsubstituted bridge composed of 3 or 4 carbon atoms, such that the R³ radicals together with one of the elements A=D, D-E, A'=D' , D'=E', E'=G' form a 5- or 6-membered ring;
or
the R³ radicals at the G' and A positions together form a saturated or unsaturated, methyl-, methoxy-, phenyl-, SiMe₃-, SiPh₃-, F-, CF₃- or CN-substituted or unsubstituted bridge composed of 1 or 2 carbon atoms, such that the R³ radicals together with the element -G'-C-C-A- form a 5- or 6-membered ring.

4. A carbene complex according to any of claims 1 to 3, wherein
R² is selected from the group consisting of substituted or unsubstituted C₁-C₂₀-alkyl which is branched in the 1-position, preferably isopropyl, isobutyl, isopentyl, sec-butyl or tert-butyl; substituted or unsubstituted C₆-aryl, preferably unsubstituted phenyl or phenyl which is substituted in the 2- and/or 6-position, preferably by methyl, methoxy, CF₃, CN and/or F; more preferably 2-tolyl, 2-methoxyphenyl, 2-cyanophenyl, 2-trifluoromethylphenyl, 2,6-difluorophenyl, 2,3-, 2,4-, 2,5- or 2,6-dimethylphenyl or 2,4,6-, 2,3,4- or 2,3,5-trimethylphenyl; substituted or unsubstituted heteroaryl having from 5 to 13 ring atoms, preferably pyridin-2-yl, pyridin-3-yl, pyridin-4-yl, thiophen-2-yl, thiophen-3-yl, pyrrol-2-yl, pyrrol-3-yl, furan-2-yl, furan-3-yl, thiazol-2-yl, oxazol-2-yl, pyrazol-3-yl or imidazol-2-yl, and the corresponding benzofused radicals.

5. A carbene complex according to any of claims 1 to 4, wherein
X is N, and
Y is NR².

6. A carbene complex according to any of claims 1 to 5, wherein
A, D, G, E, A', D', G' and E'
are each CH or CR³, preferably CH.

7. A carbene complex according to any of claims 1 to 6, selected from the group consisting of 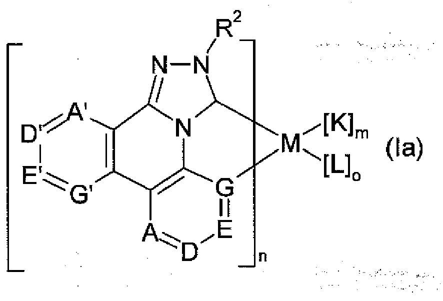 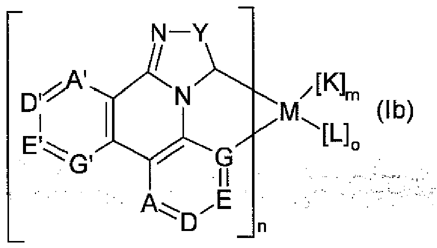 in which:
A, D, G, E, A', D', G' and E' are each independently CH, CR³ or N, preferably CH or CR³, more preferably CH;
R², R³ are each independently substituted or unsubstituted C₁-C₂₀-alkyl, substituted or unsubstituted C₅-C₂₀-cycloalkyl, substituted or unsubstituted C₅-C₂₀-cycloalkenyl, substituted or unsubstituted heterocycloalkyl having from 5 to 30 ring atoms, substituted or unsubstituted heterocycloalkenyl having from 5 to 30 ring atoms, substituted or unsubstituted C₂-C₂₀-alkenyl, substituted or unsubstituted C₂-C₂₀-alkynyl, substituted or unsubstituted C₆-C₃₀aryl, substituted or unsubstituted heteroaryl having from 5 to 30 ring atoms or a substituent with donor or acceptor action selected from the group consisting of: C₁-C₂₀-alkoxy, C₆-C₃₀-aryloxy, C₁-C₂₀-alkylthio, C₆-C₃₀-arylthio, SiR⁴R⁵R⁶, halogen radicals, halogenated C₁-C₂₀-alkyl radicals, carbonyl (-CO(R⁴)), carbonylthio (-C=O(SR⁴)), carbonyloxy (-C=O(OR⁴)), oxycarbonyl (-OC=O(R⁴)), thiocarbonyl (-SC=O(R⁴)), amino (-NR⁴R⁵), OH, pseudohalogen radicals, amido (-C=O(NR⁴R⁵)), -NR⁴C=O(R⁵), phosphonate (-P(O)(OR⁴)₂), phosphate (-OP(O)(OR⁴)₂), phosphine (-PR⁴R⁵), phosphine oxide (-P(O)R⁴₂), sulfate (-OS(O)₂OR⁴), sulfoxide (-S(O)R⁴), sulfonate (-S(O)₂OR⁴), sulfonyl (-S(O)₂R⁴), sulfonamide (-S(O)₂NR⁴R⁵), NO₂, boronic esters (-B(OR⁴)₂), imino (-C=NR⁴), borane radicals, stannate radicals, hydrazine radicals, hydrazone radicals, oxime radicals, nitroso groups, diazo groups, vinyl groups, sulfoximines, alanes, germanes, boroxines and borazines;
or
two adjacent R³ radicals together form a saturated or unsaturated, substituted or unsubstituted bridge composed of from 3 to 6 atoms, such that the R³ radicals together with one of the elements A=D, D-E, A'=D', D'-E', E'=G' form a 5- to 8-membered ring;
or
the R³ radicals at the G' and A positions together form a saturated or unsaturated, substituted or unsubstituted bridge composed of from 1 to 4 atoms, such that the R³ radicals together with the element -G'-C-C-A-form a 5- to 8-membered ring;
where R² is preferably selected from the group consisting of substituted or unsubstituted C₁-C₂₀-alkyl which is branched in the 1-position, preferably isopropyl, isobutyl, isopentyl, sec-butyl or tert-butyl; substituted or unsubstituted C₆-aryl, preferably unsubstituted phenyl or phenyl which is substituted in the 2- and/or 6-position, preferably by methyl, methoxy, CF₃, CN and/or F; more preferably 2-tolyl, 2-methoxyphenyl, 2-cyanophenyl, 2-trifluoromethylphenyl, 2,6-difluorophenyl, 2,3-, 2,4-, 2,5- or 2,6-dimethylphenyl or 2,4,6-, 2,3,4- or 2,3,5-trimethylphenyl; substituted; or unsubstituted heteroaryl having from 5 to 13 ring atoms, preferably pyridin-2-yl, pyridin-3-yl, pyridin-4-yl, thiophen-2-yl, thiophen-3-yl, pyrrol-2-yl, pyrrol-3-yl, furan-2-yl, furan-3-yl, thiazol-2-yl, oxazol-2-yl, pyrazol-3-yl or imidazol-2-yl, and the corresponding benzofused radicals;
R⁴, R⁵, R⁶ are each independently H, substituted or unsubstituted C₁-C₂₀-alkyl or substituted or unsubstituted C₆-C₃₀-aryl, or substituted or unsubstituted heteroaryl having from 5 to 30 ring atoms;
Y is CR²₂;
M is Ir, Os or Pt; preferably Ir(III), Os (II) or Pt(II), more preferably Ir(III);
K is an uncharged bidentate ligand;
L is a monoanionic bidentate ligand;
n is the number of carbene ligands, where n is 3 in the case of Ir, is 2 in the case of Os and is 1 or 2 in the case of Pt, and the carbene ligands in the complexes of the formula Ia or Ib may be the same or different;
m is 0 in the case that M = Ir or Pt and is 1 in the case of Os;
o is 0 in the case that M = Ir or Os and Pt and in the case that n = 2, and is 1 in the case of Pt and in the case that n = 1.

8. A process for preparing carbene complexes according to any of claims 1 to 7, comprising the reaction of at least one ligand precursor of the formula (III) 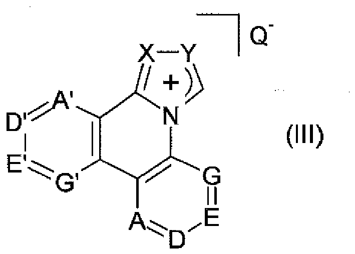 in which
Q⁻ is a monoanionic counterion, preferably halide, pseudohalide, BF₄⁻, BPh₄⁻, PF₆⁻, AsF₆⁻ or SbF₆⁻;
and
the further symbols in the ligand precursor of the general formula III, are each defined as follows:
X is CR¹ or N, preferably N;
Y is NR² or CR²₂;
A, D, G, E, A', D', G' or E' are each independently CH, CR³ or N;
R¹ is F, CN, C₁-C₂₀-alkoxy, C₆-C₃₀-aryloxy, C₁-C₂₀-alkylthio, C₆-C₃₀-arylthio, substituted or unsubstituted C₆-C₃₀-aryl- or substituted or unsubstituted heteroaryl having from 5 to 30 ring atoms;
R², R³ are each independently substituted or unsubstituted C₁-C₂₀-alkyl, substituted or unsubstituted C₅-C₂₀-cycloalkyl, substituted or unsubstituted C₅-C₂₀-cycloalkenyl, substituted or unsubstituted heterocycloalkyl having from 5 to 30 ring atoms, substituted or unsubstituted heterocycloalkenyl having from 5 to 30 ring atoms, substituted or unsubstituted C₂-C₂₀-alkenyl, substituted or unsubstituted C₂-C₂₀-alkynyl, substituted or unsubstituted C₆-C₃₀-aryl, substituted or unsubstituted heteroaryl having from 5 to 30 ring atoms or a substituent with donor or acceptor action selected from the group consisting of: C₁-C₂₀-alkoxy, C₆-C₃₀-aryloxy, C₁-C₂₀-alkylthio, C₆-C₃₀-arylthio, SiR⁴R⁵R⁶, halogen radicals, halogenated C₁-C₂₀-alkyl radicals, carbonyl (-CO (R⁴)), carbonylthio (-C=O (SR⁴)), carbonyloxy (-C=O (OR⁴)), oxycarbonyl (-OC=O(R⁴)), thiocarbonyl (-SC=O(R⁹)), amino (-NR4^{R}R⁵, OH, pseudohalogen radicals, amido (-C=O (NR⁴R⁵)), -NR⁴C=O (R⁵), phosphonate (-P(O)(OR⁴)₂), phosphate (-OP(O) (OR⁴)₂), phosphine (-PR⁴R⁵), phosphine oxide (-P(O)R⁴₂) sulfate (-OS(O)₂OR⁴), sulfoxide (-S(O) R⁴), sulfonate (-S(O)₂OR⁴), sulfonyl (-S(O)₂R⁴), sulfonamide (-S(O)₂NR⁹R⁵), NO₂, boronic esters (-B(OR⁴)₂), imino (-C=NR⁴R⁵), borane radicals, stannate radicals, hydrazine radicals, hydrazone radicals, oxide radicals, nitroso groups, diazo groups, vinyl groups, sulfoximines, alanes, germanes, boroxines and borazines;
or
two adjacents R³ radicals together form a saturated or unsaturated, substituted or unsubstituted bridge composed of from 3 to 6 atoms, such that the R³ radicals together with one of the elements A=D, D-E, A' =D' , D' -E' , E'=G' form a 5- to 8-membered ring;
or the R³ radicals at the G' and A positions together form a saturated or unsaturated, substituted or unsubstituted bridge composed of from 1 to 4 atoms, such that the R³ radicals together with the element -G' -C-C-A-form a 5- to 8-membered ring;
and
R⁴, R⁵, R⁶ are each independently H, substituted or unsubstituted C₁-C₂₀-alkyl or substituted or unsubstituted C₆-C₃₀-aryl or substituted or unsubstituted heteroaryl having from 5 to 30 ring atoms;
with a metal complex comprising at least one metal M where M is defined as follows:
M is a metal atom selected from the group consisting, of metals of group IB, IIB, IIIB, IVB, VB, VIB, VIIB, VIIIB, the lanthanides and IIIA of the Periodic Table of the Elements (CAS version) in any oxidation state possible for the appropriate metal atom; preferably Fe, Os, Co, Rh, Ir, Ni, Ru, Pd and Pt, Cu, Au, Ce, Tb, Eu, more preferably Os, Ru, Rh, Ir and Pt and most preferably Ir, Os and Pt.

9. The process according to claim 8, wherein the metal M used is Ir, Odor Pt.

10. The use of carbene complexes according to any of claims 1 to 7 or produced according to claim 8 or 9 in organic light-emitting diodes, preferably as an emitter material, matrix material, charge blocker material and/or charge transport material, more preferably as emitter material, most preferably as a blue emitter.

11. An organic light-emitting diode comprising at least one carbene complex according to any of claims 1 to 7 or produced according to claim 8 or 9.

12. A light-emitting layer comprising at least one carbene complex according to any of claims 1 to 7 or produced according to claim 8 or 9.

13. An organic light-emitting diode comprising at least one light-emitting layer according to claim 12.

14. A device selected from the group consisting of stationary visual display units such as visual display units of computers, televisions, visual display units in printers, kitchen appliances and advertising panels, illuminations, information panels and mobile visual display units such as visual display units in cellphones, laptops, digital cameras, vehicles and destination displays on buses and trains, and illuminating means comprising at least one organic light-emitting diode according to claim 11 or 13.

## Revendications

1. Complexes de carbène cyclométallisés de formule générale (I) 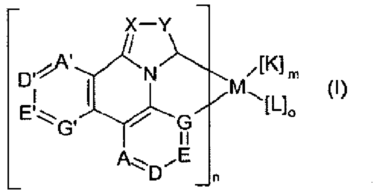 où les symboles présentent les significations suivantes :
M atome métallique choisi dans le groupe constitué par les métaux du groupe IB, IIB, IIIB, IVB, VB, VIB, VIIB, VIIIB, des lanthanides et du groupe IIIA du système périodique des éléments (version CAS) dans chaque étage d'oxydation possible pour l'atome métallique correspondant; de préférence Fe, Os, Co, Rh, Ir, Ni, Ru, Pd et Pt, Cu, Au, Ce, Tb, Eu, de manière particulièrement préférée Os, Ru, Rh, Ir et Pt et de manière tout particulièrement préférée Ir, Os et Pt ;
K ligand monodentate ou bidentate neutre ;
L ligand monoanionique ou dianionique, de préférence ligand monoanionique, qui peut être monodentate ou bidentate ;
X CR¹ ou N, de préférence N ;
Y NR² ou CR²₂ ;
A, D, G, E, A', D', G' ou E' indépendamment l'un de l'autre, CH, CR³ ou N;
R¹ F, CN, C₁-C₂₀-alcoxy, C₆-C₃₀-aryloxy, C₁-C₂₀-alkylthio, C₆-C₃₀-arylthio, C₆-C₃₀-aryle substitué ou non substitué ou hétéroaryle substitué ou non substitué, comprenant 5 à 30 atomes de cycle ;
R², R³ indépendamment l'un de l'autre, C₁-C₂₀-alkyle substitué ou non substitué, C₅-C₂₀-cycloalkyle substitué ou non substitué, C₅-C₂₀-cycloalcényle substitué ou non substitué, hétérocycloalkyle substitué ou non substitué comprenant 5 à 30 atomes de cycle, hétérocycloalcényle substitué ou non substitué comprenant 5 à 30 atomes de cycle, C₂-C₂₀-alcényle substitué ou non substitué, C₂-C₂₀-alcynyle substitué ou non substitué, C₆-C₃₀-aryle substitué ou non substitué, hétéroaryle substitué ou non substitué comprenant 5 à 30 atomes de cycle ou substituant présentant un effet donneur ou accepteur, choisi dans le groupe constitué par : C₁-C₂₀-alcoxy, C₆-C₃₀-arylaxy, C₁-C₂₀-alkylthio, C₆-C₃₀-arylthio, SiR⁴R⁵R⁶, les radicaux halogéno, les radicaux C₁-C₂₀-alkyle halogénés, carbonyle (-CO (R4)), carbonylthio (-C=O (SR⁴)), carbonyloxy (-C=O(OR₄)), oxycarbonyle (-OC=O(R⁹)), thiocarbonyle (-SC=O(R⁴)), amino (-NR⁴R⁵), OH, les radicaux pseudohalogéno, amido (-C=O(NR⁴R⁵)), -NR⁴C=O (R⁵), phosphonate (-P(O) (OR⁴)₂, phosphate (-OP(O)(OR⁴)₂), phosphine (-PR⁴R⁵), phosphinoxyde (-P(O-) R⁴₂), sulfate (-OS (₂OR⁴)OR⁴), sulfoxyde (-S(O) R⁴), sulfonate (-S (O) ₂OR⁹), sulfonyle (-S(O)₂R⁴, sulfonamide (-S(O)₂NR⁴R⁵), NO₂, esters de l'acide boronique (-B(OR⁴)₂), imino (-C=NR⁴), les radicaux borane, les radicaux stannate, les radicaux hydrazine, les radicaux hydrazone, les radicaux-oxime, les groupes nitroso, les groupes diazo, les groupes vinyle, les sulfoximines, les alanes, germanes, les boroxines et les borazines ;
ou
deux radicaux R³ adjacents forment ensemble un pont saturé ou insaturé, substitué ou non substitué, de 3 à 6 atomes, de manière telle que les radicaux R³ forment, ensemble avec un des éléments A=D, D-E, A' =D', D'-E', E'=G' un cycle de 5 à 8 chaînons ; ou les radicaux R³ sur les positions G' et A forment ensemble un pont saturé ou insaturé, substitué ou non substitué de 1 à 4 atomes, de manière telle que les radicaux R³ forment, ensemble avec l'élément -G'-C-C-A-, un cycle de 5 à 8 chaînons ;
R⁴, R⁵, R⁶ indépendamment l'un de l'autre, H, C₁-C₂₀-alkyle substitué ou non substitué ou C₆-C₃₀-aryle substitué ou non substitué ou hétéroaryle substitué ou non substitué, comprenant 5 à 30 atomes de cycle ;
n nombre de ligands carbène, où n vaut au moins 1 et les ligands carbène dans le complexe de formule I pour n > 1 peuvent être identiques ou différents ;
m nombre de ligands K, où m peut valoir 0 ou être ≥ 1 et les ligands K pour m > 1 peuvent être identiques ou différentes ;
o nombre de ligands L, où o peut valoir 0 ou être ≥ 1 et les ligands L pour o > 1 peuvent être identiques ou différents ;
la somme n + m + o dépendant de l'étage d'oxydation et de l'indice de coordination de l'atome de métal utilisé et de la valence des ligands L et K ainsi que de la charge du ligand L, à condition que n vaille au moins 1.

2. Complexes de carbène selon la revendication 1, **caractérisés en ce que**
M signifie Ir (III),
n vaut 3, et
m, o valent 0.

3. Complexes de carbène selon la revendication 1 ou 2, **caractérisés, en ce que**
R¹, R², R³ sont-choisis, indépendamment l'un de l'autre,
dans le groupe constitué par C₁-C₂₀-alkyle substitué ou non substitué, C₂-C₂₀-alcényle substitué ou non substitué, C₂-C₂₀-alcynyle substitué ou non substitué, C₆-C₃₀-aryle substitué ou non substitué, hétéroaryle substitué ou non substitué comprenant 5 à 30 atomes de cycle, C₁-C₂₀-alcoxy, C₆-C₃₀-aryloxy, C₁-C₂₀-alkylthio, C₆-C₃₀-arylthio, SiR⁴R⁵R⁶, les radicaux halogéno, les radicaux C₁-C₂₀-alkyle halogénés et les radicaux pseudohalogéno ; de manière particulièrement préférée R² et R³ sont choisis, indépendamment l'un de l'autre, dans le groupe constitué par C₁-C₂₀-alkyle substitué ou non substitué, de préférence C₁-C₄-alkyle, de manière particulièrement préférée méthyle, éthyle, n-propyle, isopropyle, n-butyle, isobutyle, sec-butyle ou tert-butyle, C₆-C₃₀-aryle substitué ou non substitué, de préférence phényle substitué ou non substitué, de manière particulièrement préférée phényle non substitué, toluyle, diméthylphényle, triméthylphényle, phényle substitué par F, CN, méthoxy et/ou CF₃, hétéroaryle substitué ou non substitué comprenant 5 à 30 atomes de cycle, de préférence hétéroaryle substitué ou non substitué comprenant 5 à 13 atomes de cycle, de manière particulièrement préférée pyridyle, thiényle, pyrrolyle, furyle, thiazolyle, oxazolyle, pyrazolyle ou imidazolyle, C₁-C₂₀-alcoxy, de préférence C₁-C₉-alcoxy, de manière particulièrement préférée méthoxy, C₆-C₃₀-aryloxy, de préférence C₆-C₁₀-aryloxy, de manière particulièrement préférée phénoxy, C₁-C₂₀-alkylthio, de préférence C₁-C₄-alkylthio, de manière particulièrement préférée SCH₃, C₆-C₃₀-arylthio, de préférence C₆-C₁₀-arylthio, de manière particulièrement préférée SPh, SiR⁴R⁵R⁶, de préférence SiMe₃ ou SiPh₃, les radicaux halogéno, de préférence F, Cl, Br, de manière particulièrement préférée F, les radicaux C₁-C₂₀-alkyle halogénés, de préférence les radicaux C₁-C₁₀-alkyle halogénés, de manière particulièrement préférée CF₃, et les radicaux pseudohalogéno, de préférence CN ; ou
deux radicaux R³ adjacents forment ensemble un pont saturé ou insaturé, substitué par méthyle, méthoxy, phényle, SiMe₃, SiPh₃, F, CF₃ ou CN ou non substitué, comprenant 3 ou 4 atomes de carbone, de manière telle que les radicaux R³ forment, ensemble avec un des éléments A=D, D-E, A'=D', D'-E-, E'=G', un cycle de 5 ou 6 chaînons; ou
les radicaux R³ sur les positions G' et A forment ensemble un pont saturé ou insaturé, substitué par méthyle, méthoxy, phényle, SiMe₃, SiPh₃, F, CF₃ ou CN ou non substitué, comprenant 1 ou 2 atomes de carbone, de manière telle que les radicaux R³ forment, ensemble avec l'élément -G'-C-C-A-, un cycle de 5 ou 6 chaînons.

4. Complexes de carbène selon l'une quelconque des revendications 1 à 3, **caractérisés en ce que**
R² est choisi dans le groupe constitué par C₁-C₂₀-alkyle substitué ou non substitué, qui est ramifié en position 1, de préférence isopropyle, isobutyle, isopentyle, sec-butyle ou tert-butyle ; C₆-aryle substitué ou non substitué, de préférence phényle non substitué ou phényle substitué en position 2 et/ou 6, de préférence par méthyle, méthoxy, CF₃, CN et/ou F ; de manière particulièrement préférée 2-toluyle, 2-méthoxyphényle, 2-cyanophényle, 2-trifluorométhylphényle, 2,-6-difluorophényle, 2,3-diméthylphényle, 2,4-diméthylphényle, 2,5-diméthylphényle ou 2,6-diméthylphényle ou 2,4,6-triméthylphényle, 2,3,4-triméthylphényle ou 2,3,5-triméthylphényle ; hétéroaryle substitué ou non substitué comprenant 5 à 13 atomes de cycle, de préférence pyridin-2-yle, pyridin-3-yle, pyridin-4-yle, thiophén-2-yle, thiophén-3-yle, pyrrol-2-yle, pyrrol-3-yle, furann-2-yle, furann-3-yle, thiazol-2-yle, oxazol-2-yle, pyrazol-3-yle ou imidazol-2-yle ainsi que les radicaux condensés avec benzène correspondants.

5. Complexes de carbène selon l'une quelconque des revendications 1 à 4, **caractérisés en ce que**
X signifie N, et
Y signifie NR².

6. Complexes de carbène selon l'une quelconque des revendications 1 à 5, **caractérisés en ce que**
A, D, G, E, A', D', G' et E' signifient CH ou CR³, de préférence CH.

7. Complexes de carbène selon l'une quelconque des revendications 1 à 6, choisis dans le groupe constitué par : 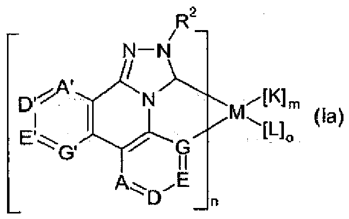 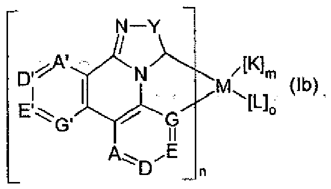 où :
A, D, G, E, A', D', G' et E' signifient, indépendamment l'un de l'autre, CH, CR³ ou N, de préférence CH ou CR³, de manière particulièrement préférée CH ;
R², R³ signifient, indépendamment l'un de l'autre, C₁-C₂₀-alkyle substitué ou non substitué, C₅-C₂₀-cycloalkyle substitué ou non substitué, C₅-C₂₀-cycloalcényle substitué ou non substitué, hétérocycloalkyle substitué ou non substitué comprenant 5 à 30 atomes de cycle, hétérocycloalcényle substitué ou non substitué comprenant 5 à 30 atomes de cycle, C₂-C₂₀-alcényle substitué ou non substitué, C₂-C₂₀-alcynyle substitué ou non substitué, C₆-C₃₀-aryle substitué ou non substitué, hétéroaryle substitué ou non substitué comprenant 5 à 30 atomes de cycle ou un substituant présentant un effet donneur ou accepteur, choisi dans le groupe constitué par : C₁-C₂₀-alcoxy, C₆-C₃₀-aryloxy, C₁-C₂₀-alkylthic, C₆-C₃₀-arylthio, SiR⁴R⁵R⁶, les radicaux halogéno, les radicaux C₁-C₂₀-alkyle halogénés, carbonyle (-CC (R⁴)), carbonylthio (-C=O(SR⁴)), carbonyloxy (-C=O(OR⁴)), oxycarbonyle (-OC=O(R⁴)), thiocarbonyle (-SC=O (R⁹)), amino (-NR⁴R⁵), OH, les radicaux pseudohalogéno, amido (-C=O(NR⁹R⁵)), -NR⁴C=O(R⁵), phosphonate (-P(O) (OR⁴)₂, phosphate (-OP(O) (OR⁴)₂), phosphine (-PR⁴R⁵), phosphinoxyde (-P(O)R⁴₂), sulfate (-OS (O)₂OR⁴) sulfoxyde (-S(O)R⁴), sulfonate (-S(O)₂OR⁴), sulfonyle (-S(O)₂R⁴, sulfonamide (-S(O)₂NR⁴R⁵), NO₂, esters de l'acide boronique (-B (OR⁴)₂), imino (-C=NR⁴), les radicaux borane, les radicaux stannate, les radicaux hydrazine, les radicaux hydrazone, les radicaux oxime, les groupes nitroso, les groupes diazo, les groupes vinyle, les sulfoximines, les alanes, germanes, les boroxines et les borazines ;
ou
deux radicaux R³ adjacents, forment ensemble un pont saturé ou insaturé, substitué ou non substitué de 3 à 6 atomes, de manière telle que les radicaux R³ forment, ensemble avec un des éléments A=D, D-E, A'=D', D'-E', E'=G' un cycle de 5 à 8 chaînons ; ou
les radicaux R³ sur les positions G' et A forment ensemble un pont saturé ou insaturé, substitué ou non substitué de 1 à 4 atomes, de manière telle que les radicaux R³ forment, ensemble avec l'élément -G'-C-C-A-, un cycle de 5 à 8 chaînons ; où R² est de préférence choisi dans le groupe constitué par C₁-C₂₀-alkyle substitué ou non substitué, qui est ramifié en position 1, de préférence isopropyle, isobutyle, isopentyle, sec-butyle ou tert-butyle ; C₆-aryle substitué ou non substitué, de préférence phényle non substitué ou phényle substitué en position 2 et/ou 6, de préférence par méthyle, méthoxy, CF₃, CN et/ou F ; de manière particulièrement préférée 2-toluyle, 2-méthoxyphényle, 2-cyanophényle, 2-trifluorométhylphényle, 2,6-difluorophényle, 2,3-diméthylphényle, 2,4-diméthylphényle, 2,5-diméthylphényle ou 2,6-diméthylphényle ou 2,4,6-triméthylphényle, 2,3,4-triméthylphényle ou 2,3,5-triméthylphényle ; hétéroaryle substitué ou non substitué comprenant 5 à 13 atomes de cycle, de préférence pyridin-2-yle, pyridin-3-yle, pyridin-4-yle, thiophén-2-yle, thiophén-3-yle, pyrrol-2-yle, pyrrol-3-yle, furann-2-yle, furann-3-yle, thiazol-2-yle, oxazol-2-yle, pyrazol-3-yle ou imidazol-2-yle ainsi que les radicaux condensés avec benzène correspondants ;
R⁴ , R⁵, R⁶ signifient, indépendamment l'un de l'autre, H, C₁-C₂₀-alkyle substitué ou non substitué ou C₆-C₃₀-aryle substitué ou non substitué ou hétéroaryle substitué ou non substitué, comprenant 5 à 30 atomes de cycle ;
Y signifie CR²₂;
M signifie Ir, Os ou Pt ; de préférence Ir(III), Os (II) ou Pt(II), de manière particulièrement préférée Ir (III) ;
K signifie un ligand bidentate neutre ;
L signifie un ligand bidentate monoanionique ;
n signifie le nombre de ligands carbène, où n vaut 3 dans le cas de Ir, 2 dans le cas de Os et 1 ou 2 dans le cas de Pt et les ligands carbène dans les complexes de la formule Ia ou Ib peuvent être identiques ou différents ;
m vaut 0 dans le cas de M = Ir ou Pt et vaut 1 dans le cas de Os ;
o vaut 0 dans le cas où M = Ir ou Os et Pt, pour le cas où n = 2, et vaut 1 dans le cas de Pt, pour le cas où n = 1.

8. Procédé pour la préparation de complexes de carbène selon l'une quelconque des revendications 1 à 7, comprenant la transformation d'au moins un précurseur de ligand de formule (III) 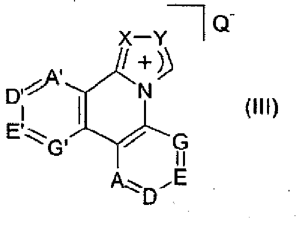 où
Q⁻ signifie un contre-ion monoanionique, de préférence halogénure, pseudohalogénure, BF₄⁻, BPh₄⁻, PF₆ , AsF₆⁻ ou SbF₆⁻ ; et les autres symboles dans le précurseur de ligand de formule générale III présentent les significations suivantes :
X CR¹ ou N, de préférence N ;
Y NR² ou CR²₂ ;
A, D, G, E, A', D', G' ou E' indépendamment l'un de l'autre, CH, CR³ ou N ;
R¹ F, CN, C₁-C₂₀-alcoxy, C₆-C3₀-aryloxy, C₁-C₂₀-alkylthio, C₆-C₃₀-arylthio, C₆-C₃₀-aryle substitué ou non substitué ou hétéroaryle substitué ou non substitué, comprenant 5 à 30 atomes de cycle ;
R², R³ indépendamment l'un de l'autre, C₁-C₂₀-alkyle substitué ou non substitué, C₅-C₂₀-cycloalkyle substitué ou non substitué; C₅-C₂₀-cycloalcényle substitué ou non substitué, hétérocycloalkyle substitué ou non substitué comprenant 5 à 30 atomes de cycle, hétérocycloalcényle substitué ou non substitué comprenant 5 à 30 atomes de cycle, C₂-C₂₀-alcényle substitué ou non substitué, C₂-C₂₀- alcynyle substitué ou non substitué, C₆-C₃₀-aryle substitué ou non substitué, hétéroaryle substitué ou non substitué comprenant 5 à 30 atomes de cycle ou un substituant présentant un effet donneur ou accepteur, choisi dans le groupe constitué par : C₁-C₂₀-alcoxy, C₆-C₃₀-aryloxy, C₁-C₂₀-alkylthio, C₆-C₃₀-arylthio, SiR⁴R⁵R⁶, les radicaux halogéno, les radicaux C₁-C₂₀-alkyle halogénés, carbonyle (-CO (R⁴)), carbonylthio (-C=O(SR⁴)), carbonyloxy (-C=O(OR⁴)), oxycarbonyle (-OC=O(R⁴)), thiocarbonyle (-SC=O (R⁴)), amino (-NR⁴R⁵) , OH, les radicaux pseudohalogéno, amido (-C=O(NR⁴R⁵)), -NR⁴C=O (R⁵), phosphonate (-P(O) (OR⁴)₂, phosphate (-OP(O) (OR⁴)₂), phosphine (-PR⁴R⁵), phosphinoxyde (-P(O)R⁴₂), sulfate (-OS (O) ₂OR⁴), sulfoxyde (-S (O) R⁴), sulfonate (-S (O) ₂OR⁴), sulfonyle (-S(O)₂R⁴, sulfonamide (-S(O)₂NR⁹R⁵), NO₂, esters de l'acide boronique (-B(OR⁴)₂), imino (-C=NR⁴R⁵)), les radicaux-borane, les radicaux stannate, les radicaux hydrazine, les radicaux hydrazone, les radicaux oxime, les groupes nitroso, les groupes diazo, les groupes vinyle, les sulfoximines, les alanes, germanes, les boroxines et les borazines ;
ou
deux radicaux R³ adjacents forment ensemble un pont saturé ou insaturé, substitué ou non substitué de 3 à 6 atomes, de manière telle que les radicaux R³ forment, ensemble avec un des éléments A=D, D-E, A'=D', D'-E', E'=G' un cycle de 5 à 8 chaînons ; ou
les radicaux R³ survies positions G' et A forment ensemble un pont saturé ou insaturé, substitué ou non substitué de 1 à 4 atomes, de manière telle que les radicaux R³ forment, ensemble avec l'élément -G'-C-C-A-, un cycle de 5 à 8 chaînons ; et
R⁴, R⁵, R⁶ indépendamment l'un de l'autre, H, C₁-C₂₀-alkyle substitué ou non substitué ou C₆-C₃₀-aryle substitué ou non substitué ou hétéroaryle substitué ou non substitué, comprenant 5 à 30 atomes de cycle ;
avec un complexe de métal contenant au moins un métal M, où M présente les significations suivantes :
M atome métallique choisi dans le groupe constitué par les métaux du groupe IB, IIB, IIIB, IVB, VB, VIB, VIIB, VIIIB, des lanthanides et du groupe IIIA du système périodique des éléments (version CAS) dans chaque étage d'oxydation possible pour l'atome métallique correspondant ; de préférence Fe, Os, Co, Rh, Ir, Ni, Ru, Pd et Pt, Cu, Au, Ce, Tb, Eu, de manière particulièrement préférée Os, Ru, Rh, Ir et Pt et de manière tout particulièrement préférée Ir, Os et Pt.

9. Procédé selon la revendication 8, **caractérisé en ce qu'**on utilise, comme métal M, Ir, Os ou Pt.

10. Utilisation de complexes de carbène selon l'une quelconque des revendications 1 à 7 ou préparé selon la revendication 8 ou 9 dans des diodes lumineuses organiques, de préférence comme matériau émetteur, de matrice, de blocage de charge et/ou de transport de charge, de manière particulièrement préférée comme matériau émetteur, de manière tout particulièrement préférée comme émetteur de bleu.

11. Diode lumineuse organique contenant au moins un complexe de carbène selon l'une quelconque des revendications 1 à 7 ou préparé selon la revendication 8 ou 9.

12. Couche émettant de la lumière contenant au moins un complexe de carbène selon l'une quelconque des revendications 1 à 7 ou préparé selon la revendication 8 ou 9.

13. Diode lumineuse contenant au moins une couche émettant de la lumière selon la revendication 12.

14. Dispositif choisi dans le groupe constitué par les écrans stationnaires, tels que les écrans d'ordinateurs, de téléviseurs, les écrans d'imprimantes, d'appareils de cuisine ainsi que de panneaux publicitaires, de luminaires, de tableaux indicateurs et les écrans mobiles, tels que les écrans de téléphones portables, d'ordinateurs portables, de caméras digitales, de véhicules ainsi que d'affichages de destination dans les bus et les trains ainsi que de moyens d'éclairage contenant au moins une diode lumineuse organique selon la revendication 11 ou 13.
